Europäisches Patentamt

European Patent Office

Office européen des brevets

(19)

(11) **EP 1 222 733 B1**

(12) **EUROPEAN PATENT SPECIFICATION**

(45) Date of publication and mention
of the grant of the patent:
**08.12.2004 Bulletin 2004/50**

(51) Int Cl.⁷: **H03D 7/16**

(21) Application number: **00968764.1**

(22) Date of filing: **06.10.2000**

(86) International application number:
**PCT/US2000/027555**

(87) International publication number:
**WO 2001/026215 (12.04.2001 Gazette 2001/15)**

(54) **DOWN CONVERTER USING SUBSAMPLING**

FREQUENZUMSETZER UNTER VERWENDUNG VON UNTERABTASTUNG

ABAISSEUR DE FREQUENCE A SOUS-ECHANTILLONAGE

(84) Designated Contracting States:
**AT BE CH CY DE DK ES FI FR GB GR IE IT LI LU
MC NL PT SE**

(30) Priority: **07.10.1999 US 158047 P**
**21.12.1999 US 171349 P**
**22.12.1999 US 171502 P**
**22.12.1999 US 171496 P**
**24.01.2000 US 177705 P**
**24.01.2000 US 177702 P**
**07.02.2000 US 180667 P**
**14.03.2000 US 526041**

(43) Date of publication of application:
**17.07.2002 Bulletin 2002/29**

(60) Divisional application:
**04020115.4**

(73) Proprietor: **Parkervision, Inc.**
**Jacksonville, FL 32256 (US)**

(72) Inventors:
• **SORRELLS, David F.**
**Middleburg, FL 32068 (US)**
• **BULTMAN, Michael J.**
**Jacksonville, FL 32246 (US)**
• **COOK, Robert W.**
**Switzerland, FL 32259 (US)**
• **JENSEN, Jonathan S.**
**Pocotello, Idaho 83207 (US)**
• **JOHNSON, Martin, R.**
**Salt Lake City, UT 84115 (US)**
• **LOOKE, Richard, C.**
**Jacksonville, FL 32223 (US)**
• **MOSES, Charley, D., Jr.**
**Jacksonville, FL 32217 (US)**
• **RAWLINS, Gregory, S.**
**Lake Mary, FL 32746 (US)**
• **RAWLINS, Michael W.**
**Lake Mary, FL 32746 (US)**
• **SHORT, Robert T.**
**Salt Lake City, UT 84121 (US)**
• **YOUNG, Jamison L.**
**Forest Grove, Oregon 97116 (US)**

(74) Representative:
**Cross, James Peter Archibald et al
R.G.C. Jenkins & Co.,
26 Caxton Street
London SW1H 0RJ (GB)**

(56) References cited:
**WO-A-94/05087          WO-A-98/40968
DE-A- 3 541 031         DE-C- 19 735 798
US-A- 5 454 007         US-A- 5 705 949
US-A- 5 883 548**

• **J.FESTE: "Le convertiseur A/N revolutionne le
récepteur radio" ELECTRONIQUE, no. 54, 1
December 1995 (1995-12-01), pages 40-42,
XP000545991 PARIS ,FR**

## Description

### *Background of the Invention*

### *Field of the Invention*

The present invention relates to down-conversion of electromagnetic (EM) signals. More particularly, the present invention relates to reducing or eliminating DC offset voltages and re-radiation that occurs during down-conversion of EM signals to intermediate frequency or baseband signals.

### *Related Art*

Electromagnetic (EM) information signals (baseband signals) include, but are not limited to, video baseband signals, voice baseband signals, computer baseband signals, etc. Baseband signals include analog baseband signals and digital baseband signals.

It is often beneficial to propagate EM signals at higher frequencies. This is generally true regardless of whether the propagation medium is wire, optic fiber, space, air, liquid, etc. To enhance efficiency and practicality, such as improved ability to radiate and added ability for multiple channels of baseband signals, up-conversion to a higher frequency is utilized. Conventional up-conversion processes modulate higher frequency carrier signals with baseband signals. Modulation refers to a variety of techniques for impressing information from the baseband signals onto the higher frequency carrier signals. The resultant signals are referred to herein as modulated carrier signals. For example, the amplitude of an AM carrier signal varies in relation to changes in the baseband signal, the frequency of an FM carrier signal varies in relation to changes in the baseband signal, and the phase of a PM carrier signal varies in relation to changes in the baseband signal.

In order to process the information that was in the baseband signal, the information must be extracted, or demodulated, from the modulated carrier signal. However, because conventional signal processing technology is limited in operational speed, conventional signal processing technology cannot easily demodulate a baseband signal from higher frequency modulated carrier signal directly. Instead, higher frequency modulated carrier signals must be down-converted to an intermediate frequency (IF), from where a conventional demodulator can demodulate the baseband signal.

Conventional down-converters include electrical components whose properties are frequency dependent. As a result, conventional down-converters are designed around specific frequencies or frequency ranges and do not work well outside their designed frequency range.

Conventional down-converters generate unwanted image signals and thus must include filters for filtering the unwanted image signals. However, such filters reduce the power level of the modulated carrier signals. As a result, conventional down-converters include power amplifiers, which require external energy sources.

When a received modulated carrier signal is relatively weak, as in, for example, a radio receiver, conventional down-converters include additional power amplifiers, which require additional external energy.

The document US 5454007 discloses a circuit that uses two clock signals to down-convert a bandpass signal to a complex baseband signal having I and Q components.

The document US 5883548 discloses a demodulator that uses multipliers to extract even and odd harmonic components from a modulated carrier signal, where the signals provided to the multipliers are phase shifted by 90°.

### *Summary of the Invention*

According to one aspect of the present invention, there is provided an apparatus according to claim 1. According to another aspect of the present invention, there is provided a method according to claim 30.

Generally, embodiments of the invention operate by receiving an EM signal and also receiving an aliasing signal having an aliasing rate. These embodiments alias the EM signal according to the aliasing signal to down-convert the EM signal.

In an embodiment of the invention, the EM signal is down-converted to an intermediate frequency (IF) signal.

In another embodiment of the invention, the EM signal is down-converted to a demodulated baseband information signal.

In another embodiment of the invention, the EM signal is a frequency modulated (FM) signal, which is down-converted to a non-FM signal, such as a phase modulated (PM) signal or an amplitude modulated (AM) signal.

In another embodiment of the invention, the EM signal is an I/Q modulated signal, which is down-converted to an in-phase information signal and a quadrature-phase information signal.

Embodiments of the invention may be used to down-convert any type of EM signal, including but not limited to, modulated carrier signals (the invention is applicable to anymodulation scheme or combination thereof) and unmodulated carrier signals.

Further features and advantages of the invention, as well as the structure and operation of various embodiments of the invention, are described in detail below with reference to the accompanying drawings. In the drawings, like reference numbers generally indicate identical, functionally similar, and/or structurally similar elements.

### *Brief Description of the Figures*

The invention shall be described with reference to the accompanying figures, wherein:

FIG. 1A is a block diagram of a universal frequency translation (UFT) module according to an embodiment of the invention.

FIG. 1B is a more detailed diagram of a universal frequency translation (UFT) module according to an embodiment of the invention.

FIG. 1C illustrates a UFT module used in a universal frequency down-conversion (UFD) module according to an embodiment of the invention.

FIG. 2 is a block diagram of a universal frequency translation (UFT) module according to an alternative embodiment of the invention.

FIG. 3 illustrates a UFT module used in a receiver according to an embodiment of the invention.

FIGS. 4A and 4G are example aliasing modules according to embodiments of the invention.

FIGS. 4B-4F are example waveforms used to describe the operation of the aliasing modules of FIGS. 4A and 4G.

FIG. 5 illustrates an exemplary I/O modulation receiver, according to an embodiment of the present invention.

FIG. 6 illustrates a I/Q modulation control signal generator, according to an embodiment of the present invention.

FIG. 7 illustrates example waveforms related to the I/Q modulation control signal generator of FIG. 6.

FIG. 8 illustrates example control signal waveforms overlaid upon an input RF signal.

FIG. 9 illustrates a I/Q modulation receiver circuit diagram, according to an embodiment of the present invention.

FIGS. 10-20 illustrate example waveforms related to the receiver of FIG. 9.

FIG. 21 illustrates a single channel receiver, according to an embodiment of the present invention.

FIG. 22 illustrates an alternative I/Q modulation receiver, according to an embodiment of the present invention.

FIG. 23A illustrates an example antenna that transmits re-radiation.

FIGS. 23B-23D illustrates example signals and frequency spectrums related to re-radiation effects.

FIGS. 24A-D illustrate example aperture generators.

FIG. 24E illustrates an oscillator according to an embodiment of the present invention.

FIG. 25 illustrates an energy transfer system with an optional energy transfer signal module according to an embodiment of the invention.

FIG. 26A illustrates and example embodiment of the invention.

FIG. 26B illustrates example equations for determining charge transfer, in accordance with the present invention.

FIG. 26C illustrates relationships between capacitor charging and aperture, in accordance with an embodiment of the present invention.

FIG. 26D illustrates relationships between capacitor charging and aperture, in accordance with an embodiment of the present invention.

FIG. 26E illustrates power-charge relationship equations, in accordance with an embodiment of the present invention.

FIG. 26F illustrates insertion loss equations, in accordance with an embodiment of the present invention.

FIG. 27 illustrates a down-converter according to an embodiment of the present invention, showing some DC offset contributions.

FIG. 28 shows a conventional wireless communications down-conversion system.

FIG. 29 illustrates some aspects of charge injection related to the present invention.

FIG. 30 illustrates an exemplary circuit configuration for reducing DC offset voltage caused by charge injection, according to an embodiment of the present invention.

FIG. 31 illustrates an exemplary input RF signal and exemplary control signal waveforms, according to embodiments of the present invention.

FIG. 32 illustrates an exemplary I/Q modulation receiver circuit, according to an embodiment of the present invention.

FIGS. 33A-33I show an exemplary input RF I/Q signal, and several exemplary control signal waveforms.

FIG. 34 illustrates an exemplary buffered I/Q modulation receiver circuit, according to an embodiment of the present invention.

FIG. 35 depicts a flowchart that illustrates operational steps for down-converting an input signal and reducing a DC offset voltage, according to an embodiment of the present invention.

FIG. 36 depicts a flowchart that illustrates operational steps for down-converting an input signal with a variety of control signal pulse widths, according to an embodiment of the present invention.

FIG. 37 depicts a flowchart that illustrates operational steps for down-converting an RF I/Q modulated input signal, according to an embodiment of the present invention.

FIG. 38 depicts a flowchart that illustrates operational steps for down-converting an RF I/Q modulated input signal, according to an embodiment of the present invention.

FIG. 39 depicts a flowchart that illustrates operational steps for down-converting a RF I/Q modulated signal and reducing DC offset voltages, according to an embodiment of the present invention.

### Detailed Description of the Preferred Embodiments

### 1. Overview of the Invention

The present invention is directed to receivers implemented using universal frequency translation (UFT) modules. The UFT modules perform frequency translation operations. Embodiments of the present invention incorporating various applications of the UFT module are described below.

Receivers exhibit multiple advantages by using UFT modules. These advantages include, but are not limited to, lower power consumption, longer power source life, fewer parts, lower required package size, lower package weight, lower cost, less tuning, and more effective signal transmission and reception. Receivers in accordance with embodiments of the present invention can receive and transmit signals across a broad frequency range. Furthermore, DC offset voltages and re-radiation generated by such receivers are reduced or eliminated in embodiments of the present invention. The structure and operation of embodiments of the UFT module, and various applications of the same, utilizing DC offset/re-radiation reduction, are described in detail in the following sections.

### 2. Universal Frequency Translation

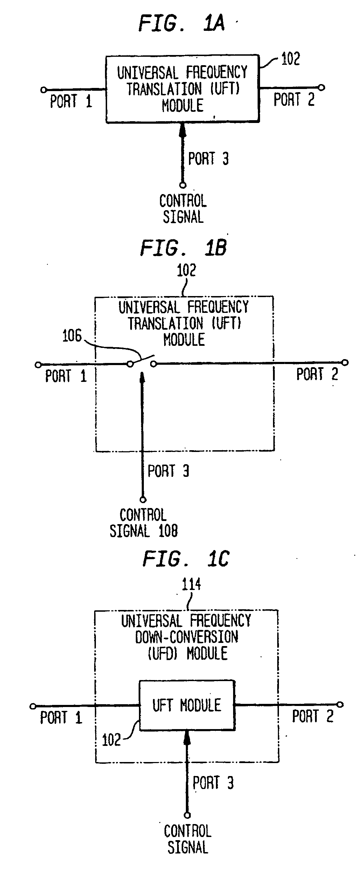

FIG. 1A illustrates a universal frequency translation (UFT) module 102 according to embodiments of the invention. (The UFT module is also sometimes called a universal frequency translator, or a universal translator.)

As indicated by the example of FIG. 1A, some embodiments of the UFT module 102 include three ports (nodes), designated in FIG. 1A as Port 1, Port 2, and Port 3. Other UFT embodiments include other than three ports.

Generally, the UFT module 102 (perhaps in combination with other components) operates to generate an output signal from an input signal, where the frequency of the output signal differs from the frequency of the input signal. In other words, the UFT module 102 (and perhaps other components) operates to generate the output signal from the input signal by translating the frequency (and perhaps other characteristics) of the input signal to the frequency (and perhaps other characteristics) of the output signal.

Another example embodiment of the UFT module 102 is generally illustrated in FIG. 1B. Generally, the UFT module 102 includes a switch 106 controlled by a control signal 108. The switch 106 is said to be a controlled switch.

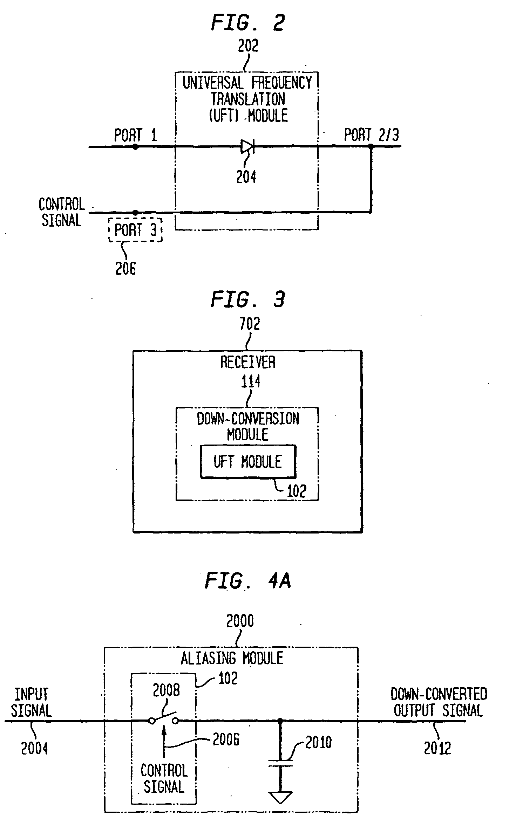

As noted above, some UFT embodiments include other than three ports. For example, and without limitation, FIG. 2 illustrates an example UFT module 202. The example UFT module 202 includes a diode 204 having two ports, designated as Port 1 and Port 2/3. This embodiment does not include a third port, as indicated by the dotted line around the "Port 3" label.

The UFT module is a very powerful and flexible device. Its flexibility is illustrated, in part, by the wide range of applications in which it can be used. Its power is illustrated, in part, by the usefulness and performance of such applications.

For example, a UFT module 102 can be used in a universal frequency down-conversion (UFD) module 114, an example of which is shown in FIG. 1C. In this capacity, the UFT module 102 frequency down-converts an input signal to an output signal. This is also shown in FIG. 3, for example, where an example UFT module 102 is part of a down-conversion module 114, which is part of a receiver 702.

### 3. Frequency Down-conversion

The following discussion describes down-converting using a Universal Frequency Translation Module. The down-conversion of an EM signal by aliasing the EM signal at an aliasing rate is fully described in U.S. Patent No. 6,061,551 entitled "Method and System for Down-Converting Electromagnetic Signals." A relevant portion of the above mentioned patent application is summarized below to describe down-converting an input signal to produce a down-converted signal that exists at a lower frequency or a baseband signal.

FIG. 4A illustrates an aliasing module 2000 for down-conversion using a universal frequency translation (UFT) module 102 which down-converts an EM input signal 2004. In particular embodiments, aliasing module 2000 includes a switch 2008 and a capacitor 2010. The electronic alignment of the circuit components is flexible. That is, in one implementation, the switch 2008 is in series with input signal 2004 and capacitor 2010 is shunted to ground (although it may be other than ground in configurations such as differential mode). In a second implementation (see FIG. 4G), the capacitor 2010 is in series with the input signal 2004 and the switch 2008 is shunted to ground (although it may be other than ground in configurations such as differential mode). Aliasing module 2000 with UFT module 102 can be easily tailored to down-convert a wide variety of electromagnetic signals using aliasing frequencies that are well below the frequencies of the EM input signal 2004.

In one implementation, aliasing module 2000 down-converts the input signal 2004 to an intermediate frequency (IF) signal. In another implementation, the aliasing module 2000 down-converts the input signal 2004 to a demodulated baseband signal. In yet another implementation, the input signal 2004 is a frequency modulated (FM) signal, and the aliasing module 2000 down-converts it to a non-FM signal, such as a phase modulated (PM) signal or an amplitude modulated (AM) signal. Each of the above implementations is described below.

In an embodiment, the control signal 2006 includes a train of pulses that repeat at an aliasing rate that is equal to, or less than, twice the frequency of the input signal 2004. In this embodiment, the control signal 2006 is referred to herein as an aliasing signal because it is below the Nyquist rate for the frequency of the input signal 2004. Preferably, the frequency of control signal 2006 is much less than the input signal 2004.

A train of pulses 2018 as shown in FIG. 4D controls the switch 2008 to alias the input signal 2004 with the control signal 2006 to generate a down-converted output signal 2012. More specifically, in an embodiment, switch 2008 closes on a first edge of each pulse 2020 of FIG. 4D and opens on a second edge of each pulse. When the switch 2008 is closed, the input signal 2004 is coupled to the capacitor 2010, and charge is transferred from the input signal to the capacitor 2010. The charge stored during successive pulses forms down-converted output signal 2012.

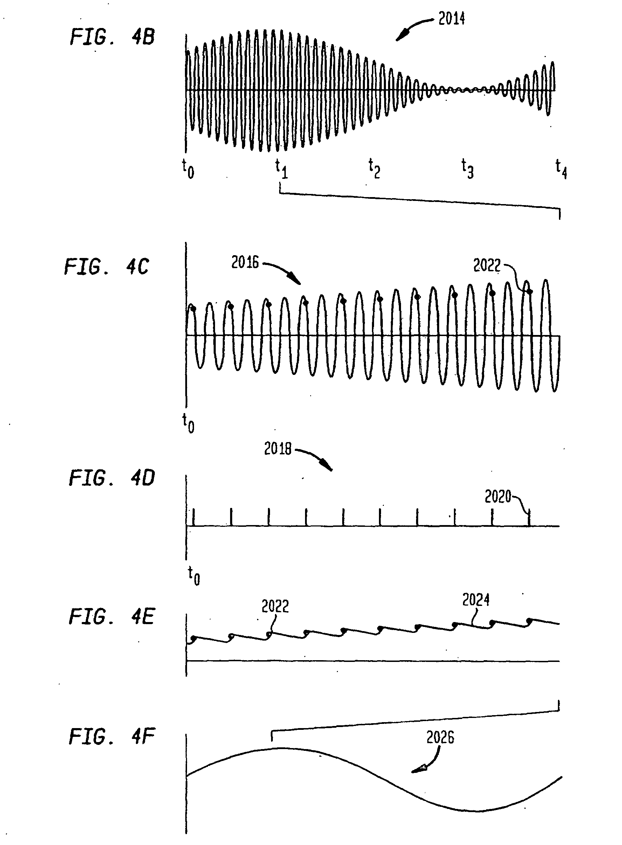

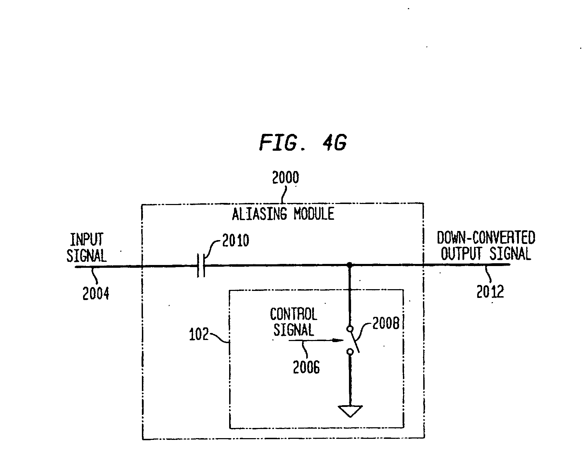

Exemplary waveforms are shown in FIGS. 4B-4F.

FIG. 4B illustrates an analog amplitude modulated (AM) carrier signal 2014 that is an example of input signal 2004. For illustrative purposes, in FIG. 4C, an analog AM carrier signal portion 2016 illustrates a portion of the analog AM carrier signal 2014 on an expanded time scale. The analog AM carrier signal portion 2016 illustrates the analog AM carrier signal 2014 from time $t_0$ to time $t_1$.

FIG. 4D illustrates an exemplary aliasing signal 2018 that is an example of control signal 2006. Aliasing signal 2018 is on approximately the same time scale as the analog AM carrier signal portion 2016. In the example shown in FIG. 4D, the aliasing signal 2018 includes a train of pulses 2020 having negligible apertures that tend towards zero. The pulse aperture may also be referred to as the pulse width as will be understood by those skilled in the art(s). The pulses 2020 repeat at an aliasing rate, or pulse repetition rate of aliasing signal 2018. The aliasing rate is determined as described below, and further described in U.S. Patent No. 6,061,551 entitled "Method and System for Down-converting Electromagnetic Signals," referenced above.

As noted above, the train of pulses 2020 (i.e., control signal 2006) control the switch 2008 to alias the analog AM carrier signal 2016 (i.e., input signal 2004) at the aliasing rate of the aliasing signal 2018. Specifically, in this embodiment, the switch 2008 closes on a first edge of each pulse and opens on a second edge of each pulse. When the switch 2008 is closed, input signal 2004 is coupled to the capacitor 2010, and charge is transferred from the input signal 2004 to the capacitor 2010. The charge transferred during a pulse is referred to herein as an under-sample. Exemplary under-samples 2022 form down-converted signal portion 2024 (FIG. 4E) that corresponds to the analog AM carrier signal portion 2016 (FIG. 4C) and the train of pulses 2020 (FIG. 4D). The charge stored during successive under-samples of AM carrier signal 2014 form the down-converted signal 2024 (FIG. 4E) that is an example of down-converted output signal 2012 (FIG. 4A). In FIG. 4F, a demodulated baseband signal 2026 represents the demodulated baseband signal 2024 after filtering on a compressed time scale. As illustrated, down-converted signal 2026 has substantially the same "amplitude envelope" as AM carrier signal 2014. Therefore, FIGS. 4B-4F illustrate down-conversion of AM carrier signal 2014.

The waveforms shown in FIGS. 4B-4F are discussed herein for illustrative purposes only, and are not limiting. Additional exemplary time domain and frequency domain drawings, and exemplary methods and systems of the invention relating thereto, are disclosed in U.S. Patent No. 6,061,551 entitled "Method and System for Down-converting Electromagnetic Signals," referenced above.

The aliasing rate of control signal 2006 determines whether the input signal 2004 is down-converted to an IF signal, down-converted to a demodulated baseband signal, or down-converted from an FM signal to a PM or an AM signal. Generally, relationships between the input signal 2004, the aliasing rate of the control signal 2006, and the down-converted output signal 2012 are illustrated below:

$$\text{(Freq. of input signal 2004)} = n \cdot \text{(Freq. of control signal 2006)} \pm$$

(Freq. of down-converted output signal 2012)

For the examples contained herein, only the "+" condition will be discussed. The value of $n$ represents a harmonic or sub-harmonic of input signal 2004 (e.g., $n$ = 0.5, 1, 2, 3,...).

When the aliasing rate of control signal 2006 is off-set from the frequency of input signal 2004, or off-set from a harmonic or sub-harmonic thereof, input signal 2004 is down-converted to an IF signal. This is because the under-sampling pulses occur at different phases of subsequent cycles of input signal 2004. As a result, the under-samples form a lower frequency oscillating pattern. If the input signal 2004 includes lower frequency changes, such as amplitude, frequency, phase, etc., or any combination thereof, the charge stored during associated under-samples reflects the lower frequency changes, resulting in similar changes on the down-converted IF signal. For example, to down-convert a 901 MHZ input signal to a 1 MHZ IF signal, the frequency of the control signal 2006 would be calculated as follows:

$$(\text{Freq}_{input} - \text{Freq}_{IF})/n = \text{Freq}_{control}$$

$$(901 \text{ MHZ} - 1 \text{ MHZ})/n = 900/n$$

For n = 0.5, 1, 2, 3, 4, etc., the frequency of the control signal 2006 would be substantially equal to 1.8 GHz, 900 MHZ, 450 MHZ, 300 MHZ, 225 MHZ, etc.

Exemplary time domain and frequency domain drawings, illustrating down-conversion of analog and digital AM, PM and FM signals to IF signals, and exemplary methods and systems thereof, are disclosed in U.S. Patent No. 6,061,551 entitled "Method and System for Down-converting Electromagnetic Signals," referenced above.

Alternatively, when the aliasing rate of the control signal 2006 is substantially equal to the frequency of the input signal 2004, or substantially equal to a harmonic or sub-harmonic thereof, input signal 2004 is directly down-converted to a demodulated baseband signal. This is because, without modulation, the under-sampling pulses occur at the same point of subsequent cycles of the input signal 2004. As a result, the under-samples form a constant output baseband signal. If the input signal 2004 includes lower frequency changes, such as amplitude, frequency, phase, etc., or any combination thereof, the charge stored during associated under-samples reflects the lower frequency changes, resulting in similar changes on the demodulated baseband signal. For example, to directly down-convert a 900 MHZ input signal to a demodulated baseband signal (i.e., zero IF), the frequency of the control signal 2006 would be calculated as follows:

$$(\text{Freq}_{input} - \text{Freq}_{IF})/n = \text{Freq}_{control}$$

$$(900 \text{ MHZ} - 0 \text{ MHZ})/n = 900 \text{ MHZ}/n$$

For $n$ = 0.5, 1, 2, 3, 4, etc., the frequency of the control signal 2006 should be substantially equal to 1.8 GHz, 900 MHZ, 450 MHZ, 300 MHZ, 225 MHZ, etc.

Exemplary time domain and frequency domain drawings, illustrating direct down-conversion of analog and digital AM and PM signals to demodulated baseband signals, and exemplary methods and systems thereof, are disclosed in U.S. Patent No. 6,061,551 entitled "Method and System for Down-converting Electromagnetic Signals," referenced above.

Alternatively, to down-convert an input FM signal to a non-FM signal, a frequency within the FM bandwidth must be down-converted to baseband (i.e., zero IF). As an example, to down-convert a frequency shift keying (FSK) signal (a sub-set of FM) to a phase shift keying (PSK) signal (a subset of PM), the midpoint between a lower frequency $F_1$ and an upper frequency $F_2$ (that is, $[(F_1 + F_2) \div 2]$) of the FSK signal is down-converted to zero IF. For example, to down-convert an FSK signal having $F_1$ equal to 899 MHZ and $F_2$ equal to 901 MHZ, to a PSK signal, the aliasing rate of the control signal 2006 would be calculated as follows:

$$\text{Frequency of the input} = (F_1 + F_2) \div 2 = (899 \text{ MHZ} + 901 \text{ MHZ}) \div 2 = 900 \text{ MHZ}$$

Frequency of the down-converted signal = 0 (i.e., baseband)

$$(\text{Freq}_{\text{input}} - \text{Freq}_{\text{IF}})/n = \text{Freq}_{\text{control}}$$

$$(900 \text{ MHZ} - 0 \text{ MHZ})/n = 900 \text{ MHZ}/n$$

For $n = 0.5, 1, 2, 3$, etc:, the frequency of the control signal 2006 should be substantially equal to 1.8 GHz, 900 MHZ, 450 MHZ, 300 MHZ, 225 MHZ, etc. The frequency of the down-converted PSK signal is substantially equal to one half the difference between the lower frequency $F_1$ and the upper frequency $F_2$.

As another example, to down-convert a FSK signal to an amplitude shift keying (ASK) signal (a subset of AM), either the lower frequency $F_1$ or the upper frequency $F_2$ of the FSK signal is down-converted to zero IF. For example, to down-convert an FSK signal having $F_1$ equal to 900 MHZ and $F_2$ equal to 901 MHZ, to an ASK signal, the aliasing rate of the control signal 2006 should be substantially equal to:

$$(900 \text{ MHZ} - 0 \text{ MHZ})/n = 900 \text{ MHZ}/n,$$

or

$$(901 \text{ MHZ} - 0 \text{ MHZ})/n = 901 \text{ MHZ}/n.$$

For the former case of 900 MHZ/$n$, and for $n = 0.5, 1, 2, 3, 4$, etc., the frequency of the control signal 2006 should be substantially equal to 1.8 GHz, 900 MHZ, 450 MHZ, 300 MHZ, 225 MHZ, etc. For the latter case of 901 MHZ/$n$, and for $n = 0.5, 1, 2, 3, 4$, etc., the frequency of the control signal 2006 should be substantially equal to 1.802 GHz, 901 MHZ, 450.5 MHZ, 300.333 MHZ, 225.25 MHZ, etc. The frequency of the down-converted AM signal is substantially equal to the difference between the lower frequency $F_1$ and the upper frequency $F_2$ (i.e., 1 MHZ).

Exemplary time domain and frequency domain drawings, illustrating down-conversion of FM signals to non-FM signals, and exemplary methods and systems thereof, are disclosed in the U.S. Patent No. 6,061,551 entitled "Method and System for Down-converting Electromagnetic Signals," referenced above.

In an embodiment, the pulses of the control signal 2006 have negligible apertures that tend towards zero. This makes the UFT module 102 a high input impedance device. This configuration is useful for situations where minimal disturbance of the input signal may be desired.

In another embodiment, the pulses of the control signal 2006 have non-negligible apertures that tend away from zero. This makes the UFT module 102 a lower input impedance device. This allows the lower input impedance of the UFT module 102 to be substantially matched with a source impedance of the input signal 2004. This also improves the energy transfer from the input signal 2004 to the down-converted output signal 2012, and hence the efficiency and signal to noise (s/n) ratio of UFT module 102.

Exemplary systems and methods for generating and optimizing the control signal 2006 and for otherwise improving energy transfer and s/n ratio, are disclosed in the U.S. Patent No. 6,061,551 entitled "Method and System for Down-converting Electromagnetic Signals," referenced above.

When the pulses of the control signal 2006 have non-negligible apertures, the aliasing module 2000 is referred to interchangeably herein as an energy transfer module or a gated transfer module, and the control signal 2006 is referred to as an energy transfer signal. Exemplary systems and methods for generating and optimizing the control signal 2006 and for otherwise improving energy transfer and/or signal to noise ratio in an energy transfer module are described below.

### 3.1. Optional Energy Transfer Signal Module

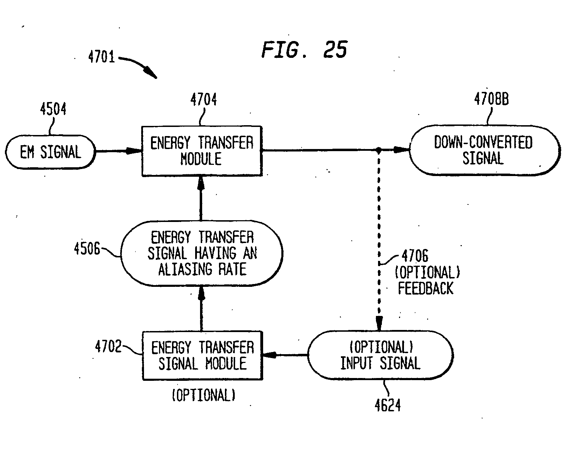

FIG. 25 illustrates an energy transfer system 4701 that includes an optional energy transfer signal module 4702, which can perform any of a variety of functions orcombinations of functions including, but not limited to, generating the energy transfer signal 4506.

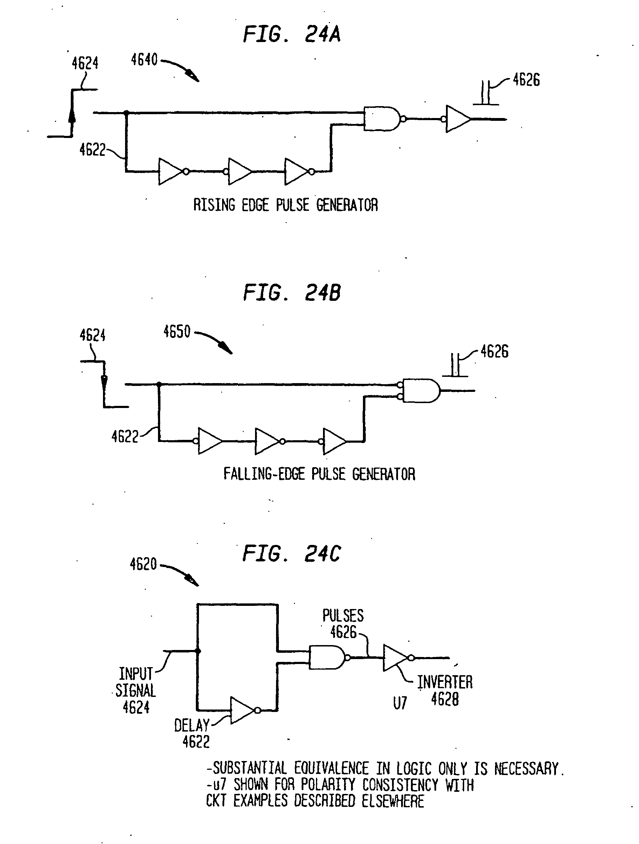

In an embodiment, the optional energy transfer signal module 4702 includes an aperture generator, an example of which is illustrated in FIG. 24C as an aperture generator 4620. The aperture generator 4620 generates non-negligible aperture pulses 4626 from an input signal 4624. The input signal 4624 can be any type of periodic signal, including, but not limited to, a sinusoid, a square wave, a saw-tooth wave, etc. Systems for generating the input signal 4624 are described below.

The width or aperture of the pulses 4626 is determined by delay through the branch 4622 of the aperture generator 4620. Generally, as the desired pulse width increases, the difficulty in meeting the requirements of the aperture generator 4620 decrease. In other words, to generate non-negligible aperture pulses for a given EM input frequency, the components utilized in the example aperture generator 4620 do not require as fast reaction times as those that are required in an under-sampling system operating with the same EM input frequency.

The example logic and implementation shown in the aperture generator 4620 are provided for illustrative purposes only, and are not limiting. The actual logic employed can take many forms. The example aperture generator 4620 includes an optional inverter 4628, which is shown for polarity consistency with other examples provided herein.

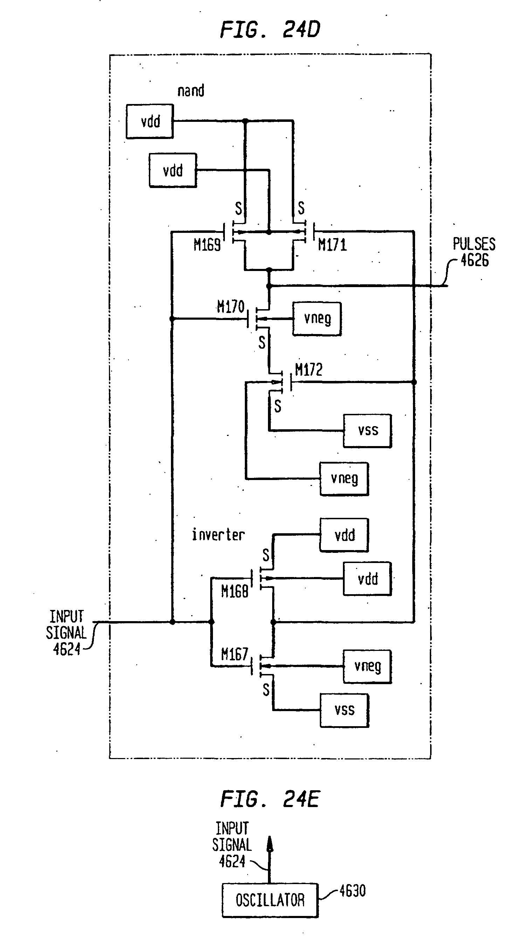

An example implementation of the aperture generator 4620 is illustrated in FIG. 24D. Additional examples of aperture generation logic are provided in FIGS. 24A and 24B. FIG. 24A illustrates a rising edge pulse generator 4640, which generates pulses 4626 on rising edges of the input signal 4624. FIG. 24B illustrates a falling edge pulse generator 4650, which generates pulses 4626 on falling edges of the input signal 4624.

In an embodiment, the input signal 4624 is generated externally of the energy transfer signal module 4702, as illustrated in FIG. 25. Alternatively, the input signal 4724 is generated internally by the energy transfer signal module 4702. The input signal 4624 can be generated by an oscillator, as illustrated in FIG. 24E by an oscillator 4630. The oscillator 4630 can be internal to the energy transfer signal module 4702 or external to the energy transfer signal module 4702. The oscillator 4630 can be external to the energy transfer system 4701. The output of the oscillator 4630 may be any periodic waveform.

The type of down-conversion performed by the energy transfer system 4701 depends upon the aliasing rate of the energy transfer signal 4506, which is determined by the frequency of the pulses 4626. The frequency of the pulses 4626 is determined by the frequency of the input signal 4624. For example, when the frequency of the input signal 4624 is substantially equal to a harmonic or a sub-harmonic of the EM signal 4504, the EM signal 4504 is directly down-converted to baseband (e.g. when the EM signal is an AM signal or a PM signal), or converted from FM to a non-FM signal. When the frequency of the input signal 4624 is substantially equal to a harmonic or a sub-harmonic of a difference frequency, the EM signal 4504 is down-converted to an intermediate signal.

The optional energy transfer signal module 4702 can be implemented in hardware, software, firmware, or any combination thereof.

### 3.2 Charge and Power Transfer Concepts

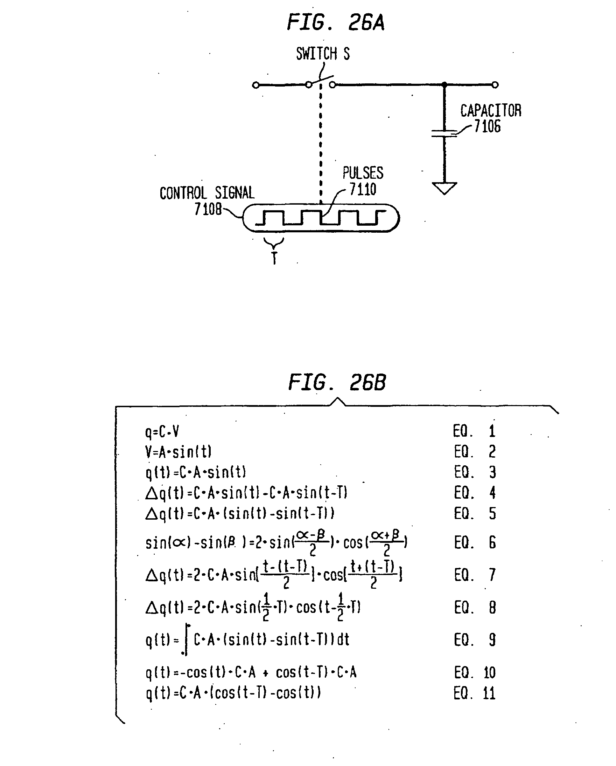

Concepts of charge transfer are now described with reference to FIGS. 26A-26F. FIG. 26A illustrates a circuit 7102, including a switch S and a capacitor 7106 having a capacitance C. The switch S is controlled by a control signal 7108, which includes pulses 7110 having apertures T.

In FIG. 26B, Equation I illustrates that the charge q on a capacitor having a capacitance C, such as the capacitor 7106, is proportional to the voltage V across the capacitor, where:

q = Charge in Coulombs
C = Capacitance in Farads
V = Voltage in Volts
A = Input Signal Amplitude

Where the voltage V is represented by Equation 2, Equation 1 can be rewritten as Equation 3. The change in charge $\Delta q$ over time t is illustrated as in Equation 4 as $\Delta q(t)$, which can be rewritten as Equation 5. Using the sum-to-product trigonometric identity of Equation 6, Equation 5 can be rewritten as Equation 7, which can be rewritten as equation 8.

Note that the sin term in Equation 2 is a function of the aperture T only. Thus, $\Delta q(t)$ is at a maximum when T is equal to an odd multiple of $\pi$ (i.e., $\pi$, $3\pi$, $5\pi$,...). Therefore, the capacitor 7106 experiences the greatest change in charge when the aperture T has a value of $\pi$ or a time interval representative of 180 degrees of the input sinusoid. Conversely, when T is equal to $2\pi$, $4\pi$, $6\pi$, ..., minimal charge is transferred.

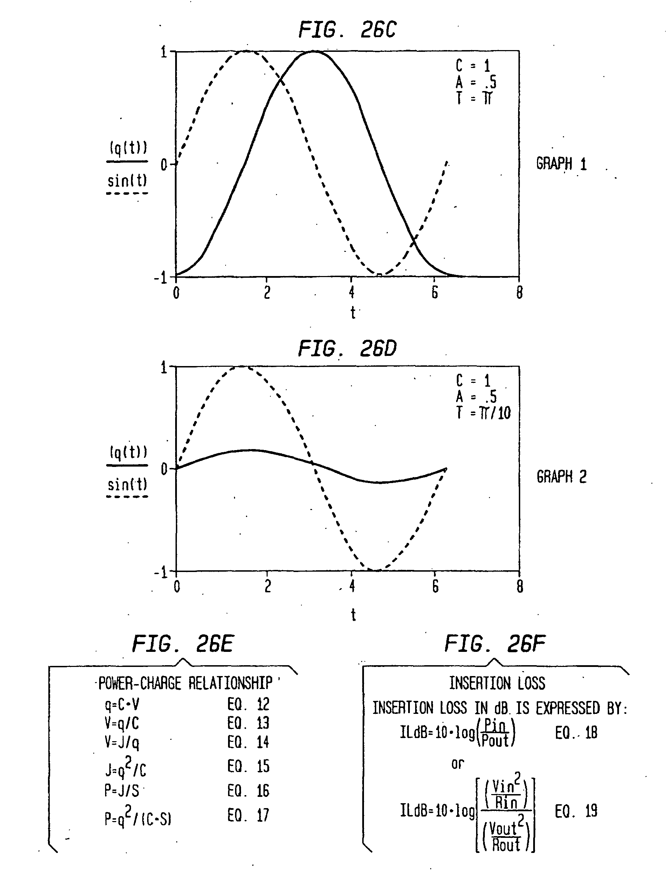

Equations 9, 10, and 11 solve for q(t) by integrating Equation 1, allowing the charge on the capacitor 7106 with respect to time to be graphed on the same axis as the input sinusoid sin(t), as illustrated in the graph of FIG. 26C. As the aperture T decreases in value or tends toward an impulse, the phase between the charge on the capacitor C or q(t) and sin(t) tend toward zero. This is illustrated in the graph of FIG. 26D, which indicates that the maximum impulse charge transfer occurs near the input voltage maxima. As this graph indicates, considerably less charge is transferred as the value of T decreases.

Power/charge relationships are illustrated in Equations 12-17 of FIG. 26E, where it is shown that power is proportional to charge, and transferred charge is inversely proportional to insertion loss.

Concepts of insertion loss are illustrated in FIG. 26F. Generally, the noise figure of a lossy passive device is numerically equal to the device insertion loss. Alternatively, the noise figure for any device cannot be less that its insertion loss. Insertion loss can be expressed by Equation 18 or 19. From the above discussion, it is observed that as the aperture T increases, more charge is transferred from the input to the capacitor 7106, which increases power transfer from the input to the output. It has been observed that it is not necessary to accurately reproduce the input voltage at the output because relative modulated amplitude and phase information is retained in the transferred power.

### 4. DC Offset, Re-radiation, and Dynamic Range Considerations and Corrections

### 4.1 Overview of DC Offset and Re-radiation

Receivers, and other electronic circuits, may suffer from problems of DC offset and re-radiation. Generally, "DC offset" refers to a DC voltage level that is added to a signal of interest by related circuitry. The related circuitry creates the DC offset voltage through a variety of mechanisms that are well known. Some of these mechanisms are discussed in further detail below. If a DC offset voltage value is significant, it can degrade the quality of the signal of interest. In a receiver, for example, the signal of interest may be a down-converted signal. Unless reduced or eliminated, the added DC offset voltage level may undesirably change the voltage value of the down-converted signal. As a result, the actual voltage value of the down-converted signal may be difficult to ascertain by downstream processing.

Generally, "re-radiation" is an undesired phenomenon where a signal comprising one or more frequency components generated by receiving circuitry is transmitted by an antenna. For example, the frequency components may be generated by a local oscillator of the receiving circuitry. When transmitted, these frequency components may undesirably interfere with nearby receivers, or may be received back by the same antenna that transmitted them. When the frequency components are received back by the same antenna that transmitted them, this may be referred to "re-radiation recapture". The phenomenon of re-radiation recapture may further impair signals that are down-converted, and/or may cause undesirable DC offset voltages that may impair the down-converted signals. For instance, the re-radiated and recaptured signal may appear to the receiver as unwanted noise, within or without the frequency band (s) of interest, or may combine with local signals to create an undesired DC offset voltage. The phenomenon of creating a DC offset voltage by re-radiation recapture is described further below. Solutions provided herein for eliminating unwanted DC offset voltages apply to eliminating DC offset voltages produced from re-radiation recapture.

Furthermore, signals in a receiver circuit may travel or radiate to other receiver circuit sections, causing problems similar to those of re-radiation recapture described above, including problems of noise and DC offset voltages. For instance, local oscillator signals may undesirably transmit through the circuit substrate, through the air, or through other paths, to other receiver circuit sections, causing unwanted noise problems and problems with unwanted DC offset voltages being generated. Circuits provided herein for solving problems with DC offsets, re-radiation, and re-radiation recapture also apply to solving problems of noise and unwanted DC offset voltages caused by this phenomenon.

The concepts of DC offset and re-radiation are further described in the following sub-sections. Furthermore, example methods and systems are provided in subsequent sections below for reducing or eliminating unwanted DC offset and re-radiation. Such methods and systems can be used alone, or in combination with each other, to address offset issues.

### 4.1.1 Introduction

Embodiments of the UFT module may be used in many communications applications. For some of these applications, the signal space may include waveforms with near DC content. Such waveforms exist, for example, in signals transmitted at radio frequencies. Hence, it may be advantageous to limit the amount of artificial DC insertion or DC offsets contributed by the UFT module or its complimentary demodulation architecture.

This section presents an overview of DC offset contributions of the UFT module, and related circuitry, relevant for zero IF implementation. In addition, embodiments of the present invention are presented for reducing the adverse impacts of the DC offsets.

### 4.1.2 DC Offset Model Overview

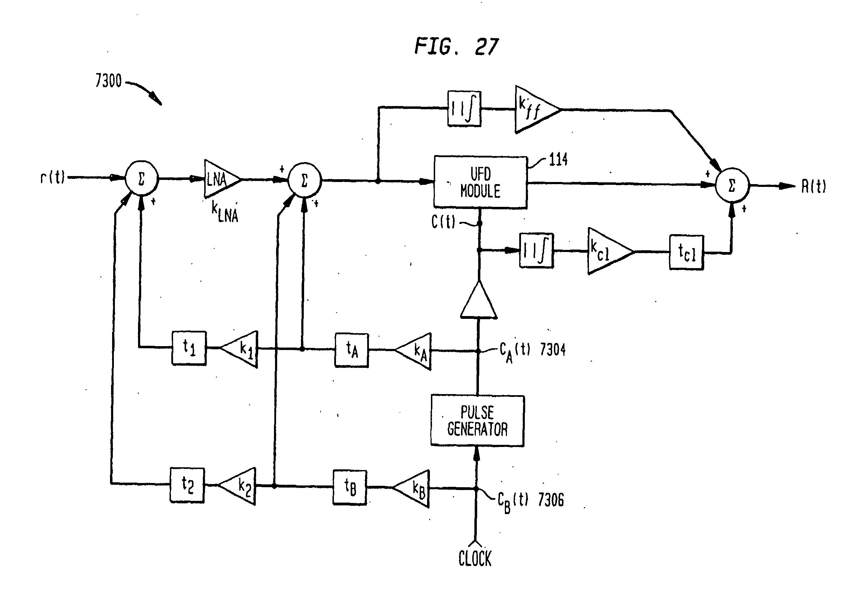

FIG. 27 illustrates a down-conversion circuit 7300 according to an embodiment of the present invention. The down-conversion circuit 7300 of FIG. 73 provides a model that indicates possible DC offset contributions. Down-conversion circuit 7300 comprises a UFD module 114. UFD module 114 comprises a UFT module 102 (not shown).

There are at least three significant categories of offsets.

1. Clock Excitation or Charge Injected
2. Re-radiation Offsets
3. Intermodulation Distortion

Each category possesses its own mechanisms.

The following definitions in Table 1 set the backdrop for analysis and understanding of the offset phenomena from a high level model. At least some of the phenomena relevant to the discussion in terms of device physics may be lumped into one or more of the following model parameters.

$$R(t)=[r(t)+k_1k_2C_A(t'_A)+k_2k_BC_B(t'_B)k_{LNA}+k_AC_A(t'_A)+k_BC_B(t'B)]C(t)+<|\bar{C}(t)|>k_{c\lambda} \qquad \text{Eq. 20}$$

Table 1

| $r(t) = s(t)+ n(t);.$ | r(t) is the received signal of interest which consists of a modulated carrier $s(t)$ and a noise component $n(t)$. |
|---|---|
| $k_1k_AC(t'_{A1})$ or $k_AC(t'_A)$ | This signal is a conditioned clock 7304 or transient waveform, which leaks to the core input of UFD module 114 across free-space, substrate, etc.<br>$t'_{A1}$ is a delayed time variable.<br>$t_{A1} = t - t_A - t_1$ where $t_A$ is the delay of the specific (A) path, and t, is the additional delay through the (1) path. |
| $k_2k_BC_B(t'_{B2})$ or $k_BC_B(t'_B)$ | This signal is similar to the one described above except that the leakage paths and delays are different and the leakage signal is a raw clock 7306 rather than a conditioned clock 7304. |
| $<|\bar{C}(t)|>k_{c\lambda}$ | This is a signal which is self-generating at UFD module 114, and is derived from the charge injection phenomena at UFD module 114 when the conditioned clock 7304 or control is active. Essentially, the conditioned clock $C(t)$ is modified by a nonlinear operation (in this case an abs function) averaged or integrated over some interval and scaled by a gain constant $k_{c\lambda}$, and delayed by $t_{c\lambda}$.<br>When $C(t)$ is not active, then $<|\bar{C}(t)|>\cdot k_{c\lambda,} \rightarrow 0$. This offset term is summed effectively at the output of UFD module 114.<br>< > denotes the expectation operation. |
| $* k_{ff}$ | Gain constant associated with feed forward charge injection path. This path is typically of interest when interferences are present. Usually, offsets will not be significant unless the S/I (Signal to Interference power) is very low and I is very large. |

There may be additional leakage terms, which are not illustrated in the model.

### 4.2 Example Embodiments to Address DC Offset and Re-radiation Problems

Section 4.1 above discussed problems related to DC offset and re-radiation that occur during and after the down-conversion process. Various embodiments related to the problems described above are presented in this section (and its subsections). In particular, applications of the UFT module are provided below in circuit configurations that reduce or eliminate problems ofDC offset and re-radiation.

### 4.2.1 DC Offset

Exemplary embodiments are provided below for reducing or eliminating unwanted DC offset voltages. These unwanted DC offset voltages include unwanted DC offset voltages created by any source, including non-ideal circuit component operation, re-radiation recapture, local circuit signals traveling or radiating to other circuit sections, etc. These embodiments may also be applicable to reducing or eliminating unwanted circuit re-radiation.

### 4.2.2 Conventional Wireless Communications Receiver

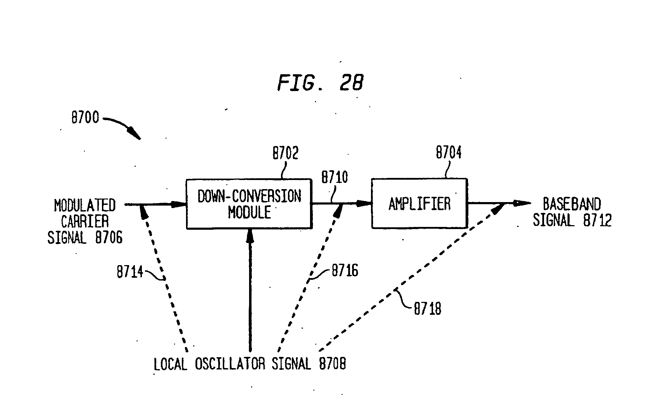

FIG. 28 shows an example conventional wireless communications down-conversion system 8700. Down-conversion system 8700 comprises a down-conversion module 8702 and an amplifier 8704. Down-conversion module 8702 typically comprises a super-heterodyne receiver. Down-conversion module 8702 may comprise multiple down-conversion stages. Amplifier 8704 may comprise an amplifier, a filter, other signal processing component(s), or any combination thereof.

Down-conversion module 8702 down-converts a modulated carrier signal 8706, according to at least one local oscillator signal 8708, to a down-converted baseband signal 8710.

Down-converted baseband signal 8710 is input to amplifier 8704. Amplifier 8704 amplifies, filters, and/or otherwise processes down-converted signal 8710, and outputs baseband signal 8712.

As described above, and shown in FIG. 28, DC offsets due to local oscillator signal 8708 may be input to the signal path at several points, with some possible points indicated by charge leakage and charge injection paths 8714, 8716, and 8718. As described above, charge leakage and charge injection are well known effects. These DC offsets disadvantageously affect at least the dynamic range and accuracy of baseband signal 8712. For instance, adding a significant DC offset to baseband signal 8712 may cause the output of subsequent amplifiers in the baseband signal path to approach the level of their power supplies, potentially causing the amplifiers to rail or become non-linear.

### 4.2.3 Charge Injection Reduction Embodiment

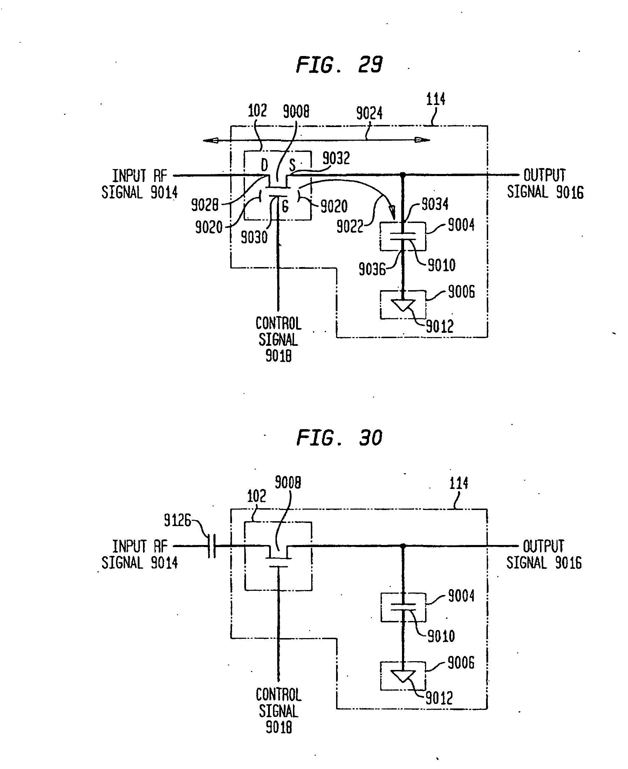

In this section, an embodiment, according to the present invention, is provided for reducing or eliminating DC offset due at least to charge injection. FIG. 29 illustrates some aspects of charge injection related to the present invention. FIG. 29 shows a UFD module 114 comprising a UFT module 102, a storage device 9004, and a reference potential 9006. In an embodiment, UFT module 102 comprises a MOSFET 9008, and storage device 9004 comprises a capacitor 9010.

An input RF signal 9014 is received by a first terminal 9028 of MOSFET 9008. A control signal 9018 is received by a second terminal 9030 of MOSFET 9008. A third terminal 9032 of MOSFET 9008 is coupled to a first terminal 9034 of storage device 9004. A second terminal 9036 of storage device 9004 is coupled to reference potential 9006 such as a ground 9012, or some other potential. In an embodiment, MOSFET 9008 contained within UFT module 102 opens and closes as a function of control signal 9018. As a result of the opening and closing of this switch, a down-converted signal, referred to as output signal 9016, results.

A well known phenomenon called charge injection may occur in such a switching environment. As control signal 9018 applies a pulse waveform to the gate of MOSFET 9008, MOSFET 9008 is caused to open and close. During this operation, charge allowed to flow along a DC path 9024 may build on the gate-to-drain and/or gate-to-source junctions of MOSFET 9008, as indicated on FIG. 29 as charge buildup 9020 (note that the source and drain terminals of MOSFET 9008 are essentially interchangeable). Charge buildup 9020 may leak from MOSFET 9020 through leakage path 9022, and become stored on capacitor 9010. This charge that becomes stored on capacitor 9010 may cause a change in the voltage across capacitor 9010. This voltage change may accordingly appear on output signal 9016 as a potentially non-negligible DC offset voltage. This non-negligible DC offset voltage on output signal 9016 may lead to difficulties in recovering the baseband information content of output signal 9016. Hence, it would be advantageous to reduce or prevent this potential generation ofDC offset voltage caused by this interaction of control signal 9018 with UFD module 114.

FIG. 30 illustrates an exemplary circuit configuration for reducing unwanted DC offset voltage caused by charge injection, according to an embodiment of the present invention.

FIG. 30 shows UFD module 114 of FIG. 29, with a capacitor 9126 coupled between input RF signal 9014 and UFD module 114. Capacitor 9126 is preferably a small valued capacitor, such as, but not limited to, 10 pF. The value for capacitor 9126 will vary depending upon the application, and accordingly its characteristics are implementation and application specific. Capacitor 9126 prevents DC current from flowing along the path shown as DC path 9024 in FIG. 29, and thus reduces or prevents the flow of charge to, and build up of charge on capacitor 9010. This in turn reduces or prevents a DC offset voltage resulting from the above described charge injection from appearing on output signal 9016. Hence, the baseband information content of output signal 9016 may be more accurately ascertained.

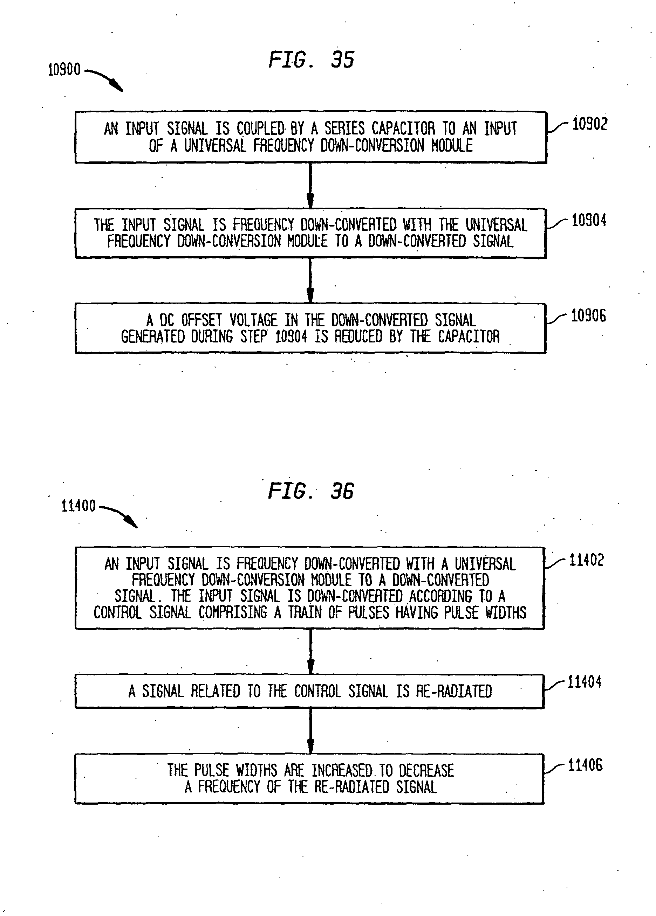

FIG. 35 depicts a flowchart 10900 that illustrates operational steps corresponding to FIG. 30, for down-converting an input signal and reducing a DC offset voltage, according to an embodiment of the present invention. In the following discussion, the steps in FIG. 35 will be described.

In step 10902, an input signal is coupled by a series capacitor to an input of a universal frequency down-conversion module.

In step 10904, the input signal is frequency down-converted with the universal frequency down-conversion module to a down-converted signal. The input signal is down-converted according to a control signal. The control signal under-samples the input signal.

In step 10906, aDC offset voltage in the down-converted signal generated during step 10904 is reduced. In an embodiment, the DC offset voltage is generated at least by charge injection effects due to interaction of the control signal with the universal frequency down-conversion module, as further described above.

### 4.2.4 Re-radiation

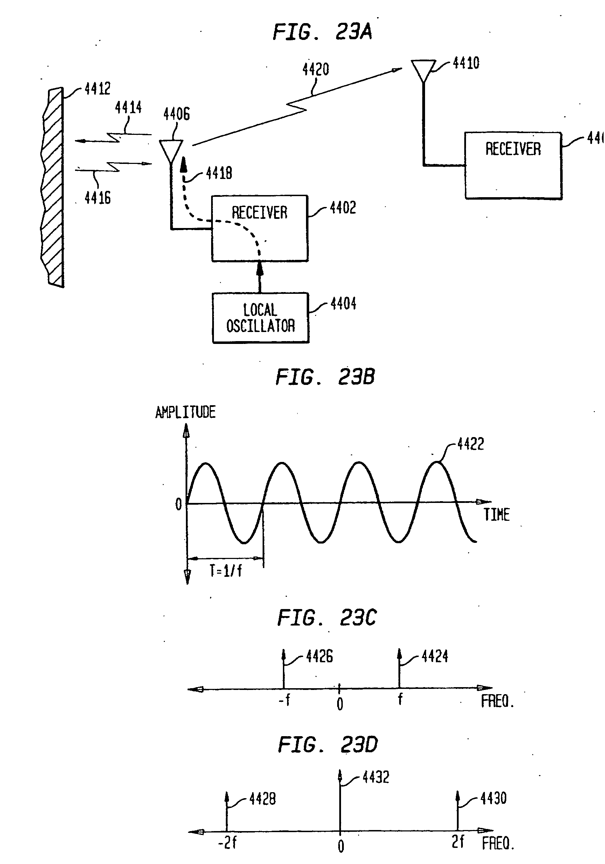

Re-radiation, as described above, is an undesirable phenomenon where a signal comprising one or more frequency components generated by receiving circuitry is transmitted by an antenna. FIG. 23A illustrates an antenna 4406 that transmits circuit re-radiation signals 4414 and 4420. Receiving circuitry, for example shown as a receiver 4402 and a local oscillator 4404, related to antenna 4406 may produce the transmitted frequency components. For example, the frequency components may be generated in part by local oscillator 4404. These generated frequency components may travel along re-radiation path 4418, where they are transmitted by antenna 4406 as re-radiation signals 4414 and 4420. When transmitted, these frequency components may undesirably interfere with one or more nearby receivers, such as nearby receiver 4408. An antenna 4420 may receive re-radiation signal 4420, which i s down-converted by nearby receiver 4408. One or more of the frequency components of received re-radiation signal 4420 may fall within a frequency range of interest of nearby receiver 4408, interfering with the quality of the signals intended to be down-converted by nearby receiver 4408.

As described above, re-radiation maybe undesirably received back by the same antenna that transmitted the re-radiation. As shown in FIG. 23A, receiver 4402 may transmit re-radiation signal 4414, which is subsequently reflected by an object 4412 as reflected re-radiation 4416, which is then received by antenna 4406. This is referred to as re-radiation recapture. If frequency components are received back by the same antenna that transmitted them, they may be down-converted, may further impair signals that are down-converted, and/or may cause undesirable DC offset voltages that may impair the down-converted signals. FIG. 23B shows an example local oscillator signal 4422, of a frequency of $f$. If a signal such as local oscillator signal 4422 is re-radiated, and subsequently received by the circuit that transmitted it, it may combine with itself to create an undesired DC offset voltage. FIG. 23C shows the Fourier transform of local oscillator signal 4422, with spectral components 4424 and 4426 at frequencies $+f$ and $-f$. FIG. 23D shows a result of the convolution of local oscillator signal 4422 with itself, producing a DC spectral component 4432 representing an undesired DC offset voltage. FIG. 23D shows resulting spectral components 4428 and 4430 at frequencies $+2f$ and $-2f$, and DC spectral component 4432 at a frequency of zero. DC spectral component 4432 may cause the same problems as DC offset voltages created by other mechanisms, such as those described elsewhere herein.

For at least these reasons, it is desirable to reduce or eliminate circuit re-radiation. Exemplary embodiments are provided below for reducing or eliminating circuit re-radiation. These embodiments may also be applicable to reducing or eliminating unwanted DC offset voltages.

### 4.2.4.1 Reducing Re-radiation by Adjusting Control Signal Attributes

In an embodiment of the present invention, a local oscillator may be used to generate a control signal used to down-convert received RF signals. The control signal may comprise frequency components related to the local oscillator frequency and its harmonics. As described above, one or more frequency components of the local oscillator signal may leak from a nearby antenna as circuit re-radiation. As a result, attributes of circuit re-radiation are directly related to attributes of control signal frequency components. Hence, re-radiation potentially may be reduced or eliminated by adjusting one or more attributes of the control signal frequency components. Control signal attributes that may be adjusted at least include control pulse width, control pulse amplitude, and/or control pulse phase.

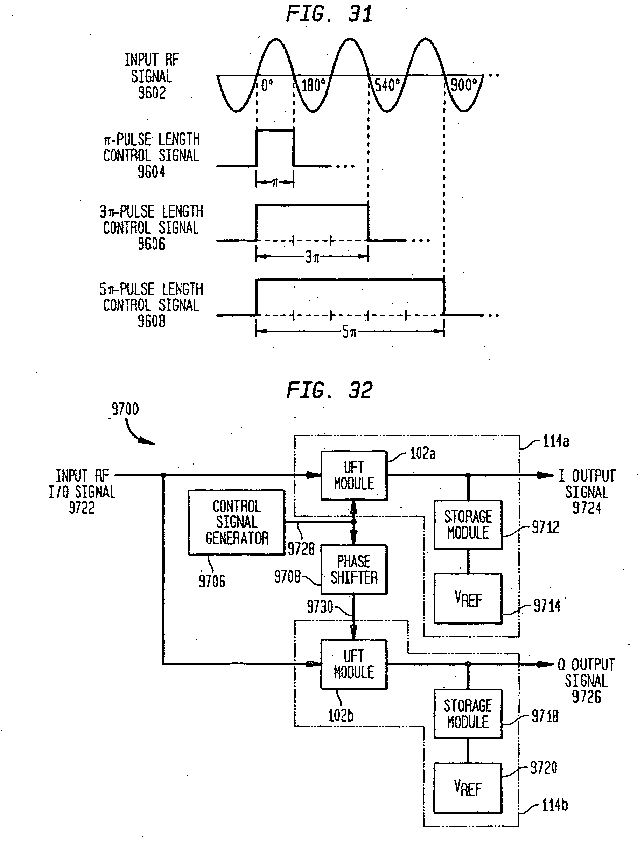

FIG. 31 shows an exemplary input RF signal 9602. A π-pulse length control signal 9604 is also shown that may be applied to a UFD module to down-convert input RF signal 9602. As shown, π-pulse length control signal 9604 comprises pulses that are of a length of π radians. In a receiver embodiment implementing a UFD module, a control signal such as π-pulse length control signal 9604 may be re-radiated from the receiver. In the time domain, the re-radiation may appear as noise pulses that are shaped similarly to pulses of the control signal. In certain situations, one or more of the frequencies of the re-radiated signal may undesirably fall within the output frequency bands of interest of the system implementing the receiver circuit. For instance, when down-converting a signal directly to baseband, a control signal frequency may be substantially equal to the frequency of the received RF carrier signal. If this control signal frequency is re-radiated, and then subsequently received and down-converted, it may result in one or more down-converted signal frequencies near or equal to DC, or at baseband, in a similar fashion to that described in FIGS. 23B-23D above. It would be beneficial if the re-radiated signal components within the frequency bands of interest could be eliminated or moved.

In an exemplary embodiment for changing the frequency content of the re-radiated signal, the pulse width of the control pulses of the control signal may be lengthened. As shown in FIG. 31, a 3π-pulse length control signal 9606 has control pulses of a length of 3π. Because the control pulse width of 3π-pulse length control signal 9606 is wider than that of π-pulse length control signal 9604, 3π-pulse length control signal 9606 is made up of lower frequency components. It is well known that signals comprising substantially square or rectangular pulses include a plurality of signals of various frequencies that add together to form the pulse shapes. As pulses become wider, the frequencies of the signals required to form them tend to become lower. Because 3π-pulse length control signal 9606 has wider pulses, and therefore contains lower frequency components, a re-radiated signal due to 3π-pulse length control signal 9606 will have lower frequency components. Even if the lower frequency components are re-radiated, and then received and down-converted, the down-converted components should be out-of-band. In an embodiment, a $3\pi$-pulse length control signal 9606 configuration re-radiated at a 19 dB lower level than that of a $\pi$-pulse length control signal 9604.

Frequency components of potential re-radiation can be lowered more by further widening the control pulses. For example, FIG. 31 shows a $5\pi$-pulse length control signal 9608 with control signal pulses of a width of $5\pi$. $5\pi$-pulse length control signal 9608 includes pulses wider than those of $3\pi$-pulse length control signal 9606. Because of this, as described above, $5\pi$-pulse length control signal 9608 is made up of lower frequency signal components relative to $3\pi$-pulse length control signal 9606. Hence, relative to $3\pi$-pulse length control signal 9606, circuit re-radiation related to $5\pi$-pulse length control signal 9608 is of lower frequency.

A pulse width can be widened even more as would be understood by persons skilled in the relevant arts from the teachings herein. To what degree the pulse width may be widened will be determined on an application by application basis. The pulse width may be varied by whole increments of $\pi$, or any fraction thereof.

FIG. 36 depicts a flowchart 11400 that illustrates operational steps for down-converting an input signal with a variety of control signal pulse widths, according to an embodiment of the present invention. In the following discussion, the steps in FIG. 36 will be described.

In step 11402, an input signal is frequency down-converted with a universal frequency down-conversion module to a down-converted signal. The input signal is down-converted according to a control signal comprising a train of pulses having pulse widths.

In step 11404, a signal related to the control signal is re-radiated.

In step 11406, the pulse widths are increased to decrease a frequency of the re-radiated signal. In an embodiment, the pulse widths may be selected according to the equation: pulse width = 180 + 360 • n degrees of a frequency of said input signal, wherein n is any integer $\geq$ zero. As n is increased, a frequency of the re-radiated signal is decreased.

### 4.2.4.1.1 I/Q Modulation Receiver Control Signal Considerations and Embodiments

Design considerations exist for I/Q modulation receiver circuits in regard to control signals. The embodiments provided above for changing control signal pulse widths are applicable to I/Q modulation receiver circuits. However, when modifying control signal pulse widths in regards to I/Q modulation receiver circuits to overcome problems with re-radiation as described above, or other problems, certain design constraints may need to be considered. For instance, in some embodiments, such as described below, pulses of the I-phase control signal and pulses of the Q-phase control signal may not overlap, and must be configured such that they do not overlap to fulfill this requirement. In alternate embodiments, such as described below, an I/Q modulation receiver circuit may be configured such that I-phase and Q-phase control signals may overlap. Exemplary embodiments are provided below for overcoming at least some design constraints related to control signal pulses for I/Q modulation receiver circuits, according to the present invention.

### 4.2.4.1.1.1 Non-overlapping I/Q Control Signal Pulses Embodiments

FIG. 32 illustrates an exemplary I/Q modulation receiver circuit 9700, according to an embodiment of the present invention. I/Q modulation receiver circuit 9700 comprises a first UFD module 114a, a second UFD module 114b, a control signal generator 9706, and a phase shifter 9708. I/Q modulation circuit 9700 may use a variety of control signal configurations to down-convert I/Q modulated signals.

An input RF I/Q signal 9722 is received by first UFD module 114a. First UFD module 114a down-converts the I-phase signal portion of input RF I/Q signal 9722 according to a control signal 9728, which is output by control signal generator 9706. First UFD module 114a outputs an I output signal 9724.

In an embodiment, first UFD module 114a comprises a first UFT module 102a, a first storage module 9712, and a first voltage reference 9714.

Control signal 9728 is received by phase shifter 9708. In an I/Q modulation embodiment, phase shifter 9708 preferably shifts the phase of control signal 9728 by 90 degrees, although other phase shifts are possible. Phase shifter 9708 outputs phase-shifted control signal 9730.

Input RF I/Q signal 9722 is received by second UFD module 114b. Second UFD module 114b down-converts the Q-phase signal portion of input RF I/Q signal 9722 according to phase-shifted control signal 9730. Second UFD module 114b outputs a Q output signal 9726.

In an embodiment, second UFD module 114b comprises a second UFT module 102b, a second storage module 9718, and a second voltage reference 9720. First and second voltage references 9714 and 9720 may or may not be equal to the same voltage value.

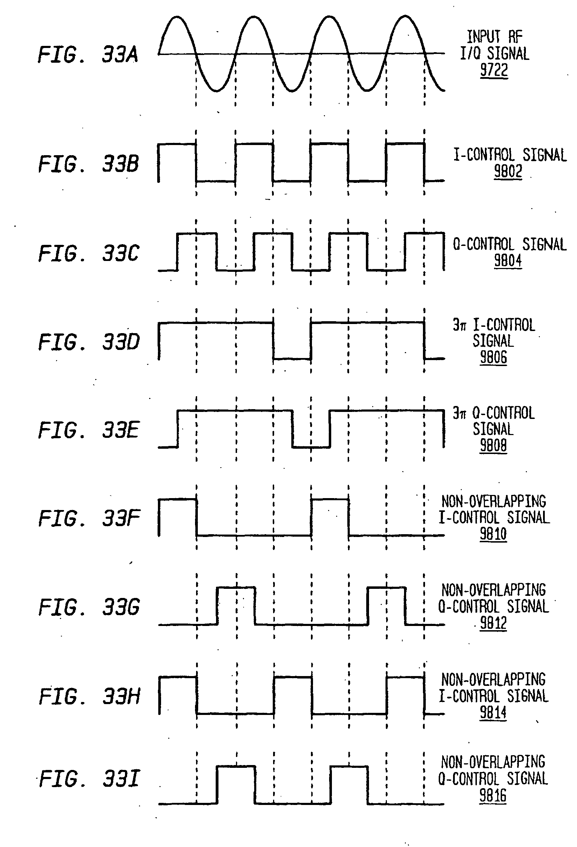

FIGS. 33A-33I shows an exemplary input RF I/Q signal 9722, and several exemplary control signal waveforms, which may be used to down-convert input RF I/Q signal 9722.

For example, an I-control signal 9802 is shown in FIG. 33B. I-control signal 9802 may be used to down-convert an I-phase signal portion of input RF I/Q signal 9722. A corresponding Q-control signal 9804 is shown in FIG. 33C. Q-control signal 9804 is output by phase shifter 9708. Q-control signal 9804 is shifted by 90 degrees from I-control signal 9802. Q-control signal 9804 may be used to down-convert a Q-phase signal portion of input RF I/Q signal 9722.

As illustrated in FIGS. 33B and 33C, pulses of I-control signal 9802 overlap the corresponding phase-shifted pulses of Q-control signal 9804. In some embodiments where first and second UFT modules 102a and 102b comprises switches, overlapping pulses of I-control signal 9802 and Q-control signal 9804 will cause the switches in first and second UFT modules 102a and 102b to be simultaneously closed during a period pulse of overlap. Due to the overlap, first and second UFD modules 114a and 114b may not be able to properly down-convert the I- and Q-phase components of input RF I/Q signal 9722. This is because during the period that switches inside the first and second UFD modules 114a and 114b are both closed, the switches will be attempting to transfer energy from input RF I/Q signal 9722 simultaneously. This may lead to non-negligible distortion of input RF I/Q signal 9722 in some embodiments. Hence, less than desirable input signal down-conversion accuracy may result.

In an another example, FIGS. 33D and 33E show a $3\pi$ I-control signal 9806 and a $3\pi$ Q-control signal 9808. Pulses of $3\pi$ I-control signal 9806 and $3\pi$ Q-control signal 9808 overlap. Using these control signals, in some embodiments first and second UFD modules 114a and 114b may not be able to properly down-convert the I- and Q-phase components of input RF I/Q signal 9722.

The overlap problem may be overcome by creating control signals with non-overlapping pulses. For example, FIGS. 33F and 33G show a non-overlapping I-control signal 9810 and a non-overlapping Q-control signal 9812. Pulses on non-overlapping I-control signal 9810 are separated by 720 degrees, and may be used to down-convert the I-phase signal component of input RF I/Q signal 9722. Pulses on non-overlapping Q-control signal 9812 are phased-shifted from pulses on non-overlapping I-control signal 9810 by 270 degrees, are separated from each other by 720 degrees, and may be used to down-convert the Q-phase signal component of input RF I/Q signal 9722.

In a further example, FIGS. 33H and 33I show a non-overlapping I-control signal 9814 and a non-overlapping Q-control signal 9816. Pulses on non-overlapping I-control signal 9814 are separated by 540 degrees, and may be used to down-convert the I-phase signal component of input RF I/Q signal 9722. (Note that when pulses on non-overlapping I-control signal 9814 are separated by 180 degrees, 540 degrees, 900 degrees, etc., the information down-converted on consecutive pulses may be inverted relative to one another, and hence an inverter may be required to correct for this.) Pulses on non-overlapping Q-control signal 9816 are phased-shifted from pulses on non-overlapping I-control signal 9814 by 270 degrees, are separated from each other by 540 degrees, and may be used to down-convert the Q-phase signal component of input RF I/Q signal 9722. (Note that when pulses on non-overlapping Q-control signal 9816 are separated by 180 degrees, 540 degrees, 900 degrees, etc., the information down-converted on consecutive pulses may be inverted relative to one another, and hence an inverter may be required to correct for this.)

Further control signal waveform configurations exist for implementing non-overlapping pulses, according to embodiments of the present invention, as would be recognized by persons skilled in the relevant art(s) from the teachings herein. I- and Q-control signal pulses may be widened, or made more narrow. I- and Q- control signal pulses may be made to occur further apart or closer together. A Q-control signal may be phase-shifted from a corresponding I-control signal by 90 degrees, 270 degrees, 450 degrees, 630 degrees, and so on, such that the I-control signal is matched with the I-phase input RF signal component, and the Q-control signal is matched with the Q-phase input RF signal component. Pulses on an I-phase control signal may be shifted from each other by any multiple of 180 (with one or more inverters possibly required, as described above) or 360 degrees. I- and Q-control signals may be formed to these requirements for use in I/Q modulation receiver circuit 9700 of FIG. 32, as long as their pulses do not overlap.

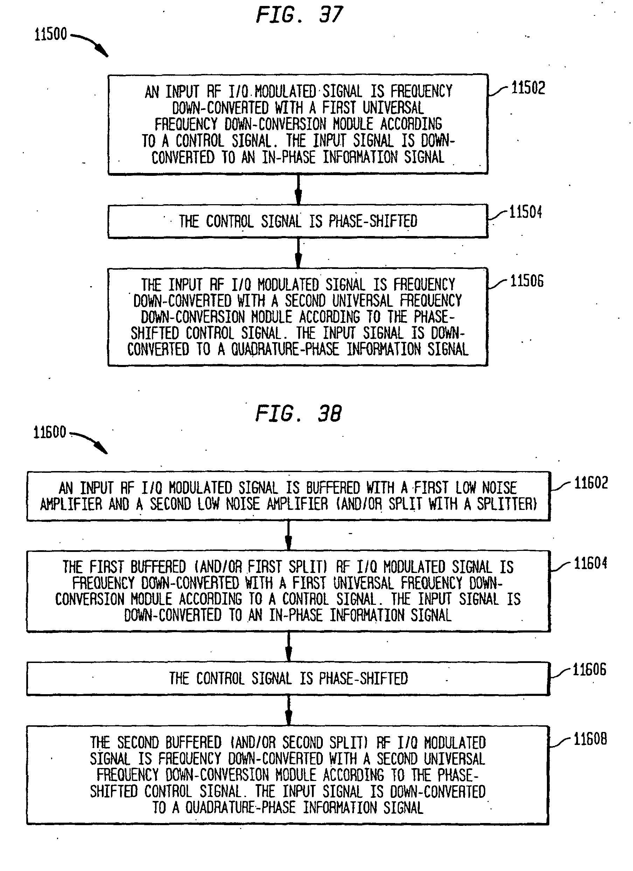

FIG. 37 depicts a flowchart 11500 that illustrates operational steps corresponding to the structure of FIG. 32, for down-converting an RF I/Q modulated input signal, according to an embodiment of the present invention. In the following discussion, the steps in FIG. 37 will be described.

In step 11502, an input RF I/Q modulated signal is frequency down-converted with a first universal frequency down-conversion module according to a control signal. The input signal is down-converted to an in-phase information signal. The control signal comprises a train of pulses. In an embodiment, the train of pulses are generated to have apertures approximately equal to 180 + 360 · n degrees of a frequency of said input RF I/Q modulated signal, wherein n is any integer greater than or equal to 0.

In step 11504, the control signal is phase-shifted. In embodiments, the control signal is phase-shifted by 90 degrees of a frequency of said input RF I/Q modulated signal. In alternative embodiments, the control signal may be shifted by 90 + in · 180 degrees, wherein m is any integer greater than or equal to 1. In embodiments, the control signal may be phase shifted such that pulses on the control signal do not overlap pulses on the phase-shifted control signal.

In step 11506, the input RF I/Q modulated signal is frequency down-converted with a second universal frequency down-conversion module according to the phase-shifted control signal. The input signal is down-converted to a quadrature-phase information signal.

### *4.2.4.1.1.2 Buffered I/Q Modulation Receiver Embodiment*

Exemplary embodiments are provide below for I/Q modulation receiver circuits where control signal pulses may overlap. Such embodiments may provide advantages where it is desirable to modify control signal pulse attributes as described above to solve problems with circuit re-radiation, and other problems.

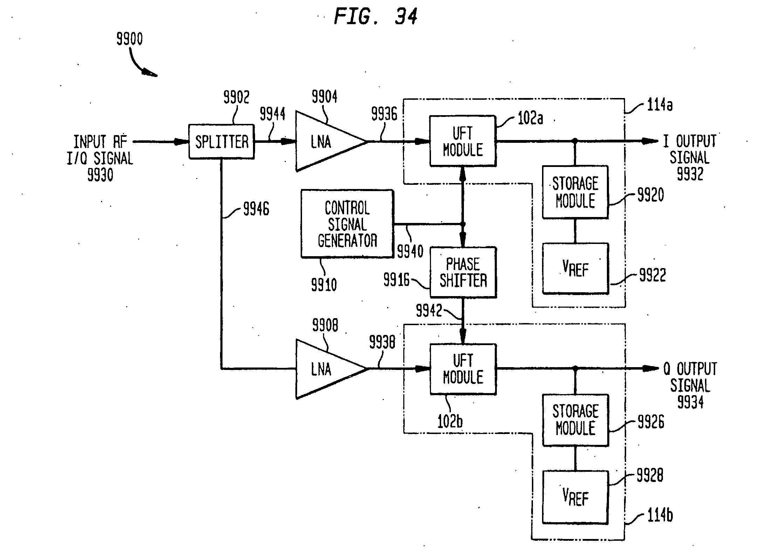

FIG. 34 illustrates an exemplary buffered I/Q modulation receiver circuit 9900, according to an embodiment of the present invention. Buffered I/Q modulation receiver circuit 9900 allows for overlapping I- and Q-control signal pulses such as I-control signal 9802 and Q-control signal 9804 of FIG. 33.

Buffered I/Q modulation receiver circuit 9900 comprises an optional splitter 9902, a first low noise amplifier (LNA) 9904, a second LNA 9908, a control signal generator 9910, a first UFD module 114a, a second UFD module 114b, and a phase shifter 9916. Buffered I/Q modulation receiver circuit 9900 is configured substantially similar to, and operates in a similar fashion to I/Q modulation receiver circuit 9700 of FIG. 32, with the addition of optional splitter 9902, first LNA 9904, and second LNA 9908.

Optional splitter 9902 optionally splits an input RF I/Q signal 9930, and outputs a first split input RF I/Q signal 9944 to first LNA 9904, and a second split input RF I/Q signal 9946 to second LNA 9908.

First LNA 9904 buffers and optionally amplifies first split input RF I/Q signal 9944, and outputs a first buffered input RF I/Q signal 9936.

Second LNA 9908 buffers and optionally amplifies second split input RF I/Q signal 9946, and outputs a second buffered input RF I/Q signal 9938.

First UFD module 114a receives first buffered input RF I/Q signal 9936. First UFD module 114a down-converts first buffered input RF I/Q signal 9936 according to a control signal 9940, which is output by control signal generator 9910. First UFD module 114a outputs I output signal 9932. In an embodiment, first UFD module 114a comprises a first UFT module 102a, a first storage module 9920, and a first voltage reference 9922.

Phase shifter 9916 receives control signal 9940, and outputs a phase-shifted control signal 9942. Phase-shifted control signal 9942 is preferably shifted by 90 degrees from control signal 9940, but may also be shifted by 270 degrees, 450 degrees, 630 degrees, and so on.

Second UFD module 114b receives second buffered input RF I/Q signal 9938. Second UFD module 114b down-converts second buffered input RF I/Q signal 9938 according to phase-shifted control signal 9942. Second UFD module 114b outputs Q output signal 9934. In an embodiment, second UFD module 114b comprises a second UFT module 102b, a second storage module 9926, and a second voltage reference 9928.

As described elsewhere herein, when first UFT module 102a transfers energy from first buffered input RF I/Q signal 9936, first buffered input RF I/Q signal 9936 will be distorted to some degree. Likewise, when second UFT module 102b transfers energy from second buffered input RF I/Q signal 9938, second buffered input RF I/Q signal 9938 will be distorted to some degree. First and second LNA 9904 and 9908 buffer the input RF I/Q signals entering first and second UFD modules 114a and 114b from input RF I/Q signal 9930. Hence, input RF I/Q signal 9930 will not be substantially distorted by energy transfer occurring in either of first and second UFD module 114a and 114b. Because of this, the I- and Q-control signals used to cause first and second UFD modules 114a and 114b to down-convert their respective input RF I/Q signals may have overlapping I- and Q- pulses. Hence, for example, control signal 9940 may appear as I-control signal 9802 of FIG. 33, and phase-shifted control signal 9942 may appear as Q-control signal 9804, phase-shifted by 90 degrees from, and having pulses overlapping with, control signal 9940. It is noted that the invention is not limited to the example of FIG. 34. Other components to buffer or isolate first and second UFT modules 102a, 102b from each other could alternatively be used.

FIG. 38 depicts a flowchart 11600 that illustrates operational steps corresponding to the structure of FIG. 34, for down-converting an RF I/Q modulated input signal, according to an embodiment of the present invention. In the following discussion, the steps in FIG. 38 will be described.

In step 11602, an input RF I/Q modulated signal is buffered with a first low noise amplifier and a second low noise amplifier. In an alternative embodiment, instead of or in addition to buffering the input RF I/Q modulated signal as just described, the input RF I/Q modulated signal may be split into a first split RF I/Q modulated signal and a second split RF I/Q modulated signal.

In step 11604, the first buffered (and/or first split) RF I/Q modulated signal is frequency down-converted with a first universal frequency down-conversion module according to a control signal. The input signal is down-converted to an in-phase information signal. The control signal comprises a train of pulses. In an embodiment, the train of pulses are generated to have apertures approximately equal to 180 + 360 • n degrees of a frequency of said input RF I/Q modulated signal, wherein n is any integer greater than or equal to 0.

In step 11606, the control signal is phase-shifted. In embodiments, the control signal is phase-shifted by 90 + m • 180 degrees of a frequency of said input RF I/Q modulated signal, wherein m is any integer greater than or equal to 0. In embodiments, the control signal may be phase shifted such that pulses on the control signal overlap pulses on the phase-shifted control signal.

In step 11608, the second buffered (and/or second split) RF I/Q modulated signal is frequency down-converted with a second universal frequency down-conversion module according to the phase-shifted control signal. The input signal is down-converted to a quadrature-phase information signal.

### 4.2.5 Example I/Q Modulation Receiver Embodiments

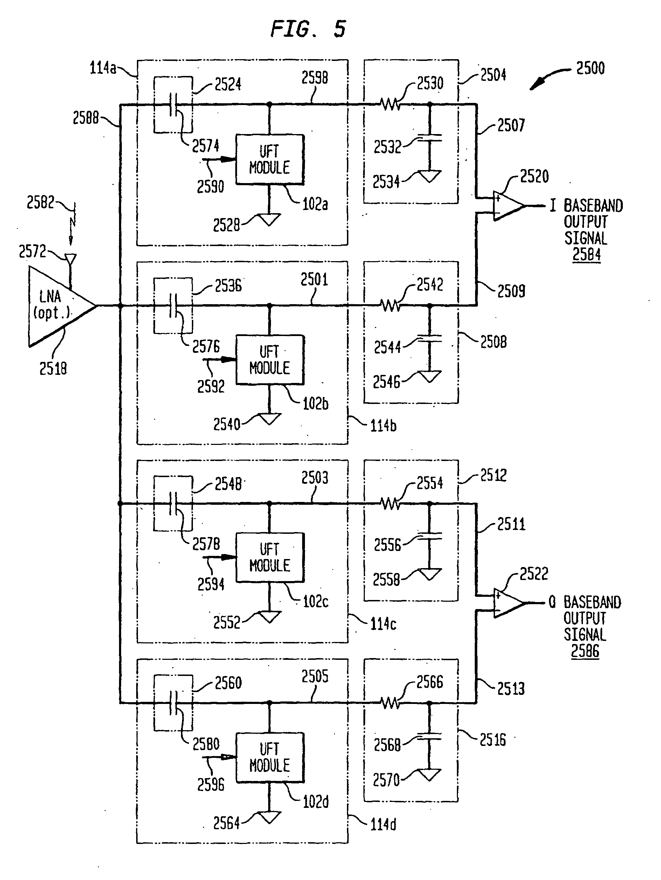

FIG. 5 illustrates an exemplary I/Q modulation receiver 2500, according to an embodiment of the present invention. I/Q modulation receiver 2500 has additional advantages of reducing or eliminating unwanted DC offsets and circuit re-radiation.

I/Q modulation receiver 2500 comprises a first UFD module 114a, a first optional filter 2504, a second UFD module 114b, a second optional filter 2508, a third UFD module 114c, a third optional filter 2512, a fourth UFD module 114d, a fourth filter 2516, an optional LNA 2518, a first differential amplifier 2520, a second differential amplifier 2522, and an antenna 2572.

I/Q modulation receiver 2500 receives, down-converts, and demodulates a I/Q modulated RF input signal 2582 to an I baseband output signal 2584, and a Q baseband output signal 2586. I/Q modulated RF input signal 2582 comprises a first information signal and a second information signal that are I/Q modulated onto an RF carrier signal. I baseband output signal 2584 comprises the first baseband information signal. Q baseband output signal 2586 comprises the second baseband information signal.

Antenna 2572 receives I/Q modulated RF input signal 2582. I/Q modulated RF input signal 2582 is output by antenna 2572 and received by optional LNA 2518. When present, LNA 2518 amplifies I/Q modulated RF input signal 2582, and outputs amplified I/Q signal 2588.

First UFD module 114a receives amplified I/Q signal 2588. First UFD module 114a down-converts the I-phase signal portion of amplified input I/Q signal 2588 according to an I control signal 2590. First UFD module 114a outputs an I output signal 2598.

In an embodiment, first UFD module 114a comprises a first storage module 2524, a first UFT module 102a, and a first voltage reference 2528. In an embodiment, a switch contained within first UFT module 102a opens and closes as a function of I control signal 2590. As a result of the opening and closing of this switch, which respectively couples and de-couples first storage module 2524 to and from first voltage reference 2528, a down-converted signal, referred to as I output signal 2598, results. First voltage reference 2528 may be any reference voltage, and is preferably ground. I output signal 2598 is stored by first storage module 2524.

In a preferred embodiment, first storage module 2524 comprises a first capacitor 2574. In addition to storing I output signal 2598, first capacitor 2574 reduces or prevents a DC offset voltage resulting from above described charge injection from appearing on I output signal 2598, in a similar fashion to that of capacitor 9126 shown in FIG. 30. Refer to section 4.2.3 above for further discussion on reducing or eliminating charge injection with a series capacitor such as capacitor 9126.

I output signal 2598 is received by optional first filter 2504. When present, first filter 2504 is a high pass filter to at least filter I output signal 2598 to remove any carrier signal "bleed through". In a preferred embodiment, when present, first filter 2504 comprises a first resistor 2530, a first filter capacitor 2532, and a first filter voltage reference 2534. Preferably, first resistor 2530 is coupled between I output signal 2598 and a filtered I output signal 2507, and first filter capacitor 2532 is coupled between filtered I output signal 2507 and first filter voltage reference 2534. Alternately, first filter 2504 may comprise any other applicable filter configuration as would be understood by persons skilled in the relevant art(s). First filter 2504 outputs filtered I output signal 2507.

Second UFD module 114b receives amplified I/Q signal 2588. Second UFD module 114b down-converts the inverted I-phase signal portion of amplified input I/Q signal 2588 according to an inverted I control signal 2592. Second UFD module 114b outputs an inverted I output signal 2501.

In an embodiment, second UFD module 114b comprises a second storage module 2536, a second UFT module 102b, and a second voltage reference 2540. In an embodiment, a switch contained within second UFT module 102b opens and closes as a function of inverted I control signal 2592. As a result of the opening and closing of this switch, which respectively couples and de-couples second storage module 2536 to and from second voltage reference 2540, a down-converted signal, referred to as inverted I output signal 2501, results. Second voltage reference 2540 may be any reference voltage, and is preferably ground. Inverted I output signal 2501 is stored by second storage module 2536.

In a preferred embodiment, second storage module 2536 comprises a second capacitor 2576. In addition to storing inverted I output signal 2501, second capacitor 2576 reduces or prevents a DC offset voltage resulting from above described charge injection from appearing on inverted I output signal 2501, in a similar fashion to that of capacitor 9126 shown in FIG. 30. Refer to section 4.2.3 above for further discussion on reducing or eliminating charge injection with a series capacitor such as capacitor 9126.

Inverted I output signal 2501 is received by optional second filter 2508. When present, second filter 2508 is a high pass filter to at least filter inverted I output signal 2501 to remove any carrier signal "bleed through". In a preferred embodiment, when present, second filter 2508 comprises a second resistor 2542, a second filter capacitor 2544, and a second filter voltage reference 2546. Preferably, second resistor 2542 is coupled between inverted I output signal 2501 and a filtered inverted I output signal 2509, and second filter capacitor 2544 is coupled between filtered inverted I output signal 2509 and second filter voltage reference 2546. Alternately, second filter 2508 may comprise any other applicable filter configuration as would be understood by persons skilled in the relevant art(s). Second filter 2508 outputs filtered inverted I output signal 2509.

First differential amplifier 2520 receives filtered I output signal 2507 at its non-inverting input and receives filtered inverted I output signal 2509 at its inverting input. First differential amplifier 2520 subtracts filtered inverted I output signal 2509 from filtered I output signal 2507, amplifies the result, and outputs I baseband output signal 2584. Other suitable subtractor and/or amplification modules maybe substituted for first differential amplifier 2520, and second differential amplifier 2522, as would be understood by persons skilled in the relevant art(s) from the teachings herein. Because filtered inverted I output signal 2509 is substantially equal to an inverted version of filtered I output signal 2507, I baseband output signal 2584 is substantially equal to filtered I output signal 2509, with its amplitude doubled.

Furthermore, filtered I output signal 2507 and filtered inverted I output signal 2509 may comprise substantially equal noise and DC offset contributions of the same polarity from prior down-conversion circuitry, including first UFD module 114a and second UFD module 114b, respectively. When first differential amplifier 2520 subtracts filtered inverted I output signal 2509 from filtered I output signal 2507, these noise and DC offset contributions substantially cancel each other.

Third UFD module 114c receives amplified I/Q signal 2588. Third UFD module 114c down-converts the Q-phase signal portion of amplified input I/Q signal 2588 according to an Q control signal 2594. Third UFD module 114c outputs an Q output signal 2503.

In an embodiment, third UFD module 114c comprises a third storage module 2548, a third UFT module 102c, and a third voltage reference 2552. In an embodiment, a switch contained within third UFT module 102c opens and closes as a function of Q control signal 2594. As a result of the opening and closing of this switch, which respectively couples and de-couples third storage module 2548 to and from third voltage reference 2552, a down-converted signal, referred to as Q output signal 2503, results. Third voltage reference 2552 may be any reference voltage, and is preferably ground. Q output signal 2503 is stored by third storage module 2548.

In a preferred embodiment, third storage module 2548 comprises a third capacitor 2578. In addition to storing Q output signal 2503, third capacitor 2578 reduces or prevents a DC offset voltage resulting from above described charge injection from appearing on Q output signal 2503, in a similar fashion to that of capacitor 9126 shown in FIG. 30. Refer to section 4.2.3 above for further discussion on reducing or eliminating charge injection with a series capacitor such as capacitor 9126.

Q output signal 2503 is received by optional third filter 2512. When present, third filter 2512 is a high pass filter to at least filter Q output signal 2503 to remove any carrier signal "bleed through". In a preferred embodiment, when present, third filter 2512 comprises a third resistor 2554, a third filter capacitor 2558, and a third filter voltage reference 2558. Preferably, third resistor 2554 is coupled between Q output signal 2503 and a filtered Q output signal 2511, and third filter capacitor 2556 is coupled between filtered Q output signal 2511 and third filter voltage reference 2558. Alternately, third filter 2512 may comprise any other applicable filter configuration as would be understood by persons skilled in the relevant art(s). Third filter 2512 outputs filtered Q output signal 2511.

Fourth UFD module 114d receives amplified I/Q signal 2588. Fourth UFD module 114d down-converts the inverted Q-phase signal portion of amplified input I/Q signal 2588 according to an inverted Q control signal 2596. Fourth UFD module 114d outputs an inverted Q output signal 2505.

In an embodiment, fourth UFD module 114d comprises a fourth storage module 2560, a fourth UFT module 102d, and a fourth voltage reference 2564. In an embodiment, a switch contained within fourth UFT module 102d opens and closes as a function of inverted Q control signal 2596. As a result of the opening and closing of this switch, which respectively couples and de-couples fourth storage module 2560 to and from fourth voltage reference 2564, a down-converted signal, referred to as inverted Q output signal 2505, results. Fourth voltage reference 2564 may be any reference voltage, and is preferably ground. Inverted Q output signal 2505 is stored by fourth storage module 2560.

In a preferred embodiment, fourth storage module 2560 comprises a fourth capacitor 2580. In addition to storing inverted Q output signal 2505, fourth capacitor 2580 reduces or prevents a DC offset voltage resulting from above described charge injection from appearing on inverted Q output signal 2505, in a similar fashion to that of capacitor 9126 shown in FIG. 30. Refer to section 4.2.3 above for further discussion on reducing or eliminating charge injection with a series capacitor such as capacitor 9126.

Inverted Q output signal 2505 is received by optional fourth filter 2516. When present, fourth filter 2516 is a high pass filter to at least filter inverted Q output signal 2505 to remove any carrier signal "bleed through". In a preferred embodiment, when present, fourth filter 2516 comprises a fourth resistor 2566, a fourth filter capacitor 2568, and a fourth filter voltage reference 2570. Preferably, fourth resistor 2566 is coupled between inverted Q output signal 2505 and a filtered inverted Q output signal 2513, and fourth filter capacitor 2568 is coupled between filtered inverted Q output signal 2513 and fourth filter voltage reference 2570. Alternately, fourth filter 2516 may comprise any other applicable filter configuration as would be understood by persons skilled in the relevant art(s). Fourth filter 2516 outputs filtered inverted Q output signal 2513.

Second differential amplifier 2522 receives filtered Q output signal 2511 at its non-inverting input and receives filtered inverted Q output signal 2513 at its inverting input. Second differential amplifier 2522 subtracts filtered inverted Q output signal 2513 from filtered Q output signal 2511, amplifies the result, and outputs Q baseband output signal 2586. Because filtered inverted Q output signal 2513 is substantially equal to an inverted version of filtered Q output signal 2511, Q baseband output signal 2586 is substantially equal to filtered Q output signal 2513, with its amplitude doubled. Furthermore, filtered Q output signal 2511 and filtered inverted Q output signal 2513 may comprise substantially equal noise and DC offset contributions of the same polarity from prior down-conversion circuitry, including third UFD module 114c and fourth UFD module 114d, respectively. When second differential amplifier 2522 subtracts filtered inverted Q output signal 2513 from filtered Q output signal 2511, these noise and DC offset contributions substantially cancel each other.

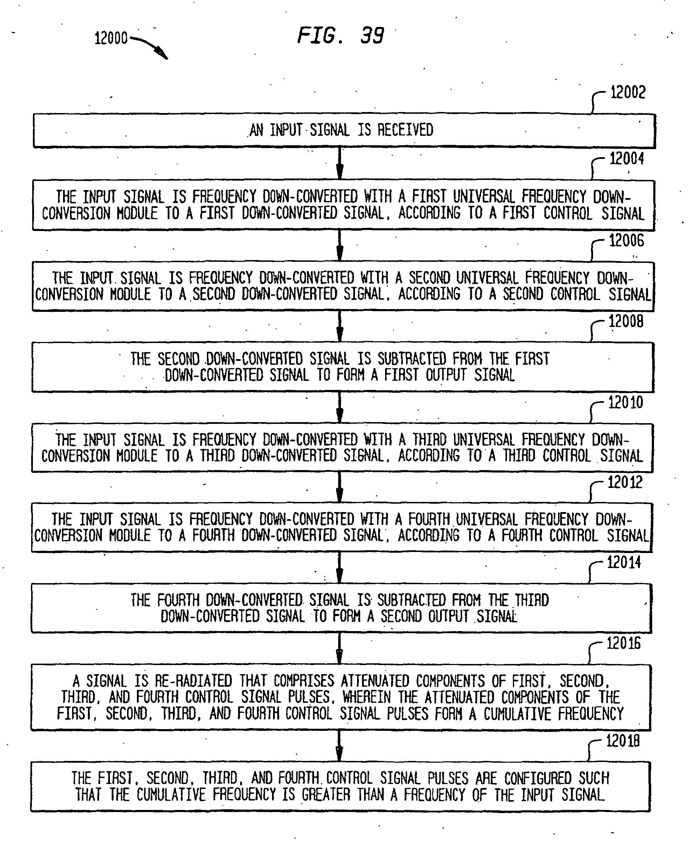

FIG. 39 depicts a flowchart 12000 that illustrates operational steps corresponding to FIG. 5, for down-converting a RF I/Q modulated signal and reducing DC offset voltages, according to an embodiment of the present invention. In the following discussion, the steps in FIG. 39 will be described.

In step 12002, an input signal is received, wherein the input signal comprises an RF I/Q modulated signal.

In step 12004, the input signal is frequency down-converted with a first universal frequency down-conversion module to a first down-converted signal, according to a first control signal. In an embodiment, the input signal is frequency down-converted to a non-inverted I-phase signal portion of the RF I/Q modulated signal. For instance, in an embodiment, a first phase of the in-phase signal portion of the RF I/Q modulated signal is under-sampled. In an embodiment, the RF I/Q modulated signal may be under-sampled every 3.0 cycles of a frequency of the RF I/Q modulated signal by the first control signal. Furthermore, in embodiments, a first DC offset voltage in the first down-converted signal is reduced by a capacitor of the first universal frequency down-conversion module.

In step 12006, the input signal is frequency down-converted with a second universal frequency down-conversion module to a second down-converted signal, according to a second control signal. In an embodiment, the input signal is frequency down-converted to an inverted I-phase signal portion of the RF I/Q modulated signal. For instance, in an embodiment, a second phase of the in-phase signal portion of the RF I/Q modulated signal is under-sampled, wherein the second phase of the in-phase signal portion is of an opposite phase to the first phase under-sampled of the in-phase signal portion. The RF I/Q modulated signal may be sampled 1.5 cycles of a frequency of the RF I/Q modulated signal after under-sampling the RF I/Q modulated signal in step 12004, for example. Furthermore, in embodiments, a second DC offset voltage in the second down-converted signal is reduced by a capacitor of the second universal frequency down-conversion module.

In step 12008, the second down-converted signal is subtracted from the first down-converted signal to form a first output signal. In embodiments, a first DC offset voltage in the first down-converted signal and a second DC offset voltage in the second down-converted signal cancel one another.

In step 12010, the input signal is frequency down-converted with a third universal frequency down-conversion module to a third down-converted signal, according to a third control signal. In an embodiment, the input signal is frequency down-converted to a non-inverted Q-phase signal portion of the RF I/Q modulated signal. For instance, in an embodiment, a third phase of the quadrature-phase signal portion ofthe RF I/Q modulated signal is under-sampled. The RF I/Q modulated signal maybe under-sampled .75 cycles of the frequency of the RF I/Q modulated signal after under-sampling of the RF I/Q modulated signal occurs in step 12004, for example. Furthermore, in embodiments, a third DC offset voltage in the third down-converted signal is reduced by a capacitor of the third universal frequency down-conversion module.

In step 12012, the input signal is frequency down-converted with a fourth universal frequency down-conversion module to a fourth down-converted signal, according to a fourth control signal. In an embodiment, the input signal is frequency down-converted to an inverted Q-phase signal portion of the RF I/Q modulated signal. For instance, in an embodiment, a fourth phase of the quadrature-phase signal portion of the RF I/Q modulated signal is under-sampled, wherein the fourth phase of the quadrature-phase signal portion is of an opposite phase to the third phase under-sampled of the quadrature-phase signal portion. In an embodiment, the RF I/Q modulated signal may be sampled 1.5 cycles of the frequency of the RF I/Q modulated signal after under-sampling of the RF I/Q modulated signal occurs in step 12010, for example. Furthermore, in embodiments, a fourth DC offset voltage in the fourth down-converted signal is reduced by a capacitor of fourth universal frequency down-conversion module.

In step 12014, the fourth down-converted signal is subtracted from the third down-converted signal to form a second output signal. In embodiments, a third DC offset voltage in the third down-converted signal and a fourth DC offset voltage in the fourth down-converted signal cancel one another.

In step 12016, a signal is re-radiated that comprises attenuated components of first, second, third, and fourth control signal pulses, wherein the attenuated components of the first, second, third, and fourth control signal pulses form a cumulative frequency, as will be discussed in more detail below.

In step 12018, the first, second, third, and fourth control signal pulses are configured such that the cumulative frequency is greater than a frequency of the input signal, as will be discussed in more detail below.

### *4.2.5.1 Example I/Q Modulation Control Signal Generator Embodiments*

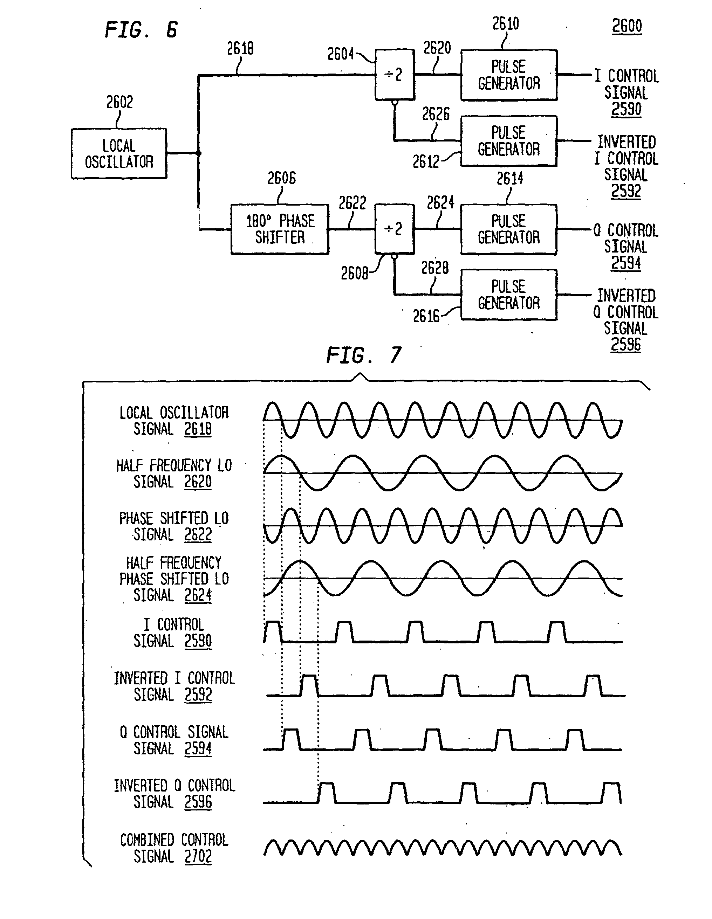

FIG. 6 illustrates an exemplary block diagram for I/Q modulation control signal generator 2600, according to an embodiment of the present invention. I/Q modulation control signal generator 2600 generates I control signal 2590, inverted I control signal 2592, Q control signal 2594, and inverted Q control signal 2596 used by I/Q modulation receiver 2500 of FIG. 5. I control signal 2590 and inverted I control signal 2592 operate to down-convert the I-phase portion of an input I/Q modulated RF signal. Q control signal 2594 and inverted Q control signal 2596 act to down-convert the Q-phase portion of the input I/Q modulated RF signal. Furthermore, I/Q modulation control signal generator 2600 has the advantage of generating control signals in a manner such that resulting collective circuit re-radiation is radiated at one or more frequencies outside of the frequency range of interest. For instance, potential circuit re-radiation is radiated at a frequency substantially greater than that of the input RF carrier signal frequency.

I/Q modulation control signal generator 2600 comprises a local oscillator 2602, a first divide-by-two module 2604, a 180 degree phase shifter 2606, a second divide-by-two module 2608, a first pulse generator 2610, a second pulse generator 2612, a third pulse generator 2614, and a fourth pulse generator 2616.

Local oscillator 2602 outputs an oscillating signal 2618. FIG. 7 shows an exemplary oscillating signal 2618.

First divide-by-two module 2604 receives oscillating signal 2618, divides oscillating signal 2618 by two, and outputs a half frequency LO signal 2620 and a half frequency inverted LO signal 2626. FIG. 7 shows an exemplary half frequency LO signal 2620. Half frequency inverted LO signal 2626 is an inverted version of half frequency LO signal 2620. First divide-by-two module 2604 may be implemented in circuit logic, hardware, software, or any combination thereof, as would be known by persons skilled in the relevant art(s).

180 degree phase shifter 2606 receives oscillating signal 2618, shifts the phase of oscillating signal 2618 by 180 degrees, and outputs phase-shifted LO signal 2622. 180 degree phase shifter 2606 may be implemented in circuit logic, hardware, software, or any combination thereof, as would be known by persons skilled in the relevant art(s). In alternative embodiments, other amounts of phase shift may be used.

Second divide-by two module 2608 receives phase-shifted LO signal 2622, divides phase-shifted LO signal 2622 by two, and outputs a half frequency phase-shifted LO signal 2624 and a half frequency inverted phase-shifted LO signal 2628. FIG. 7 shows an exemplary half frequency phase-shifted LO signal 2624. Half frequency inverted phase-shifted LO signal 2628 is an inverted version of half frequency phase-shifted LO signal 2624. Second divide-by-two module 2608 may be implemented in circuit logic, hardware, software, or any combination thereof, as would be known by persons skilled in the relevant art(s).

First pulse generator 2610 receives half frequency LO signal 2620, generates an output pulse whenever a rising edge is received on half frequency LO signal 2620, and outputs I control signal 2590. FIG. 7 shows an exemplary I control signal 2590.

Second pulse generator 2612 receives half frequency inverted LO signal 2626, generates an output pulse whenever a rising edge is received on half frequency inverted LO signal 2626, and outputs inverted I control signal 2592. FIG. 7 shows an exemplary inverted I control signal 2592.

Third pulse generator 2614 receives half frequency phase-shifted LO signal 2624, generates an output pulse whenever a rising edge is received on half frequency phase-shifted LO signal 2624, and outputs Q control signal 2594. FIG. 7 shows an exemplary Q control signal 2594.

Fourth pulse generator 2616 receives half frequency inverted phase-shifted LO signal 2628, generates an output pulse whenever a rising edge is received on half frequency inverted phase-shifted LO signal 2628, and outputs inverted Q control signal 2596. FIG. 7 shows an exemplary inverted Q control signal 2596.

In a preferred embodiment, control signals 2590, 2592, 2594 and 2596 output pulses having a width equal to one-half of a period of I/Q modulated RF input signal 2582. The invention, however, is not limited to these pulse widths, and control signals 2590, 2592, 2594, and 2596 may comprise pulse widths of any fraction of, or multiple and fraction of, a period of I/Q modulated RF input signal 2582.

First, second, third, and fourth pulse generators 2610, 2612, 2614, and 2616 may be implemented in circuit logic, hardware; software, or any combination thereof, as would be known by persons skilled in the relevant art(s).

As shown in FIG. 7, control signals 2590, 2592, 2594, and 2596 comprise pulses that are non-overlapping. Furthermore, in this example, pulses appear on these signals in the following order: I control signal 2590, Q control signal 2594, inverted I control signal 2592, and inverted Q control signal 2596. Potential circuit re-radiation from I/Q modulation receiver 2500 may comprise frequency components from a combination of these control signals.

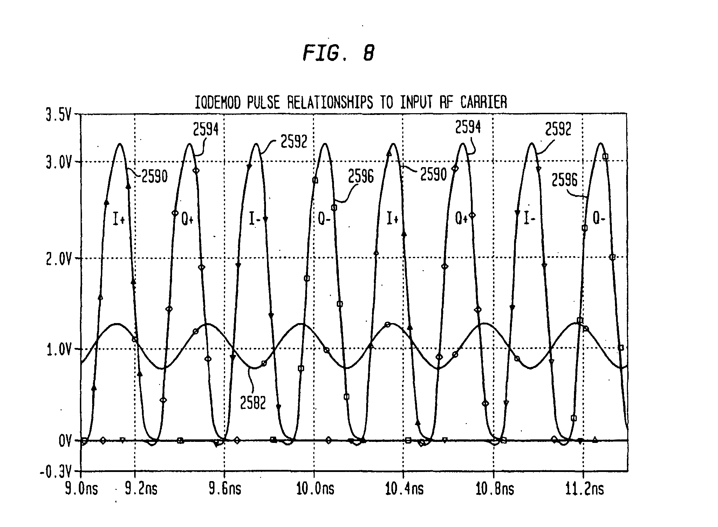

For example, FIG. 8 shows an overlay of pulses from I control signal 2590, Q control signal 2594, inverted I control signal 2592, and inverted Q control signal 2596. When pulses from these control signals leak to through first; second, third, and fourth UFD modules 114a, 114b, 114c, and 114d of to antenna 2582 (shown in FIG. 5), they may be radiated from I/Q modulation receiver 2500, with a combined waveform that appears to have a primary frequency equal to four times the frequency of any single one of control signals 2590, 2592, 2594, and 2596. FIG. 7 shows an example combined control signal 2702.

FIG. 8 also shows an example I/Q modulation RF input signal 2582 overlaid upon control signals 2590, 2592, 2594, and 2596. As shown in FIG. 8, pulses on I control signal 2590 overlay and act to down-convert a positive I-phase portion of I/Q modulation RF input signal 2582. Pulses on inverted I control signal 2592 overlay and act to down-convert a negative I-phase portion of I/Q modulation RF input signal 2582. Pulses on Q control signal 2594 overlay and act to down-convert a rising Q-phase portion of I/Q modulation RF input signal 2582. Pulses on inverted Q control signal 2596 overlay and act to down-convert a falling Q-phase portion of I/Q modulation RF input signal 2582.

As FIG. 8 further shows in this example, the frequency ratio between the combination of control signals 2590, 2592, 2594, and 2596 and I/Q modulation RF input signal 2582 is 4:3. Because the frequency of the potentially re-radiated signal, combined control signal 2702, is substantially different from that of the signal being down-converted, I/Q modulation RF input signal 2582, it does not interfere with signal down-conversion as it is out of the frequency band of interest, and hence may be filtered out. In this manner, I/Q modulation receiver 2500 reduces problems due to circuit re-radiation. As will be understood by persons skilled in the relevant art(s) from the teachings herein, frequency ratios other than 4:3 may be implemented to achieve similar reduction of problems of circuit re-radiation.

### 4.2.5.2 Detailed Example I/Q Modulation Receiver Embodiment with Exemplary Waveforms

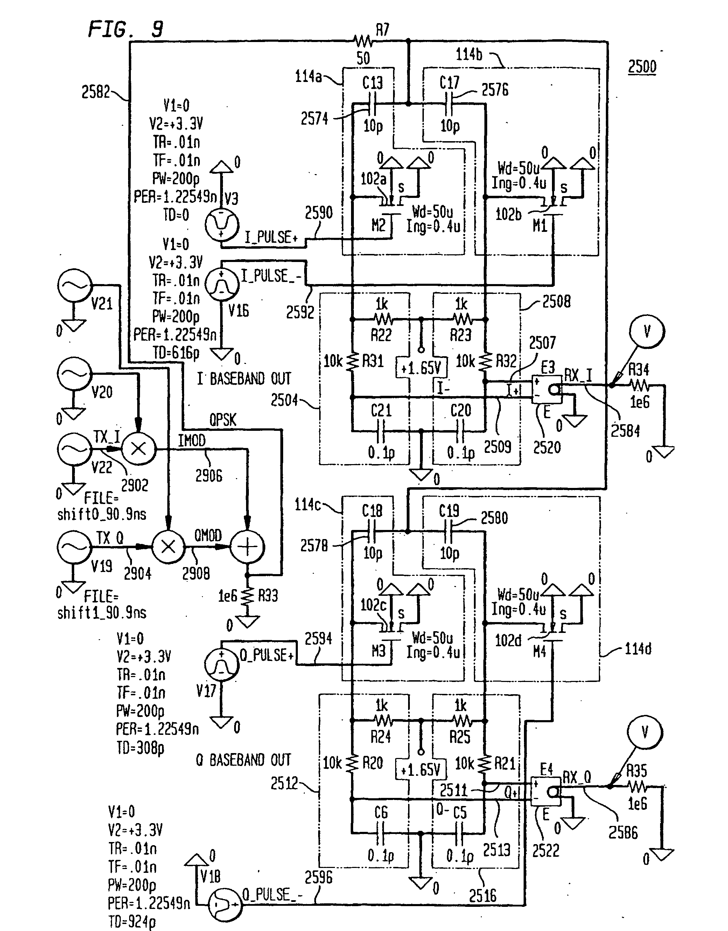

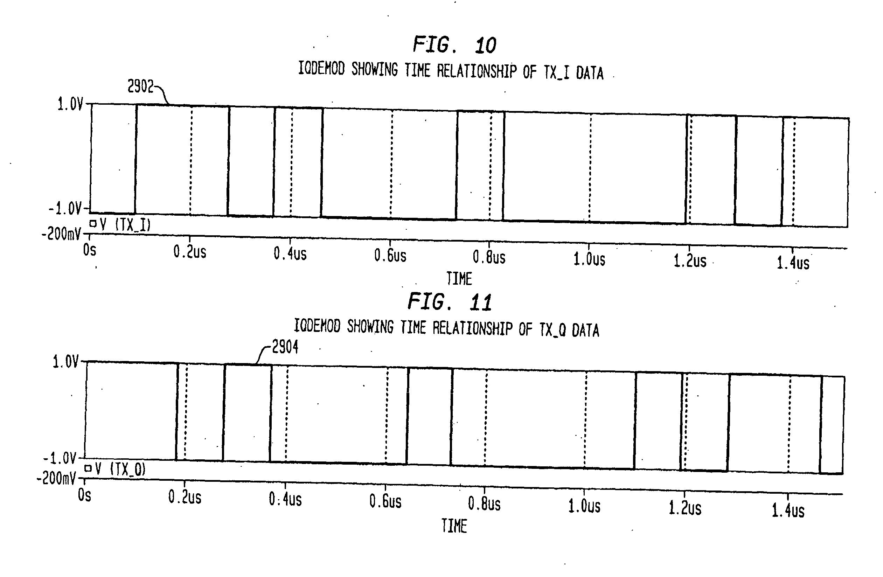

FIG. 9 illustrates a more detailed example circuit implementation of I/Q modulation receiver 2500, according to an embodiment of the present invention. FIGS. 10-20 show waveforms related to an example implementation of I/Q modulation receiver 2500 of FIG. 9.

FIGS. 10 and 11 show first and second input data signals 2902 and 2904 to be I/Q modulated with a RF carrier signal frequency as the I-phase and Q-phase information signals, respectively.

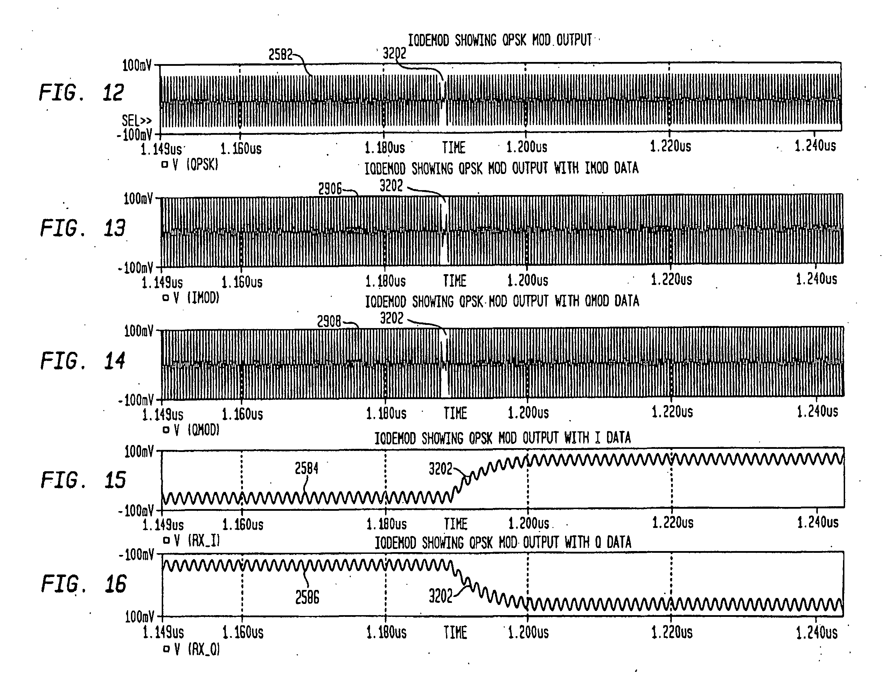

FIGS. 13 and 14 show the signals of FIG. 10 and 11 after modulation with a RF carrier signal frequency, respectively, as I-modulated signal 2906 and Q-modulated signal 2908.

FIG. 12 shows an I/Q modulation RF input signal 2582 formed from I-modulated signal 2906 and Q-modulated signal 2908 of FIGS. 13 and 14, respectively.

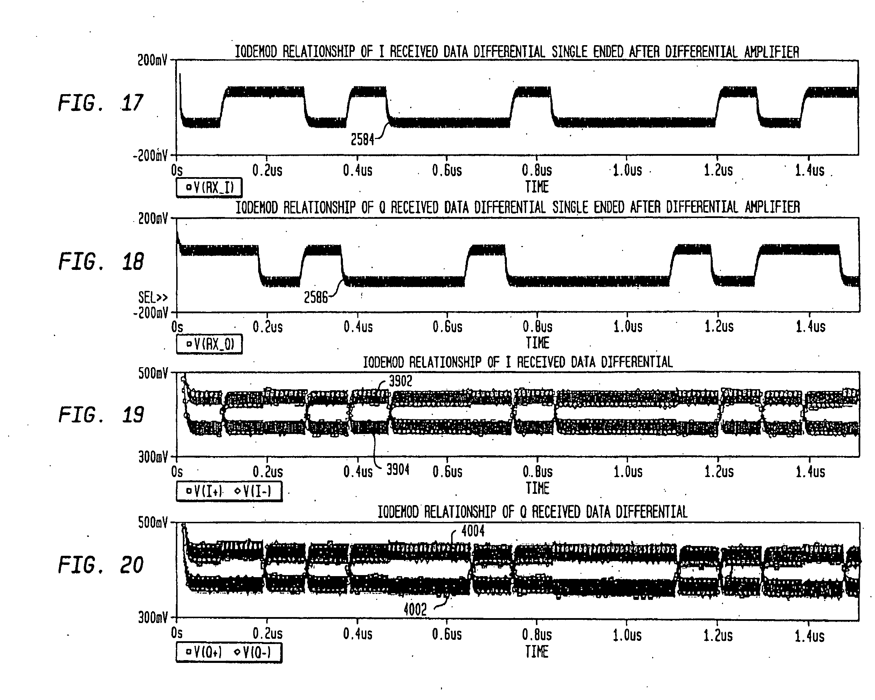

FIG. 19 shows an overlaid view of filtered I output signal 3902 and filtered inverted I output signal 3904.

FIG. 20 shows an overlaid view of filtered Q output signal 4002 and filtered inverted Q output signal 4004.

FIGS. 15 and 16 show I baseband output signal 2584 and Q baseband output signal 2586, respectfully. A data transition 3202 is indicated in both I baseband output signal 2584 and Q baseband output signal 2586. The corresponding data transition 3202 is indicated in I-modulated signal 2906 of FIG. 13, Q-modulated signal 2908 of FIG. 14, and I/Q modulation RF input signal 2582 of FIG. 12.

FIGS. 17 and 18 show I baseband output signal 2584 and Q baseband output signal 2586 over a wider time interval.

### 4.2.5.3 Example Single Channel Receiver Embodiment

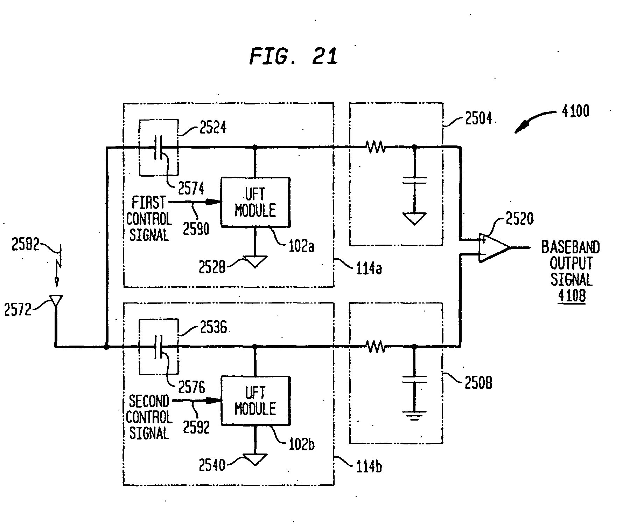

FIG. 21 illustrates an exemplary single channel receiver 4100, corresponding to either the I or Q channel of I/Q modulation receiver 2500, according to an embodiment of the present invention. Single channel receiver 4100 can down-convert an input RF signal 2582 modulated according to AM, PM, FM, and other modulation schemes. Refer to section 4.2.5 above for further description on the operation of single channel receiver 4100.

### 4.2.5.4 Alternative Example I/Q Modulation Receiver Embodiment

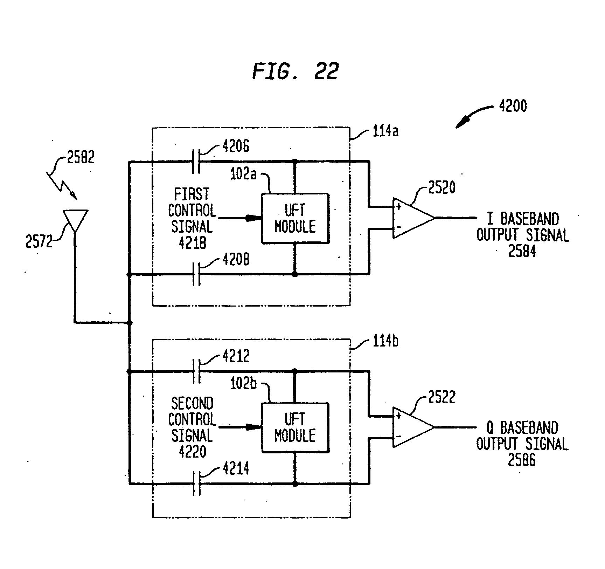

FIG. 22 illustrates an exemplary I/Q modulation receiver 4200, according to an embodiment of the present invention. I/Q modulation receiver 4200 receives, down-converts, and demodulates an I/Q modulated RF input signal 2582 to an I baseband output signal 2584, and a Q baseband output signal 2586. I/Q modulation receiver 4200 has additional advantages of reducing or eliminating unwanted DC offsets and circuit re-radiation, in a similar fashion to that of I/Q modulation receiver 2500 described above.

### 5. Conclusion

While various embodiments of the present invention have been described above, it should be understood that they have been presented by way of example only, and not limitation. It will be apparent to persons skilled in the relevant art that various changes in form and detail can be made therein without departing from the scope of the invention. Thus, the breadth and scope of the present invention should not be limited by any of the above-described exemplary embodiments, but should be defined only in accordance with the following claims.

**Claims**

1. An apparatus for down-converting an electromagnetic signal and reducing DC offset voltages, comprising:

   a first frequency down-conversion module (114a) that receives an input signal (2582), down-converts said input signal (2582) according to a first control signal (2590), and outputs a first down-converted signal (2507), wherein said first frequency down-conversion module (114a) contributes a first DC offset voltage to said first down-converted signal (2507);
   a second frequency down-conversion module (114b) that receives said input signal (2582), down-converts said input signal (2582) according to a second control signal (2592) that is phase-shifted with respect to said first control signal (2590) by 180° + n × 360°, wherein these degrees are phase degrees of said input signal, where n is an integer greater than or equal to 0, and outputs a second down-converted signal (2509), wherein said second frequency down-conversion module (114b) contributes a second DC offset voltage to said second down-converted signal (2509); and
   a first subtractor module (2520) that subtracts said second down-converted signal (2509) from said first down-converted signal (2507) and outputs a first channel down-converted signal (2584), said first channel down-converted signal (2584) having a DC offset component that comprises a difference between said first DC offset voltage and said second DC offset voltage;

   wherein said first and said second frequency down-conversion modules (114a, 114b) each comprise a switch (102a, 102b) and a storage element (2524, 2536).

2. The apparatus of claim 1, wherein said input signal (2582) is aRF carrier signal that is AM, FM, or PM modulated with an information signal.

3. The apparatus of claim 2, wherein said first channel down-converted signal (2584) is a baseband signal.

4. The apparatus of claim 2, wherein said first channel down-converted signal (2584) is an intermediate frequency signal.

5. The apparatus of any preceding claim, wherein said first control signal (2590) comprises a first control signal pulse and said second control signal (2592) comprises a second control signal pulse, wherein said second control signal pulse is delayed relative to said first control signal pulse by .5 + n cycles of said input signal (2582), wherein n is an integer greater than or equal to 1.

6. The apparatus of any preceding claim, wherein said first frequency down-conversion module (114a) under-samples said input signal (2582) according to said first control signal (2590), and said second frequency down-conversion module (114b) under-samples said input signal (2582) according to said second control signal (2592).

7. The apparatus of claim 6, wherein said first and said second control signals (2590, 2592) each comprise a train of pulses having pulse widths that are established to improve energy transfer from said input signal (2582) to said first and said second down-converted signals (2507, 2509) respectively.

8. The apparatus of any preceding claim, wherein a first node of said each switch (102a, 102b) is coupled to a node of the corresponding said each storage element (2524, 2536), and a second node of said each switch (102a, 102b) is coupled to a reference potential (2528, 2540).

9. The apparatus of claim 8, wherein said each storage element (2524, 2536) comprises a capacitor (2574, 2576), wherein said capacitor (2574) corresponding to said first frequency down-conversion module (114a) reduces said first DC offset voltage and said capacitor (2576) corresponding to said second frequency down-conversion module (114b) reduces said second DC offset voltage, and wherein said first and said second DC offset voltages are at least due to charge injection effects in said first and said second frequency down-conversion modules (114a, 114b), respectively.

**10.** The apparatus of any preceding claim, wherein said first subtractor module (2520) comprises a differential amplifier.

**11.** The apparatus of any preceding claim, further comprising:

a third frequency down-conversion module (114c) that receives said input signal (2582), down-converts said input signal (2582) according to a third control signal (2594), and outputs a third down-converted signal (2511), wherein said third frequency down-conversion module (114c) contributes a third DC offset voltage to said third down-converted signal (2511);
a fourth frequency down-conversion module (114d) that receives said input signal (2582), down-converts said input signal (2582) according to a fourth control signal (2596) that is phase-shifted with respect to said third control signal by $180° + n \times 360°$, wherein these degrees are phase degrees of said input signal, where n is an integer greater than or equal to 0, and outputs a fourth down-converted signal (2513), wherein said fourth frequency down-conversion module (114d) contributes a fourth DC offset voltage to said fourth down-converted signal (2513); and
a second subtractor module that subtracts said fourth down-converted signal (2513) from said third down-converted signal (2511) and outputs a second channel down-converted signal (2586), said second channel down-converted signal (2586) having a DC offset component that comprises a difference between said third DC offset voltage and said fourth DC offset voltage;

wherein said third and said fourth frequency down-conversion modules (114c, 114d) each comprise a switch (102c, 102d) and a storage element (2548, 2560).

**12.** The apparatus of claim 11, wherein said first subtractor module (2520) and said second subtractor module (2522) each comprise a differential amplifier.

**13.** The apparatus of claim 11 or claim 12, further comprising:

a first filter (2504) that filters said first down-converted signal (2507);
a second filter (2508) that filters said second down-converted signal (2509);
a third filter (2512) that filters said third down-converted signal (2511); and
a fourth filter (2516) that filters said fourth down-converted signal (2513).

**14.** The apparatus of claim 13, wherein said first, second, third, and fourth filters (2504, 2508, 2512, 2516) each comprise a low-pass filter.

**15.** The apparatus of claim 14, wherein each said low-pass filter (2504, 2508, 2512, 2516) comprises a resistor (2530,2542,2554,2566) and a capacitor (2532, 2544, 2556, 2568).

**16.** The apparatus of any one of claims 11 to 15, further comprising a low-noise amplifier (2518) that amplifies said input signal (2582).

**17.** The apparatus of any one of claims 11 to 16, wherein said input signal (2582) comprises an RF I/Q modulated signal.

**18.** The apparatus of claim 17, wherein said first channel down-converted signal (2584) comprises an I-phase information signal portion of said RF I/Q modulated signal, and wherein said second channel down-converted signal (2586) comprises a Q-phase information signal portion of said RF I/Q modulated signal.

**19.** The apparatus of claim 18, wherein a second control signal pulse of said second control signal (2592) occurs 1.5 cycles of a frequency of said input signal (2582) after the occurrence of a first control signal pulse of said first control signal (2590);
wherein a fourth control signal pulse of said fourth control signal (2596) occurs 1.5 cycles of said frequency of said input signal (2582) after the occurrence of a third control signal pulse of said third control signal (2594); and
wherein said third control signal pulse occurs 75 cycles of said frequency of said input signal (2582) after the occurrence of said first control signal pulse.

**20.** The apparatus of claim 19, wherein a re-radiated signal comprises attenuated components of said first, second, third, and fourth control signal pulses to form a cumulative frequency, wherein a ratio of said cumulative frequency of said re-radiated signal to said frequency of said input signal (2582) is 4:3.

21. The apparatus of any one of claims 18 to 20, wherein said first control signal (2590) comprises a first control signal pulse, said second control signal (2592) comprises a second control signal pulse, said third control signal (2594) comprises a third control signal pulse, and said fourth control signal (2596) comprises a fourth control signal pulse; wherein apotentially re-radiated signal comprises attenuated components of said first, second, third, and fourth control signal pulses to form a cumulative frequency; and wherein said cumulative frequency of said potentially re-radiated signal is chosen to be greater than a frequency of said input signal (2582).

22. The apparatus of any one of claims 11 to 21, wherein said first DC offset voltage and said second DC offset voltage are substantially cancelled from said first channel output signal (2584) in said first subtractor module (2520); and wherein said third DC offset voltage and said fourth DC offset voltage are substantially cancelled from said second channel output signal (2586) in said second subtractor module (2522).

23. The apparatus of any one of claims 11 to 22, wherein said first frequency down-conversion module (114a) under-samples said input signal (2582) according to said first control signal (2590), said second frequency down-conversion module (114b) under-samples said input signal (2582) according to said second control signal (2592), said third frequency down-conversion module (114c) under-samples said input signal (2582) according to said third control signal (2594), and said fourth frequency down-conversion module (114d) under-samples said input signal (2582) according to said fourth control signal (2596).

24. The apparatus of claim 23, wherein said first, second, third, and fourth control signals (2590, 2592, 2594, 2596) each comprise a train of pulses having pulse widths that are established to improve energy transfer from said input signal (2582) to said first, second, third, and fourth down-converted signals (2507, 2509, 2511, 2513) respectively.

25. The apparatus of any one of claims 11 to 24, wherein a first node of said each switch(102a, 102b, 102c, 102d) is coupled to a node of the corresponding said each storage element (2524, 2536, 2548, 2560), and a second node of said each switch (102a, 102b, 102c, 102d) is coupled to a reference potential (2528, 2540, 2552, 2564).

26. The apparatus of claim 25, wherein said each storage element (2524, 2536, 2548, 2560) comprises a capacitor (2574, 2576, 2578, 2580).

27. The apparatus of claim 26, wherein said each capacitor (2574, 2576, 2578, 2580) corresponding to said first, second, third, and fourth universal frequency down-conversion modules (114a, 114b, 114c, 114d) reduces said first, second, third, and fourth DC offset voltages, respectively, wherein said first, second, third and fourth DC offset voltages are at least due to charge injection effects in said first, second, third, and fourth frequency down-conversion modules (114a, 114b, 114c, 114d), respectively.

28. The apparatus of any one of claims 11 to 27, further comprising a control signal generator (2600) that outputs said first, second, third, and fourth control signals (2590, 2592, 2594, 2596).

29. The apparatus of claim 28, wherein said control signal generator (2600) comprises:

a local oscillator (2602);
a 180 degree phase shifter (2606) coupled to an output of said local oscillator (2602);
a first divide-by-two module (2604) coupled to said output of said local oscillator (2602);
a second divide-by-two module (2608) coupled to an output of said 180 degree phase shifter (2606);
a first pulse generator (2610) coupled to an output of said first divide-by-two module (2604), wherein said first pulse generator (2610) outputs said first control signal (2590);
a second pulse generator (2612) coupled to an inverting output of said first divide-by-two module (2604), wherein said second pulse generator (2612) outputs said second control signal (2592);
a third pulse generator (2614) coupled to an output of said second divide-by-two module (2608), wherein said third pulse generator (2614) outputs said third control signal (2594); and
a fourth pulse generator (2616) coupled to an inverting output of said second divide-by-two module (2608), wherein said fourth pulse generator (2616) outputs said fourth control signal (2596).

**30.** A method of down-converting an electromagnetic signal and reducing DC offset voltages, comprising the steps of:

(1) receiving an input signal (2582);
(2) frequency down-converting the input signal (2582) with a first frequency down-conversion module (114a) according to a first control signal (2590) to form a first down-converted signal (2507), wherein the first down-converted signal (2507) includes a first DC offset voltage;
(3) frequency down-converting the input signal (2582) with a second frequency down-conversion module (114b) according to a second control signal (2592) that is phase-shifted with respect to the first control signal (2590) by $180° + n \times 360°$, wherein these degrees are phase degrees of said input signal, where n is an integer greater than or equal to 0, to form a second down-converted signal (2509), wherein the second down-converted signal (2509) includes a second DC offset voltage; and
(4) subtracting the second down-converted signal (2509) from the first down-converted signal (2507) to form a first output signal (2584) having a DC offset component that comprises a difference between the first DC offset voltage and the second DC offset voltage;

wherein said first and said second frequency down-conversion modules (114a, 114b) each comprise a switch (102a, 102b) and a storage element (2524, 2536).

**31.** The method of claim 30, further comprising the step of:

(5) amplifying the first output signal (2584).

**32.** The method of claim 31, further comprising the step of:

(6) differentially amplifying the first and second down-converted signals (2507, 2509), wherein step (6) comprises steps (4) and (5).

**33.** The method of any one of claims 30 to 32,
wherein step (2) comprises the step of:

(A) under-sampling the input signal (2582) according to the first control signal (2590); and

wherein step (3) comprises the step of:

(A) under-sampling the input signal (2582) according to the second control signal (2592);

wherein the first control signal (2590) comprises a first pulse, and wherein the second control signal (2592) comprises a second pulse; and
wherein the second pulse is delayed relative to the first pulse by .5 + n cycles of the input signal (2582), wherein n is an integer greater than or equal to 0.

**34.** The method of any one of claims 30 to 33, further comprising the step of:

(5) filtering the first down-converted signal (2507) and the second down-converted signal (2509).

**35.** The method of any one of claims 30 to 34, further comprising

(5) frequency down-converting the input signal (2582) with a third frequency down-conversion module (114c) according to a third control signal (2594) to form a third down-converted signal (2511), wherein the third down-converted signal (2511) includes a third DC offset voltage;
(6) frequency down-converting the input signal (2582) with a fourth frequency down-conversion module (114d) according to a fourth control signal (2596) that is phase-shifted with respect to the third control signal (2594) by $180° + n \times 360°$, wherein these degrees are phase degrees of said input signal, where n is an integer greater than or equal to 0, to form a fourth down-converted signal (2513), wherein the fourth down-converted signal (2513) includes a fourth DC offset voltage; and
(7) subtracting the fourth down-converted signal (2513) from the third down-converted signal (2511) to form a second output signal (2586) having a DC offset component that comprises a difference between the third DC offset voltage and the fourth DC offset voltage.

**36.** The method of claim 35,
wherein step (2) comprises the step of:

(A) under-sampling the input signal (2582) according to the first control signal (2590);

wherein step (3) comprises the step of:

(A) under-sampling the input signal (2582) according to the second control signal (2592);

wherein step (5) comprises the step of:

(A) under-sampling the input signal (2582) according to the third control signal (2594); and

wherein step (6) comprises the step of:

(A) under-sampling the input signal (2582) according to the fourth control signal (2596).

**37.** The method of claim 36,
wherein step (2)(A) comprises the step of:

(i) generating the first control signal (2590);

wherein step (3)(A) comprises the step of:

(i) generating the second control signal (2592),

wherein the second control signal (2592) is a phase-shifted version of the first control signal (2590);
wherein step (5)(A) comprises the step of:

(i) generating the third control signal (2594), wherein the third control signal is a phase-shifted version of the first control signal (2590); and

wherein step (6)(A) comprises the step of:

(i) generating the fourth control signal (2596), wherein the fourth control signal (2596) is a phase-shifted version of the first control signal (2590)

**38.** The method of claim 37, wherein the received input signal (2582) comprises a modulated carrier signal, wherein steps (2)(A), (3)(A), (5)(A), and (6)(A) each further comprise the step of:

(ii) transferring non-negligible amounts of energy from the modulated carrier signal, at a rate that is substantially equal to a sub-harmonic of the modulated carrier signal, whereby the transferred non-negligible amounts of energy form the corresponding down-converted signal.

**39.** The method of claim 38,
wherein steps (2)(A)(i), (3)(A)(i), (5)(A)(i), and (6)(A)(i) each comprise the step of:

(a) generating an energy transfer signal having a harmonic substantially equal to a frequency of the modulated carrier signal; and

wherein steps (2)(A)(ii), (3)(A)(ii), (5)(A)(ii), and (6)(A)(ii) each comprise the step of:

(a) using the energy transfer signal to transfer energy from the modulated carrier signal.

**40.** The method according to claim 39, wherein steps (2)(A)(ii), (3)(A)(ii), (5)(A)(ii), and (6)(A)(ii) each further comprise generating a train of pulses having non-negligible apertures that tend away from zero time in duration.

**41.** The method of anyone of claims 35 to 40, wherein the input signal (2582) comprises an-RF I/Q modulated signal, and

wherein step (2) comprises the step of:

(A) frequency down-converting the input signal (2582) to a non-inverted I-phase signal portion (2507) of the RF I/Q modulated signal;

wherein step (3) comprises the step of:

(A) frequency down-converting the input signal (2582) to an inverted I-phase signal portion (2509) of the RF I/Q modulated signal;

wherein step (5) comprises the step of:

(A) frequency down-converting the input signal (2582) to a non-inverted Q-phase signal portion (2511) of the RF I/Q modulated signal; and

wherein step (6) comprises the step of:

(A) frequency down-converting the input signal (2582) to an inverted Q-phase signal portion (2513) of the RF I/Q modulated signal.

42. The method of claim 41,
    wherein step (2)(A) comprises the step of

(i) under-sampling a first phase of the in-phase signal portion of the RF I/Q modulated signal;

wherein step (3)(A) comprises the step of:

(i) under-sampling a second phase of the in-phase signal portion of the RF I/Q modulated signal, wherein the second phase of the in-phase signal portion is of an opposite phase to the first phase of the in-phase signal portion;

wherein step (5)(A) comprises the step of:

(i) under-sampling a third phase of the quadrature-phase signal portion of the RF I/Q modulated signal; and

wherein step (6)(A) comprises the step of:

(i) under-sampling a fourth phase of the quadrature-phase signal portion of the RF I/Q modulated signal, wherein the fourth phase of the quadrature-phase signal portion is of an opposite phase to the third phase of the quadrature-phase signal portion.

43. The method of claim 42,
    wherein step (3)(A)(i) comprises the step of:

(a) under-sampling the RF I/Q modulated signal 1.5 cycles of a frequency of the RF I/Q modulated signal after under-sampling the RF I/Q modulated signal in step (2)(A)(i);

wherein step (5)(A)(i) comprises the step of:

(a) under-sampling the RF I/Q modulated signal .75 cycles of the frequency of the RF I/Q modulated signal after under-sampling of the RF I/Q modulated signal occurs in step (2)(A)(i); and

wherein step (6)(A)(i) comprises the step of:

(a) under-sampling the RF I/Q modulated signal 1.5 cycles of the frequency of the RF I/Q modulated signal after under-sampling of the RF I/Q modulated signal occurs in step (5)(A)(i).

44. The method of claim 43, wherein step (2)(A) further comprises the step of:

(ii) under-sampling the RF I/Q modulated signal 3.0 cycles of the frequency of the RF I/Q modulated signal after a previous under-sample of the RF I/Q modulated signal.

45. The method of any one of claims 35 to 44, wherein the first control signal (2590) comprises a first control signal pulse, the second control signal (2592) comprises a second control signal pulse, the third control signal (2594) comprises a third control signal pulse, and the fourth control signal (2596) comprises a fourth control signal pulse, and wherein the method further comprises the steps of:

(8) re-radiating a signal that comprises attenuated components of the first, second, third, and fourth control signal pulses, wherein the attenuated components of the first, second, third, and fourth control signal pulses form a cumulative frequency; and
(9) configuring the first, second, third, and fourth control signal pulses such that the cumulative frequency is greater than a frequency of the input signal (2582).

46. The method of any one of claims 35 to 45,
wherein step (4) comprises the step of:

(A) substantially canceling the first DC offset voltage and the second DC offset voltage; and

wherein step (7) comprises the step of:

(A) substantially canceling the third DC offset voltage and the fourth DC offset voltage.

47. The method of any one of claims 35 to 46, wherein the first, second, third, and fourth DC offset voltages are at least generated by the first, second, third, and fourth frequency down-conversion modules (114a, 114b, 114c, 114d), respectively.

48. The method of claim 47, wherein the first, second, third, and fourth frequency down-conversion modules (114a, 114b, 114c, 114d) each comprise a capacitor (2574, 2576, 2578, 2580) in series with the input signal (2582),
wherein step (2) further comprises the step of:

(B) reducing the first DC offset voltage in the first down-converted signal (2507) with the capacitor (2574) of the first frequency down-conversion module (114a);

wherein step (3) further comprises the step of:

(B) reducing the second DC offset voltage in the second down-converted signal (2509) with the capacitor (2576) of the second frequency down-conversion module (114b);

wherein step (5) further comprises the step of:

(B) reducing the third DC offset voltage in the third down-converted signal (2511) with the capacitor (2578) of the third frequency down-conversion module (114c); and

wherein step (6) further comprises the step of:

(B) reducing the fourth DC offset voltage in the fourth down-converted signal (2513) with the capacitor (2560) of the fourth universal frequency down-conversion module (114d);

wherein the first, second, third, and fourth DC offset voltages are at least due to charge injection effects in the first, second, third, and fourth frequency down-conversion modules (114a, 114b, 114c, 114d), respectively, from interaction with the first, second, third, and fourth control signals (2590, 2592, 2594, 2596), respectively.

## EP 1 222 733 B1

**Patentansprüche**

1. Vorrichtung zum Abwärtsumsetzen eines elektromagnetischen Signals und zum Verringern von DC-Offsetspannungen mit:

    einem ersten Frequenzabwärtsumsetzmodul (114a), das ein Eingangssignal (2582) empfängt, das Eingangssignal (2582) gemäß einem ersten Steuersignal (2590) abwärtsumsetzt und ein erstes abwärtsumgesetztes Signal (2507) ausgibt, wobei das erste Frequenzabwärtsumsetzmodul (114a) zu einer ersten DC-Offsetspannung in dem ersten abwärtsumgesetzten Signal (2507) beiträgt;
    einem zweiten Frequenzabwärtsumsetzmodul (114b), das das Eingangssignal (2582) empfängt, das Eingangssignal (2582) gemäß einem zweiten Steuersignal (2592), das bezüglich des ersten Steuersignals (2590) um 180°+n×360° phasenverschoben ist, wobei diese Gradangaben Phasengrade des Eingangssignals sind und n eine ganze Zahl größer oder gleich 0 ist, abwärtsumsetzt und ein zweites abwärtsumgesetztes Signal (2509) ausgibt, wobei das zweite Frequenzabwärtsumsetzmodul (114b) zu einer zweiten DC-Offsetspannung in dem zweiten abwärtsumgesetzten Signal (2509) beiträgt; und
    einem ersten Subtraktionsmodul (2520), das das zweite abwärtsumgesetzte Signal (2509) von dem ersten abwärtsumgesetzten Signal (2507) subtrahiert und ein erstes kanalabwärtsumgesetztes Signal (2584) ausgibt, wobei das erste kanalabwärtsumgesetzte Signal (2584) eine DC-Offsetkomponente hat, die eine Differenz zwischen der ersten DC-Offsetspannung und der zweiten DC-Offsetspannung aufweist;

    wobei das erste und das zweite Frequenzabwärtsumsetzmodul (114a,114b) jeweils einen Schalter (102a, 102b) und ein Speicherelement (2524,2536) aufweisen.

2. Vorrichtung nach Anspruch 1, wobei das Eingangssignal (2582) ein RF-Trägersignal ist, das mit einem Informationssignal amplituden- (AM), frequenz- (FM)oder phasenmoduliert (PM) ist.

3. Vorrichtung nach Anspruch 2, wobei das erste kanalabwärtsumgesetzte Signal (2584) ein Basisbandsignal ist.

4. Vorrichtung nach Anspruch 2, wobei das erste kanalabwärtsumgesetzte Signal (2584) ein Zwischenfrequenzsignal ist.

5. Vorrichtung nach einem der vorstehenden Ansprüche, wobei das erste Steuersignal (2590) einen ersten Steuersignalpuls aufweist und das zweite Steuersignal (2592) einen zweiten Steuersignalpuls aufweist, wobei der zweite Steuersignalpuls um 0,5+n Zyklen des Eingangssignals (2582) relativ zum ersten Steuersignalpuls verspätet ist, wobei n eine ganze Zahl größer oder gleich 1 ist.

6. Vorrichtung nach einem der vorstehenden Ansprüche, wobei das erste Frequenzabwärtsumsetzmodul (114a) das Eingangssignal (2582) gemäß dem ersten Steuersignal (2590) unterabtastet und das zweite Frequenzabwärtsumsetzmodul (114b) das Eingangssignal (2582) gemäß dem zweiten Steuersignal (2592) unterabtastet.

7. Vorrichtung nach Anspruch 6, wobei das erste und das zweite Steuersignal (2590,2592) jeweils eine Serie von Pulsen aufweisen, die Pulsbreiten haben, die eingerichtet sind, um die Energieübertragung von dem Eingangssignal (2582) zum ersten bzw. zweiten abwärtsumgesetzten Signal (2507,2509) zu verbessern.

8. Vorrichtung nach einem der vorstehenden Ansprüche, wobei ein erster Knoten jedes Schalters (102a,102b) mit einem Knoten des entsprechenden Speicherelements (2524,2536) verbunden ist und ein zweiter Knoten jedes Schalters (102a,102b) mit einem Bezugspotential (2528,2540) verbunden ist.

9. Vorrichtung nach Anspruch 8, wobei jedes Speicherelement (2524,2536) einen Kondensator (2574,2576) aufweist, wobei der Kondensator (2574), der dem ersten Frequenzabwärtsumsetzmodul (114a) zugeordnet ist, die erste DC-Offsetspannung verringert und der Kondensator (2576), der dem zweiten Frequenzabwärtsumsetzmodul (114b) zugeordnet ist, die zweite DC-Offsetspannung verringert, und wobei Ladungsinjektionseffekte in dem ersten bzw. zweiten Frequenzabwärtsumsetzmodul (114a, 114b) die erste und die zweite DC-Offsetspannung zumindest mit verursachen.

10. Vorrichtung nach einem der vorstehenden Ansprüche, wobei das erste Subtraktionsmodul (2520) einen Differenzverstärker aufweist.

**11.** Vorrichtung nach einem der vorstehenden Ansprüche, ferner mit:

einem dritten Frequenzabwärtsumsetzmodul (114c), das das Eingangssignal (2582) empfängt, das Eingangssignal (2582) gemäß einem dritten Steuersignal (2594) abwärtsumsetzt und ein drittes abwärtsumgesetztes Signal (2511) ausgibt, wobei das dritte Frequenzabwärtsumsetzmodul (114c) zu einer dritten DC-Offsetspannung in dem dritten abwärtsumgesetzten Signal (2511) beiträgt;

einem vierten Frequenzabwärtsumsetzmodul (114d), das das Eingangssignal (2582) empfängt, das Eingangssignal (2582) gemäß einem vierten Steuersignal (2596), das bezüglich des dritten Steuersignals um 180°+n×360° phasenverschoben ist, wobei diese Gradangaben Phasengrade des Eingangssignals sind und n eine ganze Zahl größer gleich 0 ist, abwärtsumsetzt und ein viertes abwärtsumgesetztes Signal (2513) ausgibt, wobei das vierte Frequenzabwärtsumsetzmodul (114d) zu einer vierten DC-Offsetspannung in dem vierten abwärtsumgesetzten Signal (2511) beiträgt; und

einem zweiten Subtraktormodul, das das vierte abwärtsumgesetzte Signal (2513) von dem dritten abwärtsumgesetzten Signal (2511) subtrahiert und ein zweites kanalabwärtsumgesetztes Signal (2586) ausgibt, wobei das zweite kanalabwärtsumgesetzte Signal (2586) eine DC-Offsetkomponente hat, die eine Differenz zwischen der dritten DC-Offsetspannung und der vierten DC-Offsetspannung aufweist;

wobei das dritte und das vierte Frequenzabwärtsumsetzmodul (114c,114d) jeweils einen Schalter (102c, 102d) und ein Speicherelement (2548,2560) aufweisen.

**12.** Vorrichtung nach Anspruch 11, wobei das erste Subtraktormodul (2520) und das zweite Subtraktormodul (2522) jeweils einen Differenzverstärker aufweisen.

**13.** Vorrichtung nach Anspruch 11 oder Anspruch 12, ferner mit:

einem ersten Filter (2504), der das erste abwärtsumgesetzte Signal (2507) filtert;
einem zweiten Filter (2508), der das zweite abwärtsumgesetzte Signal (2509) filtert;
einem dritten Filter (2512), der das dritte abwärtsumgesetzte Signal (2511) filtert; und
einem vierten Filter (2516), der das vierte abwärtsumgesetzte Signal (2513) filtert.

**14.** Vorrichtung nach Anspruch 13, wobei der erste, zweite, dritte und vierte Filter (2504,2508,2512,2516) jeweils ein Tiefpaßfilter aufweisen.

**15.** Vorrichtung nach Anspruch 14, wobei jedes Tiefpaßfilter (2504,2508,2512,2516) einen Widerstand (2530,2542,2554,2566) und einen Kondensator (2532,2544,2556,2568) aufweist.

**16.** Vorrichtung nach einem der Ansprüche 11 bis 15, ferner mit einem rauscharmen Verstärker (2518), der das Eingangssignal (2582) verstärkt.

**17.** Vorrichtung nach einem der Ansprüche 11 bis 16, wobei das Eingangssignal (2582) ein I/Q-moduliertes RF-Signal aufweist.

**18.** Vorrichtung nach Anspruch 17, wobei das erste kanalabwärtsumgesetzte Signal (2584) einen I-Phase-Informationssignalanteil des I/Q-modulierten RF-Signals aufweist und wobei das zweite kanalabwärtsumgesetzte Signal (2586) einen Q-Phase-Informationssignalanteil des I/Q-modulierten RF-Signals aufweist.

**19.** Vorrichtung nach Anspruch 18, wobei ein zweiter Steuersignalpuls des zweiten Steuersignals (2592) 1,5 Zyklen einer Frequenz des Eingangssignals (2582) nach dem Auftreten eines ersten Steuersignalpulses des ersten Steuersignals (2590) auftritt;

wobei ein vierter Steuersignalpuls des vierten Steuersignals (2596) 1,5 Zyklen der Frequenz des Eingangssignals (2582) nach dem Auftreten eines dritten Steuersignalpulses des dritten Steuersignals (2594) auftritt; und

wobei der dritte Steuersignalpuls 0,75 Zyklen der Frequenz des Eingangssignals (2582) nach dem Auftreten des ersten Steuersignalpulses auftritt.

**20.** Vorrichtung nach Anspruch 19, wobei ein wieder ausgestrahltes Signal gedämpfte Komponenten des ersten, zweiten, dritten und vierten Steuersignalpulses aufweist, um eine kumulative Frequenz zu bilden, wobei ein Verhältnis der kumulativen Frequenz des wieder ausgestrahlten Signals zur Frequenz des Eingangssignals (2582) 4:3 ist.

21. Vorrichtung nach einem der Ansprüche 18 bis 20, wobei das erste Steuersignal (2590) einen ersten Steuersignalpuls aufweist, das zweite Steuersignal (2592) einen zweiten Steuersignalpuls aufweist, das dritte Steuersignal (2594) einen dritten Steuersignalpuls aufweist und das vierte Steuersignal (2596) einen vierten Steuersignalpuls aufweist;

wobei ein möglicherweise wieder ausgestrahltes Signal gedämpfte Komponenten des ersten, zweiten, dritten und vierten Steuersignalspulses aufweist, um eine kumulative Frequenz zu bilden; und

wobei die kumulative Frequenz des möglicherweise wieder ausgestrahlten Signals so gewählt ist, daß sie größer als eine Frequenz des Eingangssignals (2582) ist.

22. Vorrichtung nach einem der vorstehenden Ansprüche 11 bis 21, wobei in dem ersten Subtraktionsmodul (2520) die erste DC-Offsetspannung und die zweite DC-Offsetspannung aus dem ersten Kanalausgangssignal (2584) im wesentlichen eliminiert werden; und

wobei in dem zweiten Subtraktionsmodul (2522) die dritte DC-Offsetspannung und die vierte DC-Offsetspannung aus dem zweiten Kanalausgangssignal (2586) im wesentlichen eliminiert werden.

23. Vorrichtung nach einem der Ansprüche 11 bis 22, wobei das erste Frequenzabwärtsumsetzmodul (114a) das Eingangssignal (2582) gemäß dem ersten Steuersignal (2590) unterabtastet, das zweite Frequenzabwärtsumsetzmodul (114b) das Eingangssignal (2582) gemäß dem zweiten Steuersignal (2592) unterabtastet, das dritte Frequenzabwärtsumsetzmodul (114c) das Eingangssignal (2582) gemäß dem dritten Steuersignal (2594) unterabtastet und das vierte Frequenzabwärtsumsetzmodul (114d) das Eingangssignal (2582) gemäß dem vierten Steuersignal (2596) unterabtastet.

24. Vorrichtung nach Anspruch 23, wobei das erste, zweite, dritte und vierte Steuersignal (2590,2592,2594,2596) jeweils eine Serie von Pulsen aufweisen, die Pulsbreiten haben, die eingerichtet sind, um die Energieübertragung von dem Eingangssignal (2582) zu dem ersten, zweiten, dritten bzw. vierten abwärtsumgesetzten Signal (2507,2509,2511,2513) zu verbessern.

25. Vorrichtung nach einem der Ansprüche 11 bis 24, wobei ein erster Knoten jedes Schalters (102a,102b,102c,102d) mit einem Knoten des entsprechenden Speicherelements (2524,2536, 2548,2560) verbunden ist und ein zweiten Knoten jedes Schalters (102a,102b,102c,102d) mit einem Bezugspotential (2528,2540, 2552,2564) verbunden ist.

26. Vorrichtung nach Anspruch 25, wobei jedes Speicherelement (2524,2536,2548,2560) einen Kondensator (2574,2576, 2578,2580) aufweist.

27. Vorrichtung nach Anspruch 26, wobei jeder Kondensator (2574,2576,2578,2580), der dem ersten, zweiten, dritten bzw. vierten universellen Frequenzabwärtsumsetzmodul (114a,114b, 114c, 114d) zugeordnet ist, die erste, zweite, dritte bzw. vierte DC-Offsetspannung verringert, wobei Ladungsinjektionseffekte in dem ersten, zweiten, dritten bzw. vierten Frequenzabwärtsumsetzmodul (114a, 114b, 114c, 114d) die erste, zweite, dritte bzw. vierte DC-Offsetspannung zumindest mit verursachen.

28. Vorrichtung nach einem der Ansprüche 11 bis 27, ferner mit einem Steuersignalgenerator (2600), der das erste, zweite, dritte und vierte Steuersignal (2590,2592,2594,2596) ausgibt.

29. Vorrichtung nach Anspruch 28, wobei der Signalgenerator (2600) aufweist:

einen Empfangsoszillator (2602);
einen 180-Grad-Phasenschieber (2606), der mit einem Ausgang des Empfangsoszillators (2602) verbunden ist;
ein erstes Geteilt-durch-zwei-Modul (2604), das mit dem Ausgang des Empfangsoszillators (2602) verbunden ist;
ein zweites Geteilt-durch-zwei-Modul (2608), das mit einem Ausgang des 180-Grad-Phasenschiebers (2606) verbunden ist;
einen ersten Pulsgenerator (2610), der mit einem Ausgang des ersten Geteilt-durch-zwei-Moduls (2604) verbunden ist, wobei der erste Pulsgenerator (2610) das erste Steuersignal (2590) ausgibt;
einen zweiten Pulsgenerator (2612), der mit einem invertierenden Ausgang des ersten Geteilt-durch-zwei-Moduls (2604) verbunden ist, wobei der zweite Pulsgenerator (2612) das zweite Steuersignal (2592) ausgibt;
einen dritten Pulsgenerator (2614), der mit einem Ausgang des zweiten Geteilt-durch-zwei-Moduls (2608) verbunden ist, wobei der dritte Pulsgenerator (2614) das dritte Steuersignal (2594) ausgibt; und

einen vierten Pulsgenerator (2616), der mit einem invertierenden Ausgang des zweiten Geteilt-durch-zwei-Moduls (2608) verbunden ist, wobei der vierte Pulsgenerator (2616) das vierte Steuersignal (2596) ausgibt.

30. Verfahren zum Abwärtsumsetzen eines elektromagnetischen Signals und zum Verringern von DC-Offsetspannungen mit den folgenden Schritten:

(1) Empfangen eines Eingangssignals (2582);
(2) Frequenzabwärtsumsetzen des Eingangssignals (2582) mit einem ersten Frequenzabwärtsumsetzmodul (114a) gemäß einem ersten Steuersignal (2590), um ein erstes abwärtsumgesetztes Signal (2507) zu erzeugen, wobei das erste abwärtsumgesetzte Signal (2507) eine erste DC-Offsetspannung aufweist;
(3) Frequenzabwärtsumsetzen des Eingangssignals (2582) mit einem zweiten Frequenzabwärtsumsetzmodul (114b) gemäß einem zweiten Steuersignal (2592), das bezüglich des ersten Steuersignals (2590) um $180° + n \times 360°$ phasenverschoben ist, wobei diese Gradangaben Phasengrade des Eingangssignals sind und n eine ganze Zahl größer oder gleich 0 ist, um ein zweites abwärtsumgesetztes Signal (2509) zu erzeugen, wobei das zweite abwärtsumgesetzte Signal (2509) eine zweite DC-Offsetspannung aufweist; und
(4) Subtrahieren des zweiten abwärtsumgesetzten Signals (2509) von dem ersten abwärtsumgesetzten Signal (2507), um ein erstes Ausgangssignal (2584) zu erzeugen, das eine DC-Offsetkomponente hat, die eine Differenz zwischen der ersten DC-Offsetspannung und der zweiten DC-Offsetspannung aufweist;
wobei das erste und das zweite Frequenzabwärtsumsetzmodul (114a, 114b) jeweils einen Schalter (102a, 102b) und ein Speicherelement (2524, 2536) aufweisen.

31. Verfahren nach Anspruch 30, ferner mit dem Schritt:

(5) Verstärken des ersten Ausgangssignals (2584).

32. Verfahren nach Anspruch 31, ferner mit dem Schritt:

(6) differentielles Verstärken des ersten und zweiten abwärtsumgesetzten Signals (2507, 2509), wobei Schritt (6) die Schritte (4) und (5) aufweist.

33. Verfahren nach einem der Ansprüche 30 bis 32,
wobei Schritt (2) den Schritt aufweist:

(A) Unterabtasten des Eingangssignals (2582) gemäß dem ersten Steuersignal (2590); und

wobei Schritt (3) den Schritt aufweist:

(A) Unterabtasten des Eingangssignals (2582) gemäß dem zweiten Steuersignal (2592);

wobei das erste Steuersignal (2590) einen ersten Puls aufweist und wobei das zweite Steuersignal (2592) einen zweiten Puls aufweist; und
wobei der zweite Puls um 0,5+n Zyklen des Eingangssignals (2582) relativ zum ersten Puls verspätet ist, wobei n eine ganze Zahl größer oder gleich 0 ist.

34. Verfahren nach einem der Ansprüche 30 bis 33, ferner mit dem Schritt:

(5) Filtern des ersten abwärtsumgesetzten Signals (2507) und des zweiten abwärtsumgesetzten Signals (2509).

35. Verfahren nach einem der Ansprüche 30 bis 34, ferner mit:

(5) Frequenzabwärtsumsetzen des Eingangssignals (2582) mit einem dritten Frequenzabwärtsumsetzmodul (114c) gemäß einem dritten Steuersignal (2594), um ein drittes abwärtsumgesetztes Signal (2511) zu erzeugen, wobei das dritte abwärtsumgesetzte Signal (2511) eine dritte DC-Offsetspannung aufweist;
(6) Frequenzabwärtsumsetzen des Eingangssignals (2582) mit einem vierten Frequenzabwärtsumsetzmodul (114d) gemäß einem vierten Steuersignal (2596), das bezüglich des dritten Steuersignals um $180° + n \times 360°$ phasenevrschoben ist, wobei diese Gradangaben Phasengrade des Eingangssignals sind und n eine ganze Zahl größer gleich 0 ist, um ein viertes abwärtsumgesetztes Signal (2513) zu erzeugen, wobei das vierte abwärtsumgesetzte Signal (2513) eine vierte DC-Offsetspannung aufweist; und

(7) Subtrahieren des vierten abwärtsumgesetzten Signals (2513) von dem dritten abwärtsumgesetzten Signal (2511), um ein zweites Ausgangssignal (2586) zu erzeugen, das eine DC-Offsetkomponente hat, die eine Differenz zwischen der dritten DC-Offsetspannung und der vierten DC-Offsetspannung aufweist.

36. Verfahren nach Anspruch 35,
   wobei Schritt (2) den Schritt aufweist:

   (A) Unterabtasten des Eingangssignals (2582) gemäß dem ersten Steuersignal (2590);

   wobei Schritt (3) den Schritt aufweist:

   (A) Unterabtasten des Eingangssignals (2582) gemäß dem zweiten Steuersignal (2592);

   wobei Schritt (5) den Schritt aufweist:

   (A) Unterabtasten des Eingangssignals (2582) gemäß dem dritten Steuersignal (2594); und

   wobei Schritt (6) den Schritt aufweist:

   (A) Unterabtasten des Eingangssignals (2582) gemäß dem vierten Steuersignal (2596).

37. Verfahren nach Anspruch 36,
   wobei Schritt (2)(A) den Schritt aufweist:

   (i) Erzeugen des ersten Steuersignals (2590);

   wobei Schritt (3)(A) den Schritt aufweist:

   (i) Erzeugen des zweiten Steuersignals (2592), wobei das zweite Steuersignal (2592) eine phasenverschobene Version des ersten Steuersignals (2590) ist;

   wobei Schritt (5)(A) den Schritt aufweist:

   (i) Erzeugen des dritten Steuersignals (2594), wobei das dritte Steuersignal (2594) eine phasenverschobene Version des ersten Steuersignals (2590) ist; und

   wobei Schritt (6)(A) den Schritt aufweist:

   (i) Erzeugen des vierten Steuersignals (2596), wobei das vierte Steuersignal (2596) eine phasenverschobene Version des ersten Steuersignals (2590) ist.

38. Verfahren nach Anspruch 37, wobei das empfangene Eingangssignal (2582) ein moduliertes Trägersignal aufweist, wobei die Schritte (2) (A), (3) (A), (5) (A) und (6) (A) jeweils ferner den Schritt aufweisen:

   (ii) Übertragen nicht vernachlässigbarer Energiemengen von dem modulierten Trägersignal aus mit einer Rate, die im wesentlichen gleich einer Subharmonischen des modulierten Trägersignals ist, wobei die übertragenen nicht vernachlässigbaren Energiemengen das entsprechende abwärtsumgesetzte Signal bilden.

39. Verfahren nach Anspruch 38,
   wobei die Schritte (2) (A) (i), (3) (A) (i), (5) (A) (i) und (6)(A)(i) jeweils den Schritt aufweisen:

   (a) Erzeugen eines Energieübertragungssignals, das eine Harmonische hat, die im wesentlichen gleich einer Frequenz des modulierten Trägersignals ist; und

   wobei die Schritte (2)(A)(ii), (3)(A)(ii), (5) (A) (ii) und (6)(A)(ii) jeweils den Schritt aufweisen:

   (a) Verwenden des Energieübertragungssignals, um Energie von dem modulierten Trägersignals aus zu übertragen.

40. Verfahren nach Anspruch 39, wobei die Schritte (2)(A)(ii), (3)(A)(ii), (5) (A) (ii) und (6) (A) (ii) jeweils ferner aufweisen: Erzeugen einer Serie von Pulsen, die nicht vernachlässigbare Öffnungen haben, die von einer Nullzeitdauer weg tendieren.

41. Verfahren nach einem der Ansprüche 35 bis 40, wobei das Eingangssignal (2582) ein I/Q-moduliertes RF-Signal aufweist und
   wobei Schritt (2) den Schritt aufweist:

   (A) Frequenzabwärtsumsetzen des Eingangssignals (2582) in einen nicht-invertierten I-Phase-Signalanteil (2507) des I/Qmodulierten RF-Signals;

   wobei Schritt (3) den Schritt aufweist:

   (A) Frequenzabwärtsumsetzen des Eingangssignals (2582) in einen invertierten I-Phase-Signalanteil (2509) des I/Qmodulierten RF-Signals;

   wobei Schritt (5) den Schritt aufweist:

   (A) Frequenzabwärtsumsetzen des Eingangssignals (2582) in einen nicht-invertierten Q-Phase-Signalanteil (2511) des I/Qmodulierten RF-Signals; und

   wobei Schritt (6) den Schritt aufweist:

   (A) Frequenzabwärtsumsetzen des Eingangssignals (2582) in einen invertierten Q-Phase-Signalanteil (2513) des I/Qmodulierten RF-Signals.

42. Verfahren nach Anspruch 41,
   wobei Schritt (2)(A) den Schritt aufweist:

   (i) Unterabtasten einer ersten Phase des Inphase-Signalanteils des I/Q-modulierten RF-Signals;

   wobei Schritt (3)(A) den Schritt aufweist:

   (i) Unterabtasten einer zweiten Phase des Inphase-Signalanteils des I/Q-modulierten RF-Signals, wobei die zweite Phase des Inphase-Signalanteils eine entgegengesetzte Phase zur ersten Phase des Inphase-Signalanteils ist;

   wobei Schritt (5)(A) den Schritt aufweist:

   (i) Unterabtasten einer dritten Phase des Quadraturphase-Signalanteils des I/Q-modulierten RF-Signals; und

   wobei Schritt (6)(A) den Schritt aufweist:

   (i) Unterabtasten einer vierten Phase des Quadraturphase-Signalanteils des I/Q-modulierten RF-Signals, wobei die vierte Phase des Quadraturphase-Signalanteils eine entgegengesetzte Phase zur dritten Phase des Quadraturphase-Signalanteils ist.

43. Verfahren nach Anspruch 42,
   wobei Schritt (3)(A)(i) den Schritt aufweist:

   (a) Unterabtasten des I/Q-modulierten RF-Signals 1,5 Zyklen einer Frequenz des I/Q-modulierten RF-Signals nach dem Unterabtasten des I/Q-modulierten RF-Signals in Schritt (2)(A)(i);

   wobei Schritt (5)(A)(i) den Schritt aufweist:

   (a) Unterabtasten des I/Q-modulierten RF-Signals 0,75 Zyklen der Frequenz des I/Q-modulierten RF-Signals, nachdem das Unterabtasten des I/Q-modulierten RF-Signals in Schritt (2)(A)(i) stattfindet;

wobei Schritt (6)(A)(i) den Schritt aufweist:

(a) Unterabtasten des I/Q-modulierten RF-Signals 1,5 Zyklen der Frequenz des I/Q-modulierten RF-Signals, nachdem das Unterabtasten des I/Q-modulierten RF-Signals in Schritt (5) (A) (i) stattfindet.

44. Verfahren nach Anspruch 43, wobei Schritt (2)(A) ferner den Schritt aufweist:

(ii) Unterabtasten des I/Q-modulierten RF-Signals 3,0 Zyklen der Frequenz des I/Q-modulierten RF-Signals nach einer vorhergehenden Unterabtastung des I/Q-modulieren RF-Signals.

45. Verfahren nach einem der Ansprüche 35 bis 44, wobei das erste Steuersignal (2590) einen ersten Steuersignalpuls aufweist, das zweite Steuersignal (2592) einen zweiten Steuersignalpuls aufweist, das dritte Steuersignal (2594) einen dritten Steuersignalpuls aufweist und das vierte Steuersignal (2596) einen vierten Steuersignalpuls aufweist, und wobei das Verfahren ferner die Schritte aufweist:

(8) Wiederausstrahlen eines Signals, das gedämpfte Komponenten des ersten, zweiten, dritten und vierten Steuersignalpulses aufweist, wobei die gedämpften Komponenten des ersten, zweiten, dritten und vierten Steuersignalpulses eine kumulative Frequenz bilden; und
(9) Konfigurieren des ersten, zweiten, dritten und vierten Steuersignalpulses derart, daß die kumulative Frequenz größer als eine Frequenz des Eingangssignals (2582) ist.

46. Verfahren nach einem der Ansprüche 35 bis 45,
wobei Schritt (4) den Schritt aufweist:

(A) wesentliches Eliminieren der ersten DC-Offsetspannung und der zweiten DC-Offsetspannung; und

wobei Schritt (7) den Schritt aufweist:

(A) wesentliches Eliminieren der dritten DC-Offsetspannung und der vierten DC-Offsetspannung.

47. Verfahren nach einem der Ansprüche 36 bis 46, wobei die erste, zweite, dritte bzw. vierte DC-Offsetspannung von dem ersten, zweiten, dritten bzw. vierten Frequenzabwärtsumsetzmodul (114a,114b,114c,114d) zumindest mit verursacht ist.

48. Verfahren nach Anspruch 47, wobei das erste, zweite, dritte und vierte Frequenzabwärtsumsetzmodul (114a,114b, 114c, 114d) jeweils einen Kondensator (2574,2576,2578,2580) in Reihe mit dem Eingangssignal (2582) aufweisen, wobei Schritt (2) ferner den Schritt aufweist:

(B) Verringern der ersten DC-Offsetspannung in dem ersten abwärtsumgesetzten Signal (2507) mit dem Kondensator (2574) des ersten Frequenzabwärtsumsetzmoduls (114a);

wobei Schritt (3) ferner den Schritt aufweist:

(B) Verringern der zweiten DC-Offsetspannung in dem zweiten abwärtsumgesetzten Signal (2509) mit dem Kondensator (2576) des zweiten Frequenzabwärtsumsetzmoduls (114b);

wobei Schritt (5) ferner den Schritt aufweist:

(B) Verringern der dritten DC-Offsetspannung in dem dritten abwärtsumgesetzten Signal (2511) mit dem Kondensator (2578) des dritten Frequenzabwärtsumsetzmoduls (114c); und

wobei Schritt (6) ferner den Schritt aufweist:

(B) Verringern der vierten DC-Offsetspannung in dem vierten abwärtsumgesetzten Signal (2513) mit dem Kondensator (2580) des vierten universellen Frequenzabwärtsumsetzmoduls (114d);

wobei Ladungsinjektionseffekte in dem ersten, zweiten, dritten bzw. vierten Frequenzabwärtsumsetzmodul (114a,114b, 114c,114d), hervorgerufen durch die Wechselwirkung mit dem ersten, zweiten, dritten bzw. vierten Steuersignal (2590,2592, 2594,2596), die erste, zweite, dritte und vierte DC-Offsetspannung zumindest mit verursachen.

**Revendications**

1. Appareil servant à abaisser la fréquence d'un signal électromagnétique et à réduire les tensions de décalage du niveau continu, comprenant :

   un premier module d'abaissement de fréquence (114a) qui reçoit un signal d'entrée (2582), abaisse la fréquence dudit signal d'entrée (2582) selon un premier signal de commande (2590), et délivre en sortie un premier signal abaissé en fréquence (2507), ledit premier module d'abaissement de fréquence (114a) donnant une première tension de décalage du niveau continu audit premier signal abaissé en fréquence (2507) ;
   un deuxième module d'abaissement de fréquence (114b) qui reçoit ledit signal d'entrée (2582), abaisse la fréquence dudit signal d'entrée (2582) selon un deuxième signal de commande (2592) qui est déphasé par rapport audit premier signal de commande (2590) de 180°+n×360°, ces degrés étant des degrés de phase dudit signal d'entrée, où n est un entier supérieur ou égal à 0, et délivre en sortie un deuxième signal abaissé en fréquence (2509), ledit deuxième module d'abaissement de fréquence (114b) donnant une deuxième tension de décalage du niveau continu audit deuxième signal abaissé en fréquence (2509) ; et
   un premier module soustracteur (2520) qui soustrait ledit deuxième signal abaissé en fréquence (2509) dudit premier signal abaissé en fréquence (2507) et délivre en sortie un signal abaissé en fréquence de premier canal (2584), ledit signal abaissé en fréquence de premier canal (2584) ayant une composante de décalage du niveau continu qui comprend une différence entre ladite première tension de décalage du niveau continu et ladite deuxième tension de décalage du niveau continu ;

   dans lequel lesdits premier et deuxième modules d'abaissement de fréquence (114a, 114b) comprennent chacun un interrupteur (102a, 102b) et un élément de stockage (2524, 2536).

2. Appareil selon la revendication 1, dans lequel ledit signal d'entrée (2582) est une porteuse HF qui est modulée en amplitude, en fréquence ou en phase avec un signal d'information.

3. Appareil selon la revendication 2, dans lequel ledit signal abaissé en fréquence de premier canal (2584) est un signal de bande de base.

4. Appareil selon la revendication 2, dans lequel ledit signal abaissé en fréquence de premier canal (2584) est un signal de fréquence intermédiaire.

5. Appareil selon l'une quelconque des revendications précédentes, dans lequel ledit premier signal de commande (2590) comprend une première impulsion de signal de commande et ledit deuxième signal de commande (2592) comprend une deuxième impulsion de signal de commande, ladite deuxième impulsion de signal de commande étant retardée de 0,5+n cycles dudit signal d'entrée (2582) par rapport à ladite première impulsion de signal de commande.

6. Appareil selon l'une quelconque des revendications précédentes, dans lequel ledit premier module d'abaissement de fréquence (114a) sous-échantillonne ledit signal d'entrée (2582) selon ledit premier signal de commande (2590), et ledit deuxième module d'abaissement de fréquence (114b) sous-échantillonne ledit signal d'entrée (2582) selon ledit deuxième signal de commande (2592).

7. Appareil selon la revendication 6, dans lequel lesdits premier et deuxième signaux de commande (2590, 2592) comprennent chacun un train d'impulsions ayant des largeurs d'impulsion qui sont établies de manière à améliorer le transfert d'énergie dudit signal d'entrée (2582) auxdits premier et deuxième signaux abaissés en fréquence (2507, 2509), respectivement.

8. Appareil selon l'une quelconque des revendications précédentes, dans lequel un premier noeud de chacun desdits interrupteurs (102a, 102b) est couplé à un noeud dudit élément de stockage correspondant (2524, 2536), et un deuxième noeud de chacun desdits interrupteurs (102a, 102b) est couplé à un potentiel de référence (2528, 2540).

**9.** Appareil selon la revendication 8, dans lequel chacun desdits éléments de stockage (2524, 2536) comprend un condensateur (2574, 2576), où ledit condensateur (2574) correspondant audit premier module d'abaissement de fréquence (114a) réduit ladite première tension de décalage du niveau continu et ledit condensateur (2576) correspondant audit deuxième module d'abaissement de fréquence (114b) réduit ladite deuxième tension de décalage du niveau continu, et où lesdites première et deuxième tensions de décalage du niveau continu sont au moins dues aux effets d'injection de charges dans lesdits premier et deuxième modules d'abaissement de fréquence (114a, 114b), respectivement.

**10.** Appareil selon l'une quelconque des revendications précédentes, dans lequel ledit premier module soustracteur (2520) comprend un amplificateur différentiel.

**11.** Appareil selon l'une quelconque des revendications précédentes, comprenant en outre :

un troisième module d'abaissement de fréquence (114c) qui reçoit ledit signal d'entrée (2582), abaisse la fréquence dudit signal d'entrée (2582) selon un troisième signal de commande (2594), et délivre en sortie un troisième signal abaissé en fréquence (2511), ledit troisième module d'abaissement de fréquence (114c) donnant une troisième tension de décalage du niveau continu audit troisième signal abaissé en fréquence (2511) ; un quatrième module d'abaissement de fréquence (114d) qui reçoit ledit signal d'entrée (2582), abaisse la fréquence dudit signal d'entrée (2582) selon un quatrième signal de commande (2596) qui est déphasé par rapport audit troisième signal de commande (2590) de 180°+n×360°, ces degrés étant des degrés de phase dudit signal d'entrée, où n est un entier supérieur ou égal à 0, et délivre en sortie un quatrième signal abaissé en fréquence (2513), ledit quatrième module d'abaissement de fréquence (114d) donnant une quatrième tension de décalage du niveau continu audit quatrième signal abaissé en fréquence (2513) ; et un deuxième module soustracteur qui soustrait ledit quatrième signal abaissé en fréquence (2513) dudit troisième signal abaissé en fréquence (2511) et délivre en sortie un signal abaissé en fréquence de deuxième canal (2586), ledit signal abaissé en fréquence de deuxième canal (2586) ayant une composante de décalage du niveau continu qui comprend une différence entre ladite troisième tension de décalage du niveau continu et ladite quatrième tension de décalage du niveau continu ;

dans lequel lesdits troisième et quatrième modules d'abaissement de fréquence (114c, 114d) comprennent chacun un interrupteur (102c, 102d) et un élément de stockage (2548, 2560).

**12.** Appareil selon la revendication 11, dans lequel ledit premier module soustracteur (2520) et ledit deuxième module soustracteur (2522) comprennent chacun un amplificateur différentiel.

**13.** Appareil selon la revendication 11 ou 12, comprenant en outre :

un premier filtre (2504) qui filtre ledit premier signal abaissé en fréquence (2507) ; un deuxième filtre (2508) qui filtre ledit deuxième signal abaissé en fréquence (2509) ; un troisième filtre (2512) qui filtre ledit troisième signal abaissé en fréquence (2511) ; un quatrième filtre (2516) qui filtre ledit quatrième signal abaissé en fréquence (2513).

**14.** Appareil selon la revendication 13, dans lequel lesdits premier, deuxième, troisième et quatrième filtres (2504, 2508, 2512, 2516) comprennent chacun un filtre passe-bas.

**15.** Appareil selon la revendication 14, dans lequel chacun desdits filtres passe-bas (2504, 2508, 2512, 2516) comprend une résistance (2530, 2542, 2554, 2566) et un condensateur (2532, 2544, 2556, 2568).

**16.** Appareil selon l'une quelconque des revendications 11 à 15, comprenant en outre un amplificateur à faible bruit (2518) qui amplifie ledit signal d'entrée (2582).

**17.** Appareil selon l'une quelconque des revendications 11 à 16, dans lequel ledit signal d'entrée (2582) comprend un signal HF modulé I/Q.

**18.** Appareil selon la revendication 17, dans lequel ledit signal abaissé en fréquence de premier canal (2584) comprend une partie de signal d'information de phase I dudit signal HF modulé I/Q, et dans lequel ledit signal abaissé en fréquence de deuxième canal (2586) comprend une partie de signal d'information de phase Q dudit signal HF modulé I/Q.

**19.** Appareil selon la revendication 18, dans lequel une deuxième impulsion de signal de commande dudit deuxième signal de commande (2592) se produit 1,5 cycles d'une fréquence dudit signal d'entrée (2582) après l'occurrence d'une première impulsion de signal de commande dudit premier signal de commande (2590) ;

dans lequel une quatrième impulsion de signal de commande dudit quatrième signal de commande (2596) se produit 1,5 cycles de ladite fréquence dudit signal d'entrée (2582) après l'occurrence d'une troisième impulsion de signal de commande dudit troisième signal de commande (2594) ; et

dans lequel ladite troisième impulsion de signal de commande se produit 0,75 cycle de ladite fréquence dudit signal d'entrée (2582) après l'occurrence de ladite première impulsion de signal de commande.

**20.** Appareil selon la revendication 19, dans lequel un signal re-émis comprend les composantes atténuées desdites première, deuxième, troisième et quatrième impulsions de signal de commande pour former une fréquence cumulative, et dans lequel le rapport de ladite fréquence cumulative dudit signal re-émis à ladite fréquence dudit signal d'entrée (2582) vaut 4/3.

**21.** Appareil selon l'une quelconque des revendications 18 à 20, dans lequel ledit premier signal de commande (2590) comprend une première impulsion de signal de commande, ledit deuxième signal de commande (2592) comprend une deuxième impulsion de signal de commande, ledit troisième signal de commande (2594) comprend une troisième impulsion de signal de commande, et ledit quatrième signal de commande (2596) comprend une quatrième impulsion de signal de commande ;

dans lequel un signal potentiellement re-émis comprend les composantes atténuées desdites première, deuxième, troisième et quatrième impulsions de signal de commande pour former une fréquence cumulative ; et

dans lequel ladite fréquence cumulative dudit signal potentiellement re-émis est choisie de manière à être supérieure à une fréquence dudit signal d'entrée (2582).

**22.** Appareil selon l'une quelconque des revendications 11 à 21, dans lequel ladite première tension de décalage du niveau continu et ladite deuxième tension de décalage du niveau continu sont sensiblement éliminées dudit signal de sortie de premier canal (2584) dans ledit premier module soustracteur (2520) ; et

dans lequel ladite troisième tension de décalage du niveau continu et ladite quatrième tension de décalage du niveau continu sont sensiblement éliminées dudit signal de sortie de deuxième canal (2586) dans ledit deuxième module soustracteur (2522).

**23.** Appareil selon l'une quelconque des revendications 11 à 22, dans lequel ledit premier module d'abaissement de fréquence (114a) sous-échantillonne ledit signal d'entrée (2582) selon ledit premier signal de commande (2590), ledit deuxième module d'abaissement de fréquence (114b) sous-échantillonne ledit signal d'entrée (2582) selon ledit deuxième signal de commande (2592), ledit troisième module d'abaissement de fréquence (114c) sous-échantillonne ledit signal d'entrée (2582) selon ledit troisième signal de commande (2594), et ledit quatrième module d'abaissement de fréquence (114d) sous-échantillonne ledit signal d'entrée (2582) selon ledit quatrième signal de commande (2596).

**24.** Appareil selon la revendication 23, dans lequel lesdits premier, deuxième, troisième et quatrième signaux de commande (2590, 2592, 2594, 2596) comprennent chacun un train d'impulsions ayant des largeurs d'impulsion qui sont établies de manière à améliorer le transfert d'énergie dudit signal d'entrée (2582) auxdits premier, deuxième, troisième et quatrième signaux abaissés en fréquence (2507, 2509, 2511, 2513), respectivement.

**25.** Appareil selon l'une quelconque des revendications 11 à 24, dans lequel un premier noeud de chacun desdits interrupteurs (102a, 102b, 102c, 102d) est couplé à un noeud de chacun desdits éléments de stockage correspondants (2524, 2536, 2548, 2560), et un deuxième noeud de chacun desdits interrupteurs (102a, 102b, 102c, 102d) est couplé à un potentiel de référence (2528, 2540, 2552, 2564).

**26.** Appareil selon la revendication 25, dans lequel chacun desdits éléments de stockage (2524, 2536, 2548, 2560) comprend un condensateur (2574, 2576, 2578, 2580).

**27.** Appareil selon la revendication 26, dans lequel chacun desdits condensateurs (2574, 2576, 2578, 2580) correspondant auxdits premier, deuxième, troisième et quatrième modules d'abaissement de fréquence universels (114a, 114b, 114c, 114d) réduit respectivement lesdites première, deuxième, troisième et quatrième tensions de décalage du niveau continu, lesdites première, deuxième, troisième et quatrième tensions de décalage du niveau continu étant au moins dues aux effets d'injection de charges respectivement dans lesdits premier, deuxième, troisième et quatrième modules d'abaissement de fréquence (114a, 114b, 114c, 114d).

**28.** Appareil selon l'une quelconque des revendications 11 à 27, comprenant en outre un générateur de signaux de commande (2600) qui délivre en sortie lesdits premier, deuxième, troisième et quatrième signaux de commande (2590, 2592, 2594, 2596).

**29.** Appareil selon la revendication 28, dans lequel ledit générateur de signaux de commande (2600) comprend :

un oscillateur local (2602) ;
un déphaseur à 180 degrés (2606) couplé à une sortie dudit oscillateur local (2602) ;
un premier module de division par deux (2604) couplé à ladite sortie dudit oscillateur local (2602) ;
un deuxième module de division par deux (2608) couplé à une sortie dudit déphaseur à 180 degrés (2606) ;
un premier générateur d'impulsions (2610) couplé à une sortie dudit premier module de division par deux (2604), ledit premier générateur d'impulsions (2610) délivrant ledit premier signal de commande (2590) ;
un deuxième générateur d'impulsions (2612) couplé à une sortie inverseuse dudit premier module de division par deux (2604), ledit deuxième générateur d'impulsions (2612) délivrant ledit deuxième signal de commande (2592) ;
un troisième générateur d'impulsions (2614) couplé à une sortie dudit deuxième module de division par deux (2608), ledit troisième générateur d'impulsions (2614) délivrant ledit troisième signal de commande (2594) ; et
un quatrième générateur d'impulsions (2616) couplé à une sortie inverseuse dudit deuxième module de division par deux (2608), ledit quatrième générateur d'impulsions (2616) délivrant ledit quatrième signal de commande (2596).

**30.** Procédé d'abaissement de fréquence d'un signal électromagnétique et de réduction des tensions de décalage du niveau continu, comprenant les étapes consistant à :

(1) recevoir un signal d'entrée (2582) ;
(2) abaisser la fréquence du signal d'entrée (2582) avec un premier module d'abaissement de fréquence (114a) selon un premier signal de commande (2590) pour former un premier signal abaissé en fréquence (2507), le premier signal abaissé en fréquence (2507) comportant une première tension de décalage du niveau continu ;
(3) abaisser la fréquence du signal d'entrée (2582) avec un deuxième module d'abaissement de fréquence (114b) selon un deuxième signal de commande (2592) qui est déphasé par rapport audit premier signal de commande (2590) de 180°+n×360°, ces degrés étant des degrés de phase dudit signal d'entrée, où n est un entier supérieur ou égal à 0, pour former un deuxième signal abaissé en fréquence (2509), le deuxième signal abaissé en fréquence (2509) comportant une deuxième tension de décalage du niveau continu ; et
(4) soustraire le deuxième signal abaissé en fréquence (2509) du premier signal abaissé en fréquence (2507) pour former un premier signal de sortie (2584) ayant une composante de décalage du niveau continu qui comprend une différence entre la première tension de décalage du niveau continu et la deuxième tension de décalage du niveau continu ;
dans lequel lesdits premier et deuxième modules d'abaissement de fréquence (114a, 114b) comprennent chacun un interrupteur (102a, 102b) et un élément de stockage (2524, 2536).

**31.** Procédé selon la revendication 30, comprenant en outre l'étape consistant à :

(5) amplifier le premier signal de sortie (2584).

**32.** Procédé selon la revendication 31, comprenant en outre l'étape consistant à :

(6) amplifier de manière différentielle les premier et deuxième signaux abaissés en fréquence (2507, 2509), l'étape (6) comprenant les étapes (4) et (5).

**33.** Procédé selon l'une quelconque des revendications 30 à 32,
dans lequel l'étape (2) comprend l'étape consistant à :

(A) sous-échantillonner le signal d'entrée (2582) selon le premier signal de commande (2590) ; et

dans lequel l'étape (3) comprend l'étape consistant à :

(A) sous-échantillonner le signal d'entrée (2582) selon le deuxième signal de commande (2592) ;

dans lequel le premier signal de commande (2590) comprend une première impulsion, et dans lequel le deuxième signal de commande (2592) comprend une deuxième impulsion ; et

dans lequel la deuxième impulsion est retardée de 0,5+n cycles du signal d'entrée (2582) par rapport à la première impulsion, où n est un entier supérieur ou égal à 0.

**34.** Procédé selon l'une quelconque des revendications 30 à 33, comprenant en outre l'étape consistant à :

(5) filtrer le premier signal abaissé en fréquence (2507) et le deuxième signal abaissé en fréquence (2509).

**35.** Procédé selon l'une quelconque des revendications 30 à 34, comprenant en outre les étapes consistant à :

(5) abaisser la fréquence du signal d'entrée (2582) avec un troisième module d'abaissement de fréquence (114c) selon un troisième signal de commande (2594) pour former un troisième signal abaissé en fréquence (2511), le troisième signal abaissé en fréquence (2511) comportant une troisième tension de décalage du niveau continu ;

(6) abaisser la fréquence du signal d'entrée (2582) avec un quatrième module d'abaissement de fréquence (114d) selon un quatrième signal de commande (2596) qui est déphasé par rapport au troisième signal de commande (2594) de 180°+n×360°, ces degrés étant des degrés de phase dudit signal d'entrée, où n est un entier supérieur ou égal à 0, pour former un quatrième signal abaissé en fréquence (2513), le quatrième signal abaissé en fréquence (2513) comportant une quatrième tension de décalage du niveau continu ; et

(7) soustraire le quatrième signal abaissé en fréquence (2513) du troisième signal abaissé en fréquence (2511) pour former un deuxième signal de sortie (2586) ayant une composante de décalage du niveau continu qui comprend une différence entre la troisième tension de décalage du niveau continu et la quatrième tension de décalage du niveau continu.

**36.** Procédé selon la revendication 35,
dans lequel l'étape (2) comprend l'étape consistant à :

(A) sous-échantillonner le signal d'entrée (2582) selon le premier signal de commande (2590) ;

dans lequel l'étape (3) comprend l'étape consistant à :

(A) sous-échantillonner le signal d'entrée (2582) selon le deuxième signal de commande (2592) ;

dans lequel l'étape (5) comprend l'étape consistant à :

(A) sous-échantillonner le signal d'entrée (2582) selon le troisième signal de commande (2594) ; et

dans lequel l'étape (6) comprend l'étape consistant à :

(A) sous-échantillonner le signal d'entrée (2582) selon le quatrième signal de commande (2596).

**37.** Procédé selon la revendication 36,
dans lequel l'étape (2)(A) comprend l'étape consistant à :

(i) générer le premier signal de commande (2590) ;

dans lequel l'étape (3)(A) comprend l'étape consistant à :

(i) générer le deuxième signal de commande (2592), le deuxième signal de commande (2592) étant une version déphasée du premier signal de commande (2590) ;

dans lequel l'étape (5)(A) comprend l'étape consistant à :

(i) générer le troisième signal de commande (2594), le troisième signal de commande étant une version déphasée du premier signal de commande (2590) ; et

dans lequel l'étape (6)(A) comprend l'étape consistant à :

(i) générer le quatrième signal de commande (2596), le quatrième signal de commande (2596) étant une version déphasée du premier signal de commande (2590).

38. Procédé selon la revendication 37, dans lequel le signal d'entrée reçu (2582) comprend une porteuse modulée, et dans lequel les étapes (2)(A), (3)(A), (5)(A) et (6)(A) comprennent chacune en outre l'étape consistant à :

(ii) transférer des quantités non négligeables d'énergie depuis la porteuse modulée, avec un débit qui est sensiblement égal à un harmonique inférieur de la porteuse modulée, d'où les quantités non négligeables d'énergie transférée depuis le signal abaissé en fréquence correspondant.

39. Procédé selon la revendication 38,
dans lequel les étapes (2)(A)(i), (3)(A)(i), (5)(A)(i) et (6)(A)(i) comprennent chacune l'étape consistant à :

(a) générer un signal de transfert d'énergie ayant un harmonique sensiblement égal à une fréquence de la porteuse modulée ; et

dans lequel les étapes (2)(A)(ii), (3)(A)(ii), (5)(A)(ii) et (6)(A)(ii) comprennent chacune l'étape consistant à :

(a) utiliser le signal de transfert d'énergie pour transférer de l'énergie depuis la porteuse modulée.

40. Procédé selon la revendication 39, dans lequel les étapes (2)(A)(ii), (3)(A)(ii), (5)(A)(ii) et (6)(A)(ii) comprennent chacune en outre le fait de générer un train d'impulsions ayant des ouvertures non négligeables dont la durée augmente à partir de l'instant zéro.

41. Procédé selon l'une quelconque des revendications 35 à 40,
dans lequel le signal d'entrée (2582) comprend un signal HF modulé I/Q, et
dans lequel l'étape (2) comprend l'étape consistant à :

(A) abaisser la fréquence du signal d'entrée (2582) pour obtenir une partie de signal de phase I non inversée (2507) du signal HF modulé I/Q ;

dans lequel l'étape (3) comprend l'étape consistant à :

(A) abaisser la fréquence du signal d'entrée (2582) pour obtenir une partie de signal de phase I inversée (2509) du signal HF modulé I/Q ;

dans lequel l'étape (5) comprend l'étape consistant à :

(A) abaisser la fréquence du signal d'entrée (2582) pour obtenir une partie de signal de phase Q non inversée (2511) du signal HF modulé I/Q ; et

dans lequel l'étape (6) comprend l'étape consistant à :

(A) abaisser la fréquence du signal d'entrée (2582) pour obtenir une partie de signal de phase Q inversée (2513) du signal HF modulé I/Q.

42. Procédé selon la revendication 41,
dans lequel l'étape (2)(A) comprend l'étape consistant à :

(i) sous-échantillonner une première phase de la partie de signal en phase du signal HF modulé I/Q ;

dans lequel l'étape (3)(A) comprend l'étape consistant à :

(i) sous-échantillonner une deuxième phase de la partie de signal en phase du signal HF modulé I/Q, la deuxième phase de la partie de signal en phase étant de phase opposée à la première phase de la partie de signal en phase ;

dans lequel l'étape (5)(A) comprend l'étape consistant à :

(i) sous-échantillonner une troisième phase de la partie de signal en quadrature du signal HF modulé I/Q ; et

dans lequel l'étape (6)(A) comprend l'étape consistant à :

(i) sous-échantillonner une quatrième phase de la partie de signal en quadrature du signal HF modulé I/Q, la quatrième phase de la partie de signal en quadrature étant de phase opposée à la troisième phase de la partie de signal en quadrature.

**43.** Procédé selon la revendication 42,
   dans lequel l'étape (3)(A)(i) comprend l'étape consistant à :

(a) sous-échantillonner le signal HF modulé I/Q 1,5 cycles d'une fréquence du signal HF modulé I/Q après le sous-échantillonnage du signal HF modulé I/Q à l'étape (2)(A)(i) ;

dans lequel l'étape (5)(A)(i) comprend l'étape consistant à :

(a) sous-échantillonner le signal HF modulé I/Q 0,75 cycle de la fréquence du signal HF modulé I/Q après le sous-échantillonnage du signal HF modulé I/Q à l'étape (2)(A)(i) ; et

dans lequel l'étape (6)(A)(i) comprend l'étape consistant à :

(a) sous-échantillonner le signal HF modulé I/Q 1,5 cycles de la fréquence du signal HF modulé I/Q après le sous-échantillonnage du signal HF modulé I/Q à l'étape (5)(A)(i).

**44.** Procédé selon la revendication 43, dans lequel l'étape (2)(A) comprend l'étape consistant à :

(ii) sous-échantillonner le signal HF modulé I/Q 3,0 cycles de la fréquence du signal HF modulé I/Q après un précédent sous-échantillon du signal HF modulé I/Q.

**45.** Procédé selon l'une quelconque des revendications 35 à 44, dans lequel le premier signal de commande (2590) comprend une première impulsion de signal de commande, le deuxième signal de commande (2592) comprend une deuxième impulsion de signal de commande, le troisième signal de commande (2594) comprend une troisième impulsion de signal de commande, et le quatrième signal de commande (2596) comprend une quatrième impulsion de signal de commande, le procédé comprenant en outre les étapes consistant à :

(8) re-émettre un signal qui comprend des composantes atténuées des première, deuxième, troisième et quatrième impulsions de signal de commande, les composantes atténuées des première, deuxième, troisième et quatrième impulsions de signal de commande formant une fréquence cumulative ; et
(9) configurer les première, deuxième, troisième et quatrième impulsions de signal de commande de telle manière que la fréquence cumulative est supérieure à une fréquence du signal d'entrée (2582).

**46.** Procédé selon l'une quelconque des revendications 35 à 45,
   dans lequel l'étape (4) comprend l'étape consistant à :

(A) éliminer sensiblement la première tension de décalage du niveau continu et la deuxième tension de décalage du niveau continu ; et

dans lequel l'étape (7) comprend l'étape consistant à :

(A) éliminer sensiblement la troisième tension de décalage du niveau continu et la quatrième tension de décalage du niveau continu.

**47.** Procédé selon l'une quelconque des revendications 35 à 46, dans lequel les première, deuxième, troisième et quatrième tensions de décalage du niveau continu sont au moins générées respectivement par les premier, deuxième, troisième et quatrième modules d'abaissement de fréquence (114a, 114b, 114c, 114d).

**48.** Procédé selon la revendication 47, dans lequel les premier, deuxième, troisième et quatrième modules d'abaissement de fréquence (114a, 114b, 114c, 114d) comprennent chacun un condensateur (2574, 2576, 2578, 2580) en série avec le signal d'entrée (2582),

dans lequel l'étape (2) comprend en outre l'étape consistant à:

(B) réduire la première tension de décalage du niveau continu dans le premier signal abaissé en fréquence (2507) avec le condensateur (2574) du premier module d'abaissement de fréquence (114a) ;

dans lequel l'étape (3) comprend en outre l'étape consistant à:

(B) réduire la deuxième tension de décalage du niveau continu dans le deuxième signal abaissé en fréquence (2509) avec le condensateur (2576) du deuxième module d'abaissement de fréquence (114b) ;

dans lequel l'étape (5) comprend en outre l'étape consistant à :

(B) réduire la troisième tension de décalage du niveau continu dans le troisième signal abaissé en fréquence (2511) avec le condensateur (2578) du troisième module d'abaissement de fréquence (114c) ; et

dans lequel l'étape (6) comprend en outre l'étape consistant à :

(B) réduire la quatrième tension de décalage du niveau continu dans le quatrième signal abaissé en fréquence (2513) avec le condensateur (2580) du quatrième module d'abaissement de fréquence universel (114d) ;

dans lequel les première, deuxième, troisième et quatrième tensions de décalage du niveau continu sont au moins dues aux effets d'injection de charges respectivement dans les premier, deuxième, troisième et quatrième modules d'abaissement de fréquence (114a, 114b, 114c, 114d), provenant de l'interaction respectivement avec les premier, deuxième, troisième et quatrième signaux de commande (2590, 2592, 2594, 2596).

## FIG. 1A

UNIVERSAL FREQUENCY
TRANSLATION (UFT)
MODULE — 102

PORT 1

PORT 2

PORT 3

CONTROL
SIGNAL

## FIG. 1B

102

UNIVERSAL FREQUENCY
TRANSLATION (UFT)
MODULE

106

PORT 1

PORT 2

PORT 3

CONTROL
SIGNAL 108

## FIG. 1C

114

UNIVERSAL FREQUENCY
DOWN-CONVERSION
(UFD) MODULE

UFT MODULE

PORT 1

PORT 2

102

PORT 3

CONTROL
SIGNAL

## FIG. 2

202

UNIVERSAL FREQUENCY
TRANSLATION
(UFT) MODULE

PORT 1                                    PORT 2/3

204

CONTROL
SIGNAL

PORT 3

206

## FIG. 3

702

RECEIVER

114

DOWN-CONVERSION
MODULE

UFT MODULE

102

## FIG. 4A

2000

ALIASING MODULE

INPUT
SIGNAL              2008        102         DOWN-CONVERTED
                                            OUTPUT SIGNAL

2004                        2006      2010      2012

CONTROL
SIGNAL

FIG. 4B

FIG. 4C

FIG. 4D

FIG. 4E

FIG. 4F

## FIG. 4G

## FIG. 5

*FIG. 6*

*FIG. 7*

FIG. 8

IQDEMOD PULSE RELATIONSHIPS TO INPUT RF CARRIER

FIG. 9

## FIG. 10

IQDEMOD SHOWING TIME RELATIONSHIP OF TX_I DATA

## FIG. 11

IQDEMOD SHOWING TIME RELATIONSHIP OF TX_Q DATA

FIG. 12 — IQDEMOD SHOWING QPSK MOD OUTPUT
□ V (QPSK)

FIG. 13 — IQDEMOD SHOWING QPSK MOD OUTPUT WITH IMOD DATA
□ V (IMOD)

FIG. 14 — IQDEMOD SHOWING QPSK MOD OUTPUT WITH QMOD DATA
□ V (QMOD)

FIG. 15 — IQDEMOD SHOWING QPSK MOD OUTPUT WITH I DATA
□ V (RX_I)

FIG. 16 — IQDEMOD SHOWING QPSK MOD OUTPUT WITH Q DATA
□ V (RX_Q)

EP 1 222 733 B1

FIG. 17

IQDEMOD RELATIONSHIP OF I RECEIVED DATA DIFFERENTIAL SINGLE ENDED AFTER DIFFERENTIAL AMPLIFIER

200mV

-200mV

0s          0.2us          0.4us          0.6us          0.8us          1.0us          1.2us          1.4us

2584

□ V(RX_I)                                                         TIME

FIG. 18

IQDEMOD RELATIONSHIP OF Q RECEIVED DATA DIFFERENTIAL SINGLE ENDED AFTER DIFFERENTIAL AMPLIFIER

200mV

SEL>>

-200mV

0s          0.2us          0.4us          0.6us          0.8us          1.0us          1.2us          1.4us

2586

□ V(RX_Q)                                                         TIME

FIG. 19

IQDEMOD RELATIONSHIP OF I RECEIVED DATA DIFFERENTIAL

500mV

3902

300mV

0s          0.2us          0.4us   3904   0.6us          0..8us          1.0us          1.2us          1.4us

□ V(I+)   ◇ V(I-)                                                  TIME

FIG. 20

IQDEMOD RELATIONSHIP OF Q RECEIVED DATA DIFFERENTIAL

500mV

4004

300mV

4002

0s          0.2us          0.4us          0.6us          0.8us          1.0us          1.2us          1.4us

□ V(Q+)   ◇ V(Q-)                                                  TIME

FIG. 21

## FIG. 22

4200

2582

2572

114a

4206

102a

FIRST
CONTROL
SIGNAL
4218

UFT
MODULE

4208

2520

I BASEBAND
OUTPUT SIGNAL
2584

114b

4212

102b

SECOND
CONTROL
SIGNAL
4220

UFT
MODULE

4214

2522

Q BASEBAND
OUTPUT SIGNAL
2586

FIG. 23A

FIG. 23B

FIG. 23C

FIG. 23D

## FIG. 24A

RISING EDGE PULSE GENERATOR

## FIG. 24B

FALLING-EDGE PULSE GENERATOR

## FIG. 24C

PULSES
4626

INPUT
SIGNAL
4624

DELAY
4622

INVERTER
4628

U7

-SUBSTANTIAL EQUIVALENCE IN LOGIC ONLY IS NECESSARY.
-u7 SHOWN FOR POLARITY CONSISTENCY WITH
CKT EXAMPLES DESCRIBED ELSEWHERE

## FIG. 24D

nand

vdd

vdd

S    S

M169    M171

PULSES
4626

M170    vneg

S

M172

S

vss

vneg

inverter    vdd

vdd

S

M168

INPUT
SIGNAL
4624

M167    vneg

S

vss

## FIG. 24E

INPUT
SIGNAL
4624

OSCILLATOR    4630

FIG. 25

4701

4504

4704

4708B

EM SIGNAL → ENERGY TRANSFER MODULE → DOWN-CONVERTED SIGNAL

4506 — ENERGY TRANSFER SIGNAL HAVING AN ALIASING RATE

4706 (OPTIONAL) FEEDBACK

4702 — ENERGY TRANSFER SIGNAL MODULE ← (OPTIONAL) INPUT SIGNAL

(OPTIONAL)

4624

## FIG. 26A

## FIG. 26B

$$q = C \cdot V \qquad \text{EQ. 1}$$

$$V = A \cdot \sin(t) \qquad \text{EQ. 2}$$

$$q(t) = C \cdot A \cdot \sin(t) \qquad \text{EQ. 3}$$

$$\Delta q(t) = C \cdot A \cdot \sin(t) - C \cdot A \cdot \sin(t-T) \qquad \text{EQ. 4}$$

$$\Delta q(t) = C \cdot A \cdot (\sin(t) - \sin(t-T)) \qquad \text{EQ. 5}$$

$$\sin(\alpha) - \sin(\beta) = 2 \cdot \sin\left(\frac{\alpha - \beta}{2}\right) \cdot \cos\left(\frac{\alpha + \beta}{2}\right) \qquad \text{EQ. 6}$$

$$\Delta q(t) = 2 \cdot C \cdot A \cdot \sin\left[\frac{t - (t-T)}{2}\right] \cdot \cos\left[\frac{t + (t-T)}{2}\right] \qquad \text{EQ. 7}$$

$$\Delta q(t) = 2 \cdot C \cdot A \cdot \sin\left(\tfrac{1}{2} \cdot T\right) \cdot \cos\left(t - \tfrac{1}{2} \cdot T\right) \qquad \text{EQ. 8}$$

$$q(t) = \int C \cdot A \cdot (\sin(t) - \sin(t-T)) \, dt \qquad \text{EQ. 9}$$

$$q(t) = -\cos(t) \cdot C \cdot A + \cos(t-T) \cdot C \cdot A \qquad \text{EQ. 10}$$

$$q(t) = C \cdot A \cdot (\cos(t-T) - \cos(t)) \qquad \text{EQ. 11}$$

## FIG. 26C

$$C = 1$$
$$A = .5$$
$$T = \pi$$

GRAPH 1

$\dfrac{(q(t))}{\sin(t)}$

## FIG. 26D

$$C = 1$$
$$A = .5$$
$$T = \pi/10$$

GRAPH 2

$\dfrac{(q(t))}{\sin(t)}$

## FIG. 26E

POWER-CHARGE RELATIONSHIP

| | |
|---|---|
| $q = C \cdot V$ | EQ. 12 |
| $V = q/C$ | EQ. 13 |
| $V = J/q$ | EQ. 14 |
| $J = q^2/C$ | EQ. 15 |
| $P = J/S$ | EQ. 16 |
| $P = q^2/(C \cdot S)$ | EQ. 17 |

## FIG. 26F

INSERTION LOSS

INSERTION LOSS IN dB IS EXPRESSED BY:

$$ILdB = 10 \cdot \log\left(\frac{Pin}{Pout}\right) \qquad EQ.\ 18$$

or

$$ILdB = 10 \cdot \log\left[\frac{\left(\frac{Vin^2}{Rin}\right)}{\left(\frac{Vout^2}{Rout}\right)}\right] \qquad EQ.\ 19$$

FIG. 27

## FIG. 28

8700

MODULATED
CARRIER
SIGNAL 8706

8702

DOWN-CONVERSION
MODULE

8710

8704

AMPLIFIER

BASEBAND
SIGNAL 8712

8714

8716

8718

LOCAL OSCILLATOR SIGNAL 8708

## FIG. 29

INPUT RF
SIGNAL 9014

OUTPUT
SIGNAL 9016

CONTROL
SIGNAL
9018

## FIG. 30

INPUT RF
SIGNAL 9014

OUTPUT
SIGNAL 9016

CONTROL
SIGNAL
9018

## FIG. 31

INPUT RF
SIGNAL
9602

0°    180°    540°    900°

π-PULSE LENGTH
CONTROL SIGNAL
9604

|← π →|

3π-PULSE LENGTH
CONTROL SIGNAL
9606

|←———— 3π ————→|

5π-PULSE LENGTH
CONTROL SIGNAL
9608

|←——————— 5π ———————→|

## FIG. 32

9700

INPUT RF
I/Q SIGNAL
9722

CONTROL
SIGNAL
GENERATOR

9706

9728

UFT
MODULE      102a

PHASE
SHIFTER

9708

9730

UFT
MODULE

102b

STORAGE
MODULE      9712

V_REF       9714

STORAGE
MODULE      9718

V_REF       9720

114a

I OUTPUT
SIGNAL
9724

Q OUTPUT
SIGNAL
9726

114b

FIG. 33A — INPUT RF I/Q SIGNAL 9722

FIG. 33B — I-CONTROL SIGNAL 9802

FIG. 33C — Q-CONTROL SIGNAL 9804

FIG. 33D — $3\pi$ I-CONTROL SIGNAL 9806

FIG. 33E — $3\pi$ Q-CONTROL SIGNAL 9808

FIG. 33F — NON-OVERLAPPING I-CONTROL SIGNAL 9810

FIG. 33G — NON-OVERLAPPING Q-CONTROL SIGNAL 9812

FIG. 33H — NON-OVERLAPPING I-CONTROL SIGNAL 9814

FIG. 33I — NON-OVERLAPPING Q-CONTROL SIGNAL 9816

FIG. 34

EP 1 222 733 B1

## FIG. 35

10900

| AN INPUT SIGNAL IS COUPLED BY A SERIES CAPACITOR TO AN INPUT OF A UNIVERSAL FREQUENCY DOWN-CONVERSION MODULE | 10902 |

| THE INPUT SIGNAL IS FREQUENCY DOWN-CONVERTED WITH THE UNIVERSAL FREQUENCY DOWN-CONVERSION MODULE TO A DOWN-CONVERTED SIGNAL | 10904 |

| A DC OFFSET VOLTAGE IN THE DOWN-CONVERTED SIGNAL GENERATED DURING STEP 10904 IS REDUCED BY THE CAPACITOR | 10906 |

## FIG. 36

11400

| AN INPUT SIGNAL IS FREQUENCY DOWN-CONVERTED WITH A UNIVERSAL FREQUENCY DOWN-CONVERSION MODULE TO A DOWN-CONVERTED SIGNAL. THE INPUT SIGNAL IS DOWN-CONVERTED ACCORDING TO A CONTROL SIGNAL COMPRISING A TRAIN OF PULSES HAVING PULSE WIDTHS | 11402 |

| A SIGNAL RELATED TO THE CONTROL SIGNAL IS RE-RADIATED | 11404 |

| THE PULSE WIDTHS ARE INCREASED TO DECREASE A FREQUENCY OF THE RE-RADIATED SIGNAL | 11406 |

*FIG. 37*

11500

AN INPUT RF I/Q MODULATED SIGNAL IS FREQUENCY
DOWN-CONVERTED WITH A FIRST UNIVERSAL
FREQUENCY DOWN-CONVERSION MODULE ACCORDING
TO A CONTROL SIGNAL. THE INPUT SIGNAL IS DOWN-
CONVERTED TO AN IN-PHASE INFORMATION SIGNAL — 11502

THE CONTROL SIGNAL IS PHASE-SHIFTED — 11504

THE INPUT RF I/Q MODULATED SIGNAL IS FREQUENCY
DOWN-CONVERTED WITH A SECOND UNIVERSAL FREQUENCY
DOWN-CONVERSION MODULE ACCORDING TO THE PHASE-
SHIFTED CONTROL SIGNAL. THE INPUT SIGNAL IS DOWN-
CONVERTED TO A QUADRATURE-PHASE INFORMATION SIGNAL — 11506

*FIG. 38*

11600

AN INPUT RF I/Q MODULATED SIGNAL IS BUFFERED WITH A FIRST LOW NOISE
AMPLIFIER AND A SECOND LOW NOISE AMPLIFIER (AND/OR SPLIT WITH A SPLITTER) — 11602

THE FIRST BUFFERED (AND/OR FIRST SPLIT) RF I/Q MODULATED SIGNAL IS
FREQUENCY DOWN-CONVERTED WITH A FIRST UNIVERSAL FREQUENCY DOWN-
CONVERSION MODULE ACCORDING TO A CONTROL SIGNAL. THE INPUT SIGNAL IS
DOWN-CONVERTED TO AN IN-PHASE INFORMATION SIGNAL — 11604

THE CONTROL SIGNAL IS PHASE-SHIFTED — 11606

THE SECOND BUFFERED (AND/OR SECOND SPLIT) RF I/Q MODULATED
SIGNAL IS FREQUENCY DOWN-CONVERTED WITH A SECOND UNIVERSAL
FREQUENCY DOWN-CONVERSION MODULE ACCORDING TO THE PHASE-
SHIFTED CONTROL SIGNAL. THE INPUT SIGNAL IS DOWN-CONVERTED
TO A QUADRATURE-PHASE INFORMATION SIGNAL — 11608

FIG. 39

12000

12002

| AN INPUT SIGNAL IS RECEIVED |
|---|

12004

| THE INPUT SIGNAL IS FREQUENCY DOWN-CONVERTED WITH A FIRST UNIVERSAL FREQUENCY DOWN-CONVERSION MODULE TO A FIRST DOWN-CONVERTED SIGNAL, ACCORDING TO A FIRST CONTROL SIGNAL |
|---|

12006

| THE INPUT SIGNAL IS FREQUENCY DOWN-CONVERTED WITH A SECOND UNIVERSAL FREQUENCY DOWN-CONVERSION MODULE TO A SECOND DOWN-CONVERTED SIGNAL, ACCORDING TO A SECOND CONTROL SIGNAL |
|---|

12008

| THE SECOND DOWN-CONVERTED SIGNAL IS SUBTRACTED FROM THE FIRST DOWN-CONVERTED SIGNAL TO FORM A FIRST OUTPUT SIGNAL |
|---|

12010

| THE INPUT SIGNAL IS FREQUENCY DOWN-CONVERTED WITH A THIRD UNIVERSAL FREQUENCY DOWN-CONVERSION MODULE TO A THIRD DOWN-CONVERTED SIGNAL, ACCORDING TO A THIRD CONTROL SIGNAL |
|---|

12012

| THE INPUT SIGNAL IS FREQUENCY DOWN-CONVERTED WITH A FOURTH UNIVERSAL FREQUENCY DOWN-CONVERSION MODULE TO A FOURTH DOWN-CONVERTED SIGNAL, ACCORDING TO A FOURTH CONTROL SIGNAL |
|---|

12014

| THE FOURTH DOWN-CONVERTED SIGNAL IS SUBTRACTED FROM THE THIRD DOWN-CONVERTED SIGNAL TO FORM A SECOND OUTPUT SIGNAL |
|---|

12016

| A SIGNAL IS RE-RADIATED THAT COMPRISES ATTENUATED COMPONENTS OF FIRST, SECOND, THIRD, AND FOURTH CONTROL SIGNAL PULSES, WHEREIN THE ATTENUATED COMPONENTS OF THE FIRST, SECOND, THIRD, AND FOURTH CONTROL SIGNAL PULSES FORM A CUMULATIVE FREQUENCY |
|---|

12018

| THE FIRST, SECOND, THIRD, AND FOURTH CONTROL SIGNAL PULSES ARE CONFIGURED SUCH THAT THE CUMULATIVE FREQUENCY IS GREATER THAN A FREQUENCY OF THE INPUT SIGNAL |
|---|